(19) Europäisches Patentamt
European Patent Office
Office européen des brevets

(11) EP 3 767 393 A1

(12) EUROPEAN PATENT APPLICATION
published in accordance with Art. 153(4) EPC

(43) Date of publication:
**20.01.2021 Bulletin 2021/03**

(21) Application number: **19767993.9**

(22) Date of filing: **12.02.2019**

(51) Int Cl.:
***G03F 7/40*** *(2006.01)* ***C08F 2/44*** *(2006.01)*
***C08F 2/50*** *(2006.01)* ***C08F 290/08*** *(2006.01)*
***G02B 5/00*** *(2006.01)* ***G03F 7/004*** *(2006.01)*
***G03F 7/031*** *(2006.01)*

(86) International application number:
**PCT/JP2019/004835**

(87) International publication number:
**WO 2019/176409 (19.09.2019 Gazette 2019/38)**

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**
Designated Extension States:
**BA ME**
Designated Validation States:
**KH MA MD TN**

(30) Priority: **13.03.2018 JP 2018045317**

(71) Applicant: **FUJIFILM CORPORATION**
**Minato-ku**
**Tokyo 106-8620 (JP)**

(72) Inventor: **HAMADA Daisuke**
**Haibara-gun, Shizuoka 421-0396 (JP)**

(74) Representative: **Hoffmann Eitle**
**Patent- und Rechtsanwälte PartmbB**
**Arabellastraße 30**
**81925 München (DE)**

# (54) METHOD FOR MANUFACTURING CURED FILM, AND METHOD FOR MANUFACTURING SOLID-STATE IMAGING ELEMENT

(57) Provided is a method for manufacturing a cured film having excellent sustenance-defect suppressibility. Moreover, provided is a method for manufacturing a solid-state imaging element. The method for manufacturing a cured film includes a step of forming a curable composition layer by using a curable composition which contains a predetermined component such as a black coloring material; a step of exposing the curable composition layer; a step of developing the curable composition layer; and a step of heating the developed curable composition layer at a temperature of lower than 170°C in an environment where an oxygen concentration is lower than 1,000 ppm by volume.

FIG. 1

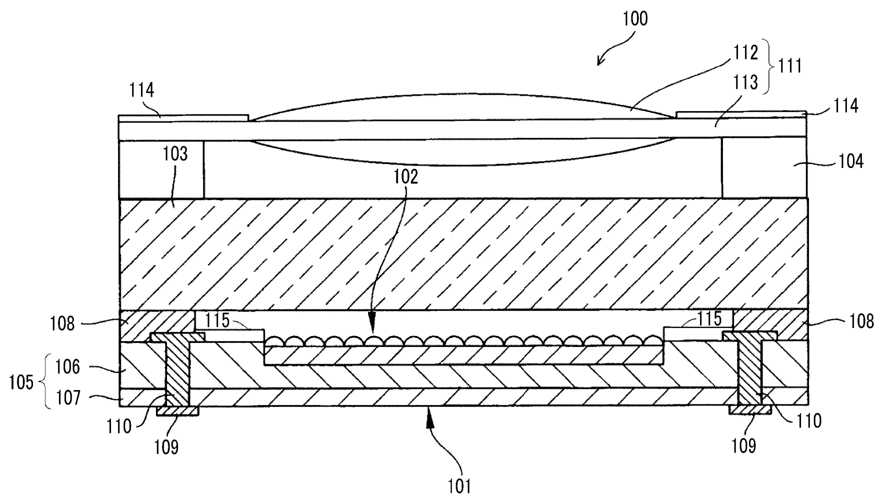


EP 3 767 393 A1

## Description

## BACKGROUND OF THE INVENTION

1. Field of the Invention

The present invention relates to a method for manufacturing a cured film and a method for manufacturing a solid-state imaging element.

2. Description of the Related Art

As a method for manufacturing a cured film used in a solid-state imaging device or the like, a method in which a curable composition layer is formed on a substrate and then cured is generally used. Typically, the curable composition layer is irradiated with light through a predetermined mask pattern and then subjected to a development treatment.
Furthermore, in order to improve performances of the formed cured film, the developed curable composition layer may be further subjected to a curing treatment (hereinafter, referred to as a "post-curing treatment" as well).
For example, JP2013-231878A discloses a method for forming a cured layer or a cured pattern, the method including a step of heating a coating layer, which is formed by applying a polymerizable composition containing a compound having a thermally polymerizable group onto a substrate, or a pattern formed by the coating layer in an environment where an oxygen concentration is 100 ppm or lower.

## SUMMARY OF THE INVENTION

As a result of examining the method described in JP2013-231878A, the present inventors have found that the cured film manufactured using the method has room for improvement in suppressibility of shape change (hereinafter, referred to as a "sustenance defect" as well) over time.
Furthermore, the sustenance defect means that in a case where the obtained cured film is left for a predetermined period, a shape of the cured film is deformed.
Accordingly, an object of the present invention is to provide a method for manufacturing a cured film having excellent sustenance-defect suppressibility. Moreover, another object of the present invention is to provide a method for manufacturing a solid-state imaging element.

[1] A method for manufacturing a cured film, the method comprising:

> a step of forming a curable composition layer by using a curable composition which contains one or more kinds of black coloring materials selected from the group consisting of a black pigment and a black dye, a polymerizable compound, and a photopolymerization initiator;
> a step of exposing the curable composition layer by irradiation with actinic rays or radiation;
> a step of developing the exposed curable composition layer; and
> a step of heating the developed curable composition layer at a temperature of lower than 170°C, in an environment where an oxygen concentration is lower than 1,000 ppm by volume, to form a cured film.

[2] The method for manufacturing a cured film described in [1], in which the oxygen concentration is 100 ppm by volume or lower.
[3] The method for manufacturing a cured film described in [1] or [2], in which the heating is performed using an oven.
[4] The method for manufacturing a cured film described in any one of [1] to [3], in which the photopolymerization initiator includes an oxime ester-based polymerization initiator.
[5] The method for manufacturing a cured film described in any one of [1] to [4], in which a double bond equivalent of the polymerizable compound is 10.0 mmol/g or greater.
[6] The method for manufacturing a cured film described in any one of [1] to [5], in which the black coloring material is the black pigment.
[7] The method for manufacturing a cured film described in [6], in which the black pigment absorbs infrared rays.
[8] The method for manufacturing a cured film described in [7], in which the black pigment is one or more kinds selected from the group consisting of a nitride of titanium, an oxynitride of titanium, a nitride of zirconium, an oxynitride of zirconium, a nitride of vanadium, an oxynitride of vanadium, a nitride of niobium, and an oxynitride of niobium.
[9] The method for manufacturing a cured film described in any one of [1] to [8], in which the cured film is a light blocking film.
[10] A method for manufacturing a solid-state imaging element including a cured film, the method comprising the

method for manufacturing a cured film described in any one of [1] to [9].

[11] A method for manufacturing a cured film, the method comprising:

a step of forming a curable composition layer by using a curable composition which contains one or more kinds of black coloring materials selected from the group consisting of a black pigment and a black dye, a polymerizable compound, and a photopolymerization initiator;
a step of exposing the curable composition layer by irradiation with actinic rays or radiation;
a step of developing the exposed curable composition layer; and
a step of irradiating the developed curable composition layer with ultraviolet rays to form a cured film.

[12] The method for manufacturing a cured film described in [11], in which the curable composition further contains a resin which contains a repeating unit having a graft chain and a repeating unit having an ethylenically unsaturated group on a side chain.

[13] The method for manufacturing a cured film described in [11] or [12], in which in the step of performing irradiation with ultraviolet rays to form a cured film, the irradiating light has a wavelength of 300 nm or less.

[14] The method for manufacturing a cured film described in any one of [11] to [13], in which the photopolymerization initiator includes a photopolymerization initiator which does not exhibit photosensitivity at a wavelength of 365 nm.

[15] The method for manufacturing a cured film described in any one of [11] to [14], in which the black coloring material is the black pigment.

[16] The method for manufacturing a cured film described in [15], in which the curable composition contains the black pigment as the black coloring material, and a content of the black pigment is less than 55% by mass with respect to a total solid content of the curable composition.

[17] The method for manufacturing a cured film described in [15] or [16], in which the black pigment absorbs infrared rays.

[18] The method for manufacturing a cured film described in [17], in which the black pigment is one or more kinds selected from the group consisting of a nitride of titanium, an oxynitride of titanium, a nitride of zirconium, an oxynitride of zirconium, a nitride of vanadium, an oxynitride of vanadium, a nitride of niobium, and an oxynitride of niobium.

[19] The method for manufacturing a cured film described in any one of [11] to [18], in which the cured film is a light blocking film.

[20] A method for manufacturing a solid-state imaging element including a cured film, the method comprising the method for manufacturing a cured film described in any one of [11] to [19].

According to the present invention, it is possible to provide a method for manufacturing a cured film having excellent sustenance-defect suppressibility.

Furthermore, according to the present invention, it is possible to provide a method for manufacturing a solid-state imaging element.

## BRIEF DESCRIPTION OF THE DRAWINGS

Fig. 1 is a schematic cross-sectional view showing an example of the constitution of a solid-state imaging device.
Fig. 2 is an enlarged schematic cross-sectional view showing an imaging portion in Fig. 1.

## DESCRIPTION OF THE PREFERRED EMBODIMENTS

Hereinafter, the present invention will be specifically described.

The following constituent elements will be described based on typical embodiments of the present invention in some cases, but the present invention is not limited to the embodiments.

Furthermore, in the present specification, a range of numerical values described using "to" means a range including the numerical values listed before and after "to" as a lower limit value and an upper limit value, respectively.

In addition, in the present specification, regarding the description of a group (atomic group), in a case where whether the group is substituted or unsubstituted is not described, the group includes a group which does not have a substituent and a group which has a substituent. For example, an "alkyl group" includes not only an alkyl group which does not have a substituent (unsubstituted alkyl group) but also an alkyl group which has a substituent (substituted alkyl group).

In addition, in the present specification, an "actinic rays" or "radiation" means, for example, far ultraviolet rays, extreme ultraviolet rays (EUV: extreme ultraviolet lithography), X-rays, electron beams, and the like. Moreover, in the

present specification, light means actinic rays and radiation.

In addition, in the present specification, "(meth)acrylate" represents acrylate and methacrylate. In the present specification, "(meth)acryl" represents acryl and methacryl. In the present specification, "(meth)acryloyl" represents acryloyl and methacryloyl. In the present specification, "(meth)acrylamide" represents acrylamide and methacrylamide. Furthermore, in the present specification, a "monomeric substance" and a "monomer" have the same definition.

In addition, in the present specification, "ppm" means "parts-per-million ($10^{-6}$)", "ppb" means "parts-per-billion ($10^{-9}$)", and "ppt" means "parts-per-trillion ($10^{-12}$)".

In the present specification, the weight-average molecular weight (Mw) is a value which is determined by a gel permeation chromatography (GPC) method and expressed in terms of polystyrene.

In the present specification, the GPC method is based on a method in which HLC-8020GPC (manufactured by Tosoh Corporation) is used, TSKgel SuperHZM-H, TSKgel SuperHZ4000, and TSKgel SuperHZ2000 (manufactured by Tosoh Corporation, 4.6 mmID × 15 cm) are used as columns, and tetrahydrofuran (THF) is used as an eluent.

[Method for manufacturing cured film]

In a manufacturing method according to an embodiment of the present invention, first, a curable composition layer is formed by using a curable composition which contains one or more kinds of black coloring materials selected from the group consisting of a black pigment and a black dye, a polymerizable compound, and a photopolymerization initiator.

Thereafter, the curable composition layer is exposed by irradiation with actinic rays or radiation, and the exposed curable composition layer is developed.

A cured film is manufactured by "heating at a temperature of lower than 170°C in an environment where an oxygen concentration is lower than 1,000 ppm by volume (method A)" or "irradiation with ultraviolet rays (method B)" with respect to the developed curable composition layer.

A mechanism by which a cured film having excellent sustenance-defect suppressibility is obtained by using the manufacturing method as described above is not always clear, but the present inventors presume as follows.

In the method A, since the heating is performed in a low-oxygen environment where the oxygen concentration is lower than 1,000 ppm by volume, radicals used for progress of polymerization of the curable composition layer are less likely to be deactivated by oxygen on a surface of the curable composition layer. Therefore, it is presumed that since curing progresses uniformly on the surface and the inside of the curable composition layer, internal stress is less likely to occur and occurrence of a sustenance defect in the cured film can be suppressed.

Furthermore, in the method A, since a heating temperature is lower than 170°C, voids (gaps) resulting from volatilization of a low-molecular-weight component in the curable composition layer or the like are less likely to be generated in the cured film. It is presumed that since the voids in the cured film can also be a starting point of shape change (sustenance defect) over time of the cured film, the number of voids in the cured film is reduced by setting a heating temperature to be lower than 170°C, and thus occurrence of a sustenance defect in the cured film is suppressed.

It is presumed that in the method B, curing of the curable composition layer can be allowed to uniformly progress by irradiation with ultraviolet rays, and thus occurrence of a sustenance defect in the cured film is suppressed.

[Curable composition]

First, the curable composition used in the manufacturing method according to the embodiment of the present invention will be described.

<Black coloring material>

The curable composition contains a black coloring material.

Examples of the black coloring material include one or more kinds selected from the group consisting of a black pigment and a black dye.

One kind of black coloring material may be used singly, or two or more kinds thereof may be used.

A content of the black coloring material in the curable composition is not particularly limited, but is preferably 1% to 99% by mass and more preferably 5% to 55% by mass with respect to a total solid content of the curable composition.

The total solid content means components forming a cured film and does not include a solvent. Moreover, as long as the component is a component forming a cured film, the component is regarded as a solid content even in a case where a property of the component is a liquid.

In addition, in a case where a post-curing treatment according to the method A is performed and the curable composition contains a black pigment, a content of the black pigment in the curable composition is preferably 25% to 70% by mass, more preferably 30% to 60% by mass, and even more preferably 33% to 55% by mass with respect to

the total solid content of the curable composition.

Furthermore, in a case where a post-curing treatment according to the method B is performed and the curable composition contains a black pigment, from the viewpoint of superior sustenance-defect suppressibility, the upper limit of the content of the black pigment in the curable composition is preferably 70% by mass or less, more preferably 60% by mass or less, even more preferably 56% by mass or less, particularly preferably less than 55% by mass, and most preferably 54% by mass or less with respect to the total solid content of the curable composition. The lower limit of the content of the black pigment in the curable composition is preferably 20% by mass or greater, more preferably 25% by mass or greater, and even more preferably 30% by mass or greater with respect to the total solid content of the curable composition.

In addition, a component obtained by combining a plurality of colorants which cannot be used alone as a black coloring material and adjusting the combination so as to be black as a whole may be used as a black coloring material.

For example, a pigment developing black alone is used as a black pigment, and a component obtained by combining a plurality of pigments having a color other than black alone may also be used as a black pigment. Similarly, a dye developing black alone is used as a black dye, and a component obtained by combining a plurality of dyes having a color other than black alone may also be used as a black dye.

Furthermore, the black coloring material refers to a coloring material which absorbs light over the entire wavelength range of 400 to 700 nm.

More specifically, for example, a black coloring material which meets evaluation standards Z described below is preferable.

First, a composition which contains a coloring material, a transparent resin matrix (acrylic resin or the like), and a solvent and in which a content of the coloring material with respect to the total solid content is 60% by mass is prepared. The obtained composition is applied onto a glass substrate such that a thickness of the dried coating film is 1 μm to form a coating film. Light blocking properties of the dried coating film are evaluated using a spectrophotometer (UV-3600 manufactured by Hitachi High-Tech Corporation or the like). In a case where a maximum value of a transmittance of the dried coating film at a wavelength of 400 to 700 nm is less than 10%, it can be determined that the coloring material is a black coloring material which meets the evaluation standards Z.

(Black pigment)

The black coloring material is preferably a black pigment.

As the black pigment, various known black pigments can be used. The black pigment may be an inorganic pigment or an organic pigment.

As the black pigment, a pigment developing black alone is preferable.

Furthermore, the black pigment is preferably a pigment which absorbs infrared rays, for example.

Here, the black pigment absorbing infrared rays absorbs light in a wavelength range of an infrared range (preferably, a wavelength of 650 to 1,300 nm), for example. A black pigment having a maximum absorption wavelength in a wavelength range of 675 to 900 nm is also preferable.

Examples of an inorganic pigment which absorbs infrared rays and develops black alone include a metal oxide, a metal nitride, and a metal oxynitride, which contain one or more kinds of metallic elements selected from the group consisting of a metallic element of Group 4 such as titanium (Ti) and zirconium (Zr), a metallic element of Group 5 such as vanadium (V) and niobium (Nb), cobalt (Co), chromium (Cr), copper (Cu), manganese (Mn), ruthenium (Ru), iron (Fe), nickel (Ni), tin (Sn), and silver (Ag). The inorganic pigment may be subjected to a surface modification treatment. For example, inorganic particles which are subjected to a surface modification treatment with a surface treatment agent having both a silicone group and an alkyl group are mentioned, and examples thereof include "KTP-09" series (manufactured by Shin-Etsu Chemical Co., Ltd.). Moreover, the metal oxide, the metal nitride, and the metal oxynitride may be used as particles in which other atoms are further mixed. For example, the metal oxide, the metal nitride, and the metal oxynitride may be used as metal nitride-containing particles which further contain an atom (preferably, an oxygen atom and/or a sulfur atom) selected from elements of Groups 13 to 17 of the periodic table. As the pigment which absorbs infrared rays and develops black alone, carbon black is also mentioned. Specific examples of the carbon black include an organic pigment such as C. I. Pigment Black 1 and an inorganic pigment such as C. I. Pigment Black 7, which are commercial products. Moreover, as the carbon black, carbon black whose surface is coated with a resin may be used.

Among them, as the black pigment, a nitride or an oxide of the metallic element of Group 4, a nitride or an oxynitride of the metallic element of Group 5, or the carbon black is preferable; a nitride or an oxynitride of titanium, a nitride or an oxynitride of zirconium, a nitride or an oxynitride of vanadium, a nitride or an oxynitride of niobium, or the carbon black is more preferable; a nitride or an oxynitride of titanium, a nitride or an oxynitride of zirconium, a nitride or an oxynitride of vanadium, or a nitride or an oxynitride of niobium is even more preferable; and a nitride or an oxynitride of titanium is particularly preferable.

In addition, for example, in a case where the black coloring material is a mixture of one or more kinds of black

pigments selected from the group consisting of a nitride or an oxynitride of titanium, a nitride or an oxynitride of zirconium, a nitride or an oxynitride of vanadium, and a nitride or an oxynitride of niobium and other black coloring materials, the total content of one or more kinds of black pigments selected from the group consisting of a nitride or an oxynitride of titanium, a nitride or an oxynitride of zirconium, a nitride or an oxynitride of vanadium, and a nitride or an oxynitride of niobium is preferably 30% by mass or greater, more preferably 40% by mass or greater, and even more preferably 50% by mass or greater with respect to the total mass of the black coloring materials.

Furthermore, the nitride of titanium is titanium nitride, the nitride of zirconium is zirconium nitride, the nitride of vanadium is vanadium nitride, and the nitride of niobium is niobium nitride. Moreover, the oxynitride of titanium is titanium oxynitride, the oxynitride of zirconium is zirconium oxynitride, the oxynitride of vanadium is vanadium oxynitride, and the oxynitride of niobium is niobium oxynitride.

In addition, in the present specification, the titanium nitride means TiN and may contain an oxygen atom (for example, a surface of the TiN particle is unintentionally oxidized or the like) which is unavoidable in manufacturing.

In the present specification, the titanium nitride means a compound in which a diffraction angle $2\theta$ of a peak derived from the (200) plane in a case where CuKa rays are used as an X-ray source is 42.5° to 42.8°.

Moreover, in the present specification, the titanium oxynitride means a compound in which the diffraction angle $2\theta$ of the peak derived from the (200) plane in a case where CuKa rays are used as an X-ray source is greater than 42.8°. The upper limit value of the diffraction angle $2\theta$ of the titanium oxynitride is not particularly limited, but is preferably 43.5° or less.

Examples of the titanium oxynitride include titanium black, and more specifically, for example, a form in which low-order titanium oxide represented by $TiO_2$ or $Ti_nO_{2n-1}$ ($1 \leq n \leq 20$) and/or titanium oxynitride represented by $TiN_xO_y$ ($0 < x < 2.0$ and $0.1 < y < 2.0$) are include is mentioned. In the following description, the titanium nitride (the diffraction angle $2\theta$ is 42.5° to 42.8°) and the titanium oxynitride (the diffraction angle $2\theta$ is greater than 42.8°) are collectively referred to as a titanium nitride, and a form thereof will be described.

Furthermore, the titanium nitride may be used as a particle in which other atoms are further mixed. For example, the titanium nitride may be used as a titanium nitride-containing particle which further contains an atom (preferably, a silicon atom, a sulfur atom, or the like) selected from elements of Groups 13 to 17 of the periodic table. Moreover, also for other metal nitrides, similarly, a metal nitride which refers to both metal nitride and metal oxynitride may be used as a particle in which other atoms are further mixed. For example, the metal nitride may be used as a metal nitride-containing particle which further contains an atom (preferably, a silicon atom, a sulfur atom, or the like) selected from elements of Groups 13 to 17 of the periodic table.

In a case where an X-ray diffraction spectrum of a titanium nitride is measured using the CuKa rays as the X-ray source, as a peak with the highest intensity, a peak derived from the (200) plane is observed near $2\theta$ = 42.5° for TiN and a peak derived from the (200) plane is observed near $2\theta$ = 43.4° for TiO. On the other hand, although the following peaks are not a peak with the highest intensity, a peak derived from the (200) plane is observed near $2\theta$ = 48.1° for anatase-type $TiO_2$ and a peak derived from the (200) plane is observed near $2\theta$ = 39.2° for rutile-type $TiO_2$. Therefore, as titanium oxynitride contains more oxygen atoms, the peak position shifts to the higher angle side with respect to 42.5°.

In a case where a titanium nitride contains titanium oxide $TiO_2$, as a peak with the highest intensity, a peak derived from anatase-type $TiO_2$ (101) is observed near $2\theta$ = 25.3° and a peak derived from rutile-type $TiO_2$ (110) is observed near $2\theta$ = 27.4°. However, since $TiO_2$ is white and is a factor of degrading light blocking properties of the light blocking film obtained by curing the curable composition, $TiO_2$ is preferably reduced to such an extent that $TiO_2$ is not observed as a peak.

A size of a crystallite constituting a titanium nitride can be determined from a half-width of the peak obtained by the measurement of the X-ray diffraction spectrum. The size of the crystallite can be calculated using the Scherrer equation.

The size of the crystallite constituting the titanium nitride is preferably 50 nm or smaller and preferably 20 nm or greater. In a case where the size of the crystallite is 20 to 50 nm, the cured film formed of the curable composition is more likely to have a higher transmittance of ultraviolet rays (particularly, i-line (a wavelength of 365 nm)) and a curable composition having higher photosensitivity is obtained.

A specific surface area of the titanium nitride is not particularly limited, but can be determined by the Brunauer, Emmett, Teller (BET) method. The specific surface area of the titanium nitride is preferably 5 to 100 $m^2/g$ and more preferably 10 to 60 $m^2/g$.

A method for manufacturing the black pigment is not particularly limited, known manufacturing methods can be used, and examples thereof include a gas phase reaction method. Examples of the gas phase reaction method include an electric furnace method and a thermal plasma method, but from the viewpoint that mixing of impurities is little, particle diameters are easily uniform, and productivity is high, the thermal plasma method is preferable.

In the thermal plasma method, the method for generating thermal plasma is not particularly limited, examples thereof include direct current arc discharge, multilayer arc discharge, radio-frequency (RF) plasma, and hybrid plasma, and the radio-frequency plasma in which mixing of impurities from electrodes is little is preferable.

The specific method for manufacturing the black pigment by the thermal plasma method is not particularly limited, but examples of a method for manufacturing a titanium nitride include a method (JP1990-022110A (JP-H02-022110A)) in which titanium tetrachloride is reacted with an ammonia gas in plasma flame, a method (JP1986-011140A (JP-S61-011140A)) in which titanium powder is evaporated by radio-frequency thermal plasma, and nitrogen is introduced as a carrier gas and nitrided in a cooling process to perform synthesis, and a method (JP1988-085007A (JP-S63-085007A)) in which an ammonia gas is blown into a peripheral edge of plasma.

However, the method for manufacturing the black pigment is not limited to the above examples, and as long as a black pigment having desired physical properties is obtained, the manufacturing method is not limited.

In addition, a component obtained by coating the (oxy)nitride of the metallic atom as described above with a silicon-containing compound may be used as a black pigment.

A method of coating the (oxy)nitride of the metallic atom is not particularly limited, known methods can be used, and examples thereof include the method (an (oxy)nitride of a metallic atom is used instead of a titanium oxide) described on page 2, lower right to page 4, upper right in JP1978-033228A (JP-S53-033228A), the method (an (oxy)nitride of a metallic atom is used instead of fine particulate titanium dioxide) described in paragraphs 0015 to 0043 in JP2008-069193A, and the method (an (oxy)nitride of a metallic atom is used instead of a metal oxide fine particle) described in paragraphs 0020 and 0124 to 0138 in JP2016-074870A, the contents of which are incorporated into the present specification.

Furthermore, in a case where the curable composition contains titanium black, it is also preferable that the titanium black is contained as a substance to be dispersed containing titanium black and a Si atom.

In this form, titanium black is contained as a substance to be dispersed in the composition, and a content ratio (Si/Ti)of a Si atom to a Ti atom in the substance to be dispersed is preferably 0.05 or more, more preferably 0.05 to 0.5, and even more preferably 0.07 to 0.4 in terms of mass.

Here, the substance to be dispersed includes both titanium black in a primary particle state and titanium black in an aggregate (secondary particle) state.

In order to change Si/Ti in the substance to be dispersed (for example, set to be 0.05 or more), the following unit can be used.

First, a substance to be dispersed which contains titanium black particles as a main component and contains Si and Ti can be obtained by dispersing titanium oxide and silica particles using a disperser to obtain a dispersion and subjecting the dispersion to a reduction treatment at a high temperature (for example, 850°C to 1,000°C). The reduction treatment can also be performed in an atmosphere of a reducing gas such as ammonia.

Examples of the titanium oxide include TTO-51N (trade name, manufactured by ISHIHARA SANGYO KAISHA, LTD.).

Examples of a commercial product of the silica particles include AEROSIL (registered trademark) 90, 130, 150, 200, 255, 300, and 380 (trade name, manufactured by Evonik Industries AG).

A dispersant may be used to disperse the titanium oxide and the silica particles. Examples of the dispersant include those described later as a dispersant.

The dispersion may be performed in a solvent. Examples of the solvent include water and an organic solvent. Examples thereof include those described in a column of the organic solvent described later.

Titanium black in which Si/Ti is adjusted to, for example, 0.05 or more can be produced, for example, by the method described in paragraphs 0005 and 0016 to 0021 in JP2008-266045A.

By adjusting a content ratio (Si/Ti) of a Si atom and a Ti atom in a substance to be dispersed containing titanium black and a Si atom to a suitable range (for example, 0.05 or more), in a case where a cured film is formed by using a composition containing the substance to be dispersed, residues derived from the composition in regions other than a region where the cured film is formed are reduced. Moreover, the residue contains components derived from the composition, such as titanium black particles and a resin component.

The reason why the residues are reduced is not yet clear, but the substance to be dispersed as described above tends to have a small particle diameter (for example, the particle diameter is 30 nm or smaller), and by increasing a component containing the Si atom of the substance to be dispersed, the adsorptivity of the entire film to a base is reduced. It is presumed that this contributes to improvement in removability of an uncured composition (particularly, titanium black) by development in the formation of the cured film.

In addition, since the titanium black has excellent light blocking properties for light in a wide wavelength range from ultraviolet light to infrared light, a light blocking film formed of the substance to be dispersed (preferably, Si/Ti is 0.05 or more in terms of mass) containing the titanium black and the Si atom exhibits excellent light blocking properties.

Furthermore, the content ratio (Si/Ti) of the Si atom to the Ti atom in the substance to be dispersed can be measured, for example, by using the method (1-1) or the method (1-2) described in paragraph 0033 in JP2013-249417A.

Moreover, regarding a substance to be dispersed contained in a cured film obtained by curing a composition, in a case where whether or not a content ratio (Si/Ti) of a Si atom to a Ti atom in the substance to be dispersed is 0.05 or more is determined, the method (2) described in paragraph 0035 in JP2013-249417Ais used.

In a substance to be dispersed containing titanium black and a Si atom, as the titanium black, the titanium black described above can be used.

Hereinafter, a material used in a case where a Si atom is introduced into the substance to be dispersed will be described. In a case where a Si atom is introduced into the substance to be dispersed, a Si-containing substance such as silica may be used.

Examples of silica which can be used include precipitated silica, fumed silica, colloidal silica, and synthetic silica, and these may be appropriately selected and used.

Furthermore, in a case where a particle diameter of a silica particle is smaller than a film thickness after formation of a light blocking film (cured film), the light blocking properties are superior, and thus fine particle-type silica is preferably used as a silica particle. Moreover, examples of the fine particle-type silica include the silica described in paragraph 0039 in JP2013-249417A, the contents of which are incorporated into the present specification.

In addition, as described above, a component obtained by combining a plurality of pigments having a color other than black alone may be used as a black pigment.

Such a pigment having a color other than black alone may be an inorganic pigment or an organic pigment. As the pigment having a color other than black alone, for example, a pigment (chromatic color pigment) of a chromatic color such as red (R), green (G), and blue (B) can also be used.

An inorganic pigment having a color other than black alone is not particularly limited, and known inorganic pigments can be used.

The inorganic pigment can be selected from, for example, titanium oxide, chromium oxide, iron oxide, red lead, red iron oxide, chrome yellow, zinc yellow (one kind of zinc yellow or two kinds of zinc yellow), ultramarine blue, Prussian blue (potassium ferric ferrocyanide), zircon grey, Praseodymium yellow, chromium titanium yellow, chrome green, peacock, Victoria green, iron blue (irrelevant to Prussian blue), vanadium zirconium blue, chrome tin pink, manganese pink, salmon pink, and the like.

The inorganic pigment may be subjected to a surface modification treatment. For example, an inorganic pigment which is subjected to a surface modification treatment with a surface treatment agent having both a silicone group and an alkyl group is mentioned, and examples thereof include "KTP-09" series (manufactured by Shin-Etsu Chemical Co., Ltd.).

An organic pigment having a color other than black alone is selected from, for example, the following organic pigments.

Color Index (C. I.) Pigment Yellow 1, 2, 3, 4, 5, 6, 10, 11, 12, 13, 14, 15, 16, 17, 18, 20, 24, 31, 32, 34, 35, 35:1, 36, 36:1, 37, 37:1, 40, 42, 43, 53, 55, 60, 61, 62, 63, 65, 73, 74, 77, 81, 83, 86, 93, 94, 95, 97, 98, 100, 101, 104, 106, 108, 109, 110, 113, 114, 115, 116, 117, 118, 119, 120, 123, 125, 126, 127, 128, 129, 137, 138, 139, 147, 148, 150, 151, 152, 153, 154, 155, 156, 161, 162, 164, 166, 167, 168, 169, 170, 171, 172, 173, 174, 175, 176, 177, 179, 180, 181, 182, 185, 187, 188, 193, 194, 199, 213, 214, and the like;
C. I. Pigment Orange 2, 5, 13, 16, 17:1, 31, 34, 36, 38, 43, 46, 48, 49, 51, 52, 55, 59, 60, 61, 62, 64, 71, 73, and the like;
C. I. Pigment Red 1, 2, 3, 4, 5, 6, 7, 9, 10, 14, 17, 22, 23, 31, 38, 41, 48:1, 48:2, 48:3, 48:4, 49, 49:1, 49:2, 52:1, 52:2, 53:1, 57:1, 60:1, 63:1, 66, 67, 81:1, 81:2, 81:3, 83, 88, 90, 105, 112, 119, 122, 123, 144, 146, 149, 150, 155, 166, 168, 169, 170, 171, 172, 175, 176, 177, 178, 179, 184, 185, 187, 188, 190, 200, 202, 206, 207, 208, 209, 210, 216, 220, 224, 226, 242, 246, 254, 255, 264, 270, 272, 279, and the like;
C. I. Pigment Green 7, 10, 36, 37, 58, 59, and the like;
C. I. Pigment Violet 1, 19, 23, 27, 32, 37, 42, and the like; and
C. I. Pigment Blue 1, 2, 15, 15:1, 15:2, 15:3, 15:4, 15:6, 16, 22, 60, 64, 66, 79, 80, and the like.

The pigment may be used in combination with a dye described later.

In order to adjust a tint and to enhance light blocking properties in a desired wavelength range, for example, a pigment developing black alone and/or a pigment having a color other than black alone may be mixed with a chromatic color pigment or a dye described later, such as red, green, yellow, orange, violet, and blue.

Moreover, a pigment which absorbs infrared rays and develops black alone is also preferably mixed with a red pigment or dye or a violet pigment or dye, and more preferably mixed with a red pigment.

Furthermore, an infrared absorber described later may be added.

In addition, as a pigment which has a color other than black alone and absorbs infrared rays, a tungsten compound, a metal boride, and the like can also be used. Among them, from the viewpoint that light blocking properties are excellent at a wavelength in an infrared range, a tungsten compound is preferable. The tungsten compound is excellent in light transmitting properties in a visible light range and a light absorption wavelength range of an oxime-based polymerization initiator related to curing efficiency by exposure.

Considering handleability, an average primary particle diameter of the black pigment is preferably 0.01 to 0.1 $\mu$m and more preferably 0.01 to 0.05 $\mu$m. In a case where the black pigment consists of a combination of a plurality of kinds of pigments, it is preferable that an average primary particle diameter of one or more kinds of pigments constituting the black pigment is within the above range, and more preferable that an average primary particle diameter of all kinds

of pigments constituting the black pigment is within the above range.

In addition, the average primary particle diameter of the pigment can be measured using a transmission electron microscope (TEM). As the transmission electron microscope, for example, a transmission electron microscope HT7700 manufactured by Hitachi High-Tech Corporation can be used.

For a particle image obtained using a transmission electron microscope, a maximum length (Dmax: maximum length between two points on the contour of the particle image) and a vertical length to maximum length (Dv-max: in a case where the image is interposed between two straight lines parallel to the line of the maximum length, DV-max is a minimum length of a line vertically connecting the two straight lines) are measured, and the value of geometrical mean thereof $(\text{Dmax} \times \text{DV-max})^{1/2}$ is adopted as a particle diameter. By this method, particle diameters are measured for 100 particles, the value of arithmetic mean thereof is calculated as an average particle diameter, and the average particle diameter is adopted as an average primary particle diameter of the pigment.

(Black dye)

As the black dye, a dye developing black alone can be used. Moreover, as described above, a component obtained by combining a plurality of dyes having a color other than black alone may be used as a black dye.

As such a coloring dye, for example, in addition to a dye (chromatic color dye) of a chromatic color such as red (R), green (G), and blue (B), the colorant described in paragraphs 0027 to 0200 in JP2014-042375A can also be used.

In addition, as the dye, for example, the coloring agents disclosed in JP1989-090403A (JP-S64-090403A), JP1989-091102A (JP-S64-091102A), JP1989-094301A (JP-H01-094301A), JP1994-011614A (JP-H06-011614A), JP2592207B, US4808501A, US5667920A, US505950, JP1993-333207A (JP-H05-333207A), JP1994-035183A (JP-H06-035183A), JP1994-051115A (JP-H06-051115A), JP1994-194828A (JP-H06-194828A), and the like can be used. In a case where the dyes are sorted based on the chemical structure, a pyrazole azo compound, a pyrromethene compound, an anilinoazo compound, a triphenylmethane compound, an anthraquinone compound, a benzylidene compound, an oxonol compound, a pyrazolotriazole azo compound, a pyridone azo compound, a cyanine compound, a phenothiazine compound, a pyrrolopyrazole azomethine compound, or the like can be used. Furthermore, a coloring agent multimer may be used as a dye. Examples of the coloring agent multimer include the compounds described in JP2011-213925A and JP2013-041097A. In addition, a polymerizable dye having a polymerizable group in a molecule may be used, and examples of a commercial product thereof include RDW series manufactured by Wako Pure Chemical Industries, Ltd.

(Infrared absorber)

The black coloring material may further contain an infrared absorber as a coloring material having a color other than black alone.

The infrared absorber means a compound absorbing light in a wavelength range of an infrared range (preferably, at a wavelength of 650 to 1,300 nm). The infrared absorber is preferably a compound having a maximum absorption wavelength in a wavelength range of 675 to 900 nm.

Examples of a colorant having such spectral characteristics include a pyrrolopyrrole compound, a copper compound, a cyanine compound, a phthalocyanine compound, an iminium compound, a thiol complex-based compound, a transition metal oxide-based compound, a squarylium compound, a naphthalocyanine compound, a quaterrylene compound, a dithiol metal complex-based compound, and a croconium compound.

As the phthalocyanine compound, the naphthalocyanine compound, the iminium compound, the cyanine compound, the squarylium compound, and the croconium compound, the compounds disclosed in paragraphs 0010 to 0081 in JP2010-111750A may be used, and the contents thereof are incorporated into the present specification. Regarding the cyanine compound, reference can be made to, for example, "Functional coloring agent, written by Makoto OKAWARA, Satoshi MATSUOKA, Teijiro KITAO, and Tsuneaki HIRASHIMA, KODANSHA SCIENTIFIC LTD.", the contents of which are incorporated into the present specification.

As the colorant having the spectral characteristics, it is also possible to use the compound disclosed in paragraphs 0004 to 0016 in JP1995-164729A (JP-H07-164729A) and/or the compound disclosed in paragraphs 0027 to 0062 in JP2002-146254A, and the near-infrared absorption particles disclosed in paragraphs 0034 to 0067 in JP2011-164583A, which consist of crystallites of an oxide containing Cu and/or P and have a number-average aggregated particle diameter of 5 to 200 nm.

As the compound having a maximum absorption wavelength in a wavelength range of 675 to 900 nm, at least one kind of compound selected from the group consisting of a cyanine compound, a pyrrolopyrrole compound, a squarylium compound, a phthalocyanine compound, and a naphthalocyanine compound is preferable.

Furthermore, the infrared absorber is preferably a compound which dissolves in an amount of 1% by mass or greater in water at 25°C, and more preferably a compound which dissolves in an amount of 10% by mass or greater in

water at 25°C. By using such a compound, solvent resistance is improved.

Regarding the pyrrolopyrrole compound, reference can be made to paragraphs 0049 to 0062 in JP2010-222557A, the contents of which are incorporated into the present specification. Regarding the cyanine compound and the squarylium compound, reference can be made to paragraphs 0022 to 0063 in WO2014/088063A, paragraphs 0053 to 0118 in WO2014/030628A, paragraphs 0028 to 0074 in JP2014-059550A, paragraphs 0013 to 0091 in WO2012/169447A, paragraphs 0019 to 0033 in JP2015-176046A, paragraphs 0053 to 0099 in JP2014-063144A, paragraphs 0085 to 0150 in JP2014-052431A, paragraphs 0076 to 0124 in JP2014-044301A, paragraphs 0045 to 0078 in JP2012-008532A, paragraphs 0027 to 0067 in JP2015-172102A, paragraphs 0029 to 0067 in JP2015-172004A, paragraphs 0029 to 0085 in JP2015-040895A, paragraphs 0022 to 0036 in JP2014-126642A, paragraphs 0011 to 0017 in JP2014-148567A, paragraphs 0010 to 0025 in JP2015-157893A, paragraphs 0013 to 0026 in JP2014-095007A, paragraphs 0013 to 0047 in JP2014-080487A, paragraphs 0007 to 0028 in JP2013-227403A, and the like, the contents of which are incorporated into the present specification.

<Polymerizable compound>

The curable composition contains a polymerizable compound. In the present specification, the polymerizable compound means a compound which is polymerized by the action of a photopolymerization initiator described later.

A content of the polymerizable compound in the curable composition is not particularly limited, but is preferably 5% to 30% by mass with respect to the total solid content of the curable composition. One kind of polymerizable compound may be used singly, or two or more kinds thereof may be used in combination. In a case where two or more kinds of polymerizable compounds are used in combination, the total content thereof is preferably within the above range.

A molecular weight of the polymerizable compound is preferably 2,000 or less.

As the polymerizable compound, a compound having one or more groups (hereinafter, simply referred to as an "ethylenically unsaturated group" as well) containing an ethylenically unsaturated bond is preferable, a compound having two or more groups containing an ethylenically unsaturated bond is more preferable, a compound having three or more groups containing an ethylenically unsaturated bond is even more preferable, and a compound having five or more groups containing an ethylenically unsaturated bond is particularly preferable. The upper limit of the number of the groups is, for example, 15 or less. Examples of the ethylenically unsaturated group include a vinyl group, a (meth)allyl group, and a (meth)acryloyl group.

As the polymerizable compound, for example, the compounds described in paragraph 0050 in JP2008-260927A and paragraph 0040 in JP2015-068893A can be used, and the contents thereof are incorporated into the present specification.

The polymerizable compound may be in any of chemical forms such as a monomer, a prepolymer, an oligomer, a mixture thereof, and a multimer thereof.

The polymerizable compound is preferably a tri- to pentadeca-functional (meth)acrylate compound and more preferably a tri- to hexa-functional (meth)acrylate compound.

As the polymerizable compound, a compound having one or more ethylenically unsaturated groups and having a boiling point of 100°C or lower under normal pressure is also preferable. For example, reference can be made to the compounds described in paragraph 0227 in JP2013-029760A and paragraphs 0254 to 0257 in JP2008-292970A, the contents of which are incorporated into the present specification.

The polymerizable compound is preferably dipentaerythritol triacrylate (as a commercial product, KAYARAD D-330 manufactured by Nippon Kayaku Co., Ltd.), dipentaerythritol tetraacrylate (as a commercial product, KAYARAD D-320 manufactured by Nippon Kayaku Co., Ltd.), dipentaerythritol penta(meth)acrylate (as a commercial product, KAYARAD D-310 manufactured by Nippon Kayaku Co., Ltd.), dipentaerythritol hexa(meth)acrylate (as a commercial product, KAYARAD DPHA manufactured by Nippon Kayaku Co., Ltd. and A-DPH-12E manufactured by Shin-Nakamura Chemical Co., Ltd.), and a structure (for example, SR454 and SR499 commercially available from Sartomer Co. Inc.) in which these (meth)acryloyl groups are linked via an ethylene glycol residue or a propylene glycol residue. Oligomer types thereof can also be used. Moreover, NK ESTER A-TMMT (pentaerythritol tetraacrylate, manufactured by Shin-Nakamura Chemical Co., Ltd.), KAYARAD RP-1040 (manufactured by Nippon Kayaku Co., Ltd.), and the like can also be used.

The preferred aspects of the polymerizable compound are shown below.

The polymerizable compound may have an acid group such as a carboxylic acid group, a sulfonic acid group, and a phosphoric acid group. As the polymerizable compound having an acid group, an ester of an aliphatic polyhydroxy compound and unsaturated carboxylic acid is preferable, a polymerizable compound having an acid group by reacting an unreacted hydroxyl group of an aliphatic polyhydroxy compound with a non-aromatic carboxylic acid anhydride is more preferable, and one in which the aliphatic polyhydroxy compound in the ester is pentaerythritol and/or dipentaerythritol is even more preferable. Examples of a commercial product thereof include ARONIX TO-2349, M-305, M-510, and M-520, which are manufactured by TOAGOSEI CO., LTD.

An acid value of the polymerizable compound having an acid group is preferably 0.1 to 40 mg KOH/g and more preferably 5 to 30 mg KOH/g. In a case where the acid value of the polymerizable compound is 0.1 mg KOH/g or greater, development dissolution characteristics are favorable, and in a case where the acid value is 40 mg KOH/g or less, the polymerizable compound is advantageous in production and/or handling. Furthermore, a photopolymerization performance is favorable and curing properties are excellent.

Regarding the polymerizable compound, a compound having a caprolactone structure is also a preferred aspect.

The compound having a caprolactone structure is not particularly limited as long as the compound has a caprolactone structure in a molecule, and examples thereof include ε-caprolactone-modified polyfunctional (meth)acrylate which is obtained by esterifying polyhydric alcohol such as trimethylolethane, ditrimethylolethane, trimethylolpropane, ditrimethylolpropane, pentaerythritol, dipentaerythritol, tripentaerythritol, glycerin, diglycerol, and trimethylol melamine, with (meth)acrylic acid and ε-caprolactone. Among them, a compound having a caprolactone structure, which is represented by Formula (Z-1), is preferable.

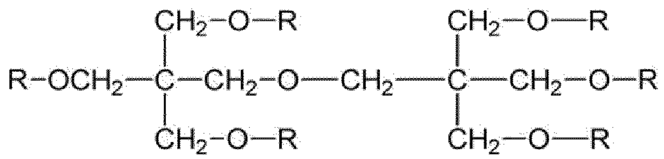

(Z-1)

In Formula (Z-1), all of six R's are a group represented by Formula (Z-2), or one to five R's among six R's are a group represented by Formula (Z-2) and the others are a group represented by Formula (Z-3).

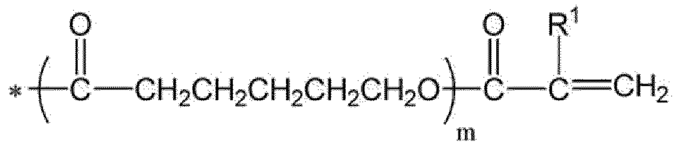

(Z-2)

In Formula (Z-2), $R^1$ represents a hydrogen atom or a methyl group, m represents a number of 1 or 2, and * represents a bond.

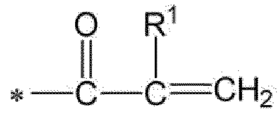

(Z-3)

In Formula (Z-3), $R^1$ represents a hydrogen atom or a methyl group and * represents a bond.

Examples of the polymerizable compound having a caprolactone structure include compounds commercially available as a KAYARAD DPCA series from Nippon Kayaku Co., Ltd., such as DPCA-20 (a compound in which in Formulae (Z-1) to (Z-3), m is 1, the number of groups represented by Formula (Z-2) is 2, and all of $R^1$'s are hydrogen atoms), DPCA-30 (a compound in which in Formulae (Z-1) to (Z-3), m is 1, the number of groups represented by Formula (Z-2) is 3, and all of $R^1$'s are hydrogen atoms), DPCA-60 (a compound in which in Formulae (Z-1) to (Z-3), m is 1, the number of groups represented by Formula (Z-2) is 6, and all of $R^1$'s are hydrogen atoms), and DPCA-120 (a compound in which in Formulae (Z-1) to (Z-3), m is 2, the number of groups represented by Formula (Z-2) is 6, and all of $R^1$'s are hydrogen atoms).

As the polymerizable compound, a compound represented by Formula (Z-4) or (Z-5) can also be used.

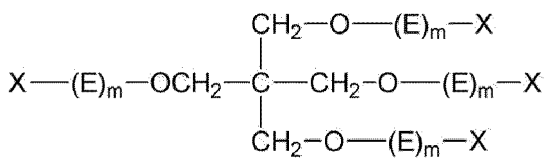

(Z-4)

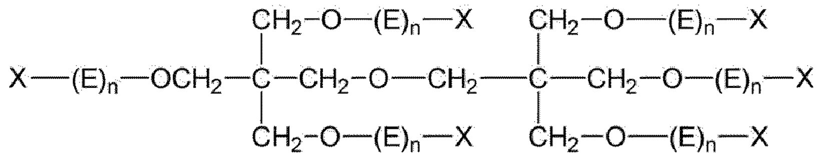

(Z-5)

In Formulae (Z-4) and (Z-5), E's each independently represent $-((CH_2)_yCH_2O)-$ or $((CH_2)_yCH(CH_3)O)-$, y's each independently represent an integer of 0 to 10, and X's each independently represent a (meth)acryloyl group, a hydrogen atom, or a carboxylic acid group.

In Formula (Z-4), the total number of (meth)acryloyl groups is 3 or 4, m's each independently represent an integer of 0 to 10, and the sum of respective m's is an integer of 0 to 40.

In Formula (Z-5), the total number of (meth)acryloyl groups is 5 or 6, n's each independently represent an integer of 0 to 10, and the sum of respective n's is an integer of 0 to 60.

In Formula (Z-4), m is preferably an integer of 0 to 6 and more preferably an integer of 0 to 4.

Moreover, the sum of respective m's is preferably an integer of 2 to 40, more preferably an integer of 2 to 16, and even more preferably an integer of 4 to 8.

In Formula (Z-5), n is preferably an integer of 0 to 6 and more preferably an integer of 0 to 4.

Moreover, the sum of respective n's is preferably an integer of 3 to 60, more preferably an integer of 3 to 24, and even more preferably an integer of 6 to 12.

In addition, an aspect in which a terminal on an oxygen atom side of $-((CH_2)_yCH_2O)-$ or $((CH_2)_yCH(CH_3)O)-$ in Formula (Z-4) or (Z-5) is bonded to X is preferable.

One kind of compound represented by Formula (Z-4) or (Z-5) may be used singly, or two or more kinds thereof may be used in combination. In particular, an aspect in which in Formula (Z-5), all of six X's are acryloyl groups, and an aspect that is a mixture of a compound in which in Formula (Z-5), all of six X's are acryloyl groups and a compound in which at least one X among six X's is a hydrogen atom are preferable. With such a structure, developability can be further improved.

In addition, the total content of the compound represented by Formula (Z-4) or (Z-5) in the polymerizable compound is preferably 20% by mass or greater and more preferably 50% by mass or greater.

Among the compounds represented by Formula (Z-4) or (Z-5), a pentaerythritol derivative and/or a dipentaerythritol derivative is more preferable.

Furthermore, the polymerizable compound may have a cardo skeleton.

As the polymerizable compound having a cardo skeleton, a polymerizable compound having a 9,9-bisarylfluorene skeleton is preferable.

The polymerizable compound having a cardo skeleton is not limited, but examples thereof include ONCOAT EX series (manufactured by NAGASE & CO., LTD.) and OGSOL (manufactured by Osaka Gas Chemicals Co., Ltd.).

From the viewpoint that the sustenance-defect suppressibility of the obtained cured film is superior, a double bond equivalent (which is a content of an ethylenically unsaturated group, and more specifically, means a value obtained by dividing the number of ethylenically unsaturated groups in the polymerizable compound by a molecular weight (g/mol) of the polymerizable compound) of the polymerizable compound is preferably 6.0 mmol/g or greater and more preferably 10.0 mmol/g or greater. The upper limit is not particularly limited, but is generally 12.0 mmol/g or less.

Furthermore, in a case where the curable composition contains a plurality of kinds of polymerizable compounds and double bond equivalents thereof are not the same, the sum of products of mass percentages of respective polymerizable compounds in all the polymerizable compounds and double bond equivalents of the respective polymerizable compounds is preferably within the above range.

Among them, in a case where the method A is used, the double bond equivalent of the polymerizable compound is preferably within the above range.

In the present specification, the double bond equivalent may be referred to as a "C=C value".

In a case where the curable composition contains a plurality of kinds of polymerizable compounds and a C=C value of each polymerizable compound is clear, a C=C value as the total mass of the polymerizable compounds contained in the curable composition is determined by calculation from a formulation ratio of each polymerizable compound.

In a case where the ethylenically unsaturated group is a (meth)acryloyl group, the C=C value (content of the ethylenically unsaturated group) of the polymerizable compound contained in the curable composition can be measured, for example, by the following method.

First, solid components (black pigment or the like) in a curable composition are precipitated by a centrifugal separation method, and remaining liquid components are collected. Furthermore, a polymerizable compound is separated from the obtained liquid components by a liquid chromatography method, a structure of the polymerizable compound is specified by analysis using a nuclear magnetic resonance (NMR) method and a GPC method, and a C=C value is

determined. The C=C value (content of the ethylenically unsaturated group) is calculated as a value obtained by dividing the number of polymerizable groups contained in one molecule by a molecular weight.

<Photopolymerization initiator>

The curable composition contains a photopolymerization initiator.

The photopolymerization initiator is not particularly limited as long as the photopolymerization initiator can initiate the polymerization of a polymerizable compound, and known photopolymerization initiators can be used. As the photopolymerization initiator, for example, a photopolymerization initiator exhibiting photosensitivity in a range of ultraviolet rays to visible light is preferable. Furthermore, the photopolymerization initiator may be an activator which generates active radicals by interacting in a certain way with a photoexcited sensitizer or an initiator (radical polymerization initiator) which initiates cationic polymerization according to the type of the polymerizable compound.

Furthermore, the photopolymerization initiator preferably contains at least one kind of compound having at least a molar absorption coefficient of 50 L/(mol·cm) in a range of 300 to 800 nm (preferably 330 to 500 nm).

In the present specification, for the molar absorption coefficient of the compound, known methods can be used, and for example, the molar absorption coefficient is preferably measured using an ultraviolet and visible spectrophotometer (Cary-5 spectrophotometer manufactured by Varian, Inc.) and an ethyl acetate solvent at a concentration of 0.01 g/L.

Examples of the photopolymerization initiator include a halogenated hydrocarbon derivative (for example, a halogenated hydrocarbon derivative containing a triazine skeleton, a halogenated hydrocarbon derivative containing an oxadiazole skeleton, or the like), an acyl phosphine compound such as acyl phosphine oxide, hexaaryl biimidazole, an oxime compound such as an oxime derivative, an organic peroxide, a thio compound, a ketone compound, an aromatic onium salt, an aminoacetophenone compound, and hydroxyacetophenone.

As a specific example of the photopolymerization initiator, reference can be made to, for example, paragraphs 0265 to 0268 in JP2013-029760A, the contents of which are incorporated into the present specification.

As the photopolymerization initiator, more specifically, for example, the aminoacetophenone-based initiator described in JP1998-291969A (JP-H10-291969A) and the acyl phosphine-based initiator described in JP4225898B can also be used.

As the hydroxyacetophenone compound, for example, IRGACURE-184, DAROCUR-1173, IRGACURE-500, IRGACURE-2959, and IRGACURE-127 (trade names, all manufactured by BASF SE) can be used.

As the aminoacetophenone compound, for example, IRGACURE-907, IRGACURE-369, or IRGACURE-379EG (trade names, all manufactured by BASF SE), which is a commercial product, can be used. As the aminoacetophenone compound, the compound described in JP2009-191179A whose absorption wavelength is matched with a long-wave light source having a wavelength of 365 nm or a wavelength of 405 nm can also be used.

As the acyl phosphine compound, IRGACURE-819 or IRGACURE-TPO (trade names, all manufactured by BASF SE), which is a commercial product, can be used.

Oxime compound

As the photopolymerization initiator, an oxime ester-based polymerization initiator (oxime compound) is more preferable. The oxime compound is particularly preferable because the oxime compound has high sensitivity and high polymerization efficiency.

Among them, in a case where the method A is used, it is preferable that the oxime ester-based polymerization initiator (oxime compound) is used as the photopolymerization initiator.

As a specific example of the oxime compound, the compound described in JP2001-233842A, the compound described in JP2000-080068A, or the compound described in JP2006-342166A can be used.

Examples of the oxime compound include 3-benzoyloxyiminobutan-2-one, 3 -acetoxyiminobutan-2-one, 3 -propionyloxyiminobutan-2-one, 2-acetoxyiminopentan-3 -one, 2-acetoxyimino-1-phenylpropan-1-one, 2-benzoyloxyimino-1-phenylpropan-1-one, 3-(4-toluenesulfonyloxy)iminobutan-2-one, and 2-ethoxycarbonyloxyimino-1-phenylpropan-1-one.

Moreover, examples of the oxime compound also include the compounds described in J. C. S. Perkin II (1979) pp. 1653 to 1660, J. C. S. Perkin II (1979) pp. 156 to 162, Journal of Photopolymer Science and Technology (1995) pp. 202 to 232, JP2000-066385A, JP2000-080068A, JP2004-534797A, and JP2006-342166A.

Among commercial products, IRGACURE-OXE01 (manufactured by BASF SE), IRGACURE-OXE02 (manufactured by BASF SE), IRGACURE-OXE03 (manufactured by BASF SE), or IRGACURE-OXE04 (manufactured by BASF SE) is also preferable. In addition, TR-PBG-304 (manufactured by Changzhou Tronly New Electronic Materials Co., Ltd.), ADEKA ARKLS NCI-831 or ADEKA ARKLS NCI-930 (manufactured by ADEKA CORPORATION), or N-1919 (carbazole and oxime ester skeleton-containing photoinitiator (manufactured by ADEKA CORPORATION)) can also be

used.

Furthermore, as oxime compounds other than the above-described oxime compounds, the compound described in JP2009-519904A in which oxime is linked to N-position of carbazole; the compound described in US7626957B in which a hetero substituent is introduced into a benzophenone moiety; the compound described in JP2010-015025A and US2009/0292039A in which a nitro group is introduced into the moiety of a coloring agent; the ketoxime compound described in WO2009/131189A; the compound described in US7556910B that contains a triazine skeleton and an oxime skeleton in the same molecule; the compound described in JP2009-221114A that has absorption maximum at 405 nm and exhibits favorable sensitivity with respect to a light source of g-line; and the like may be used.

Reference can be made to, for example, paragraphs 0274 and 0275 in JP2013-029760A, the contents of which are incorporated into the present specification.

Specifically, as the oxime compound, a compound represented by Formula (OX-1) is preferable. Moreover, in the oxime compound, a N-O bond may be an (E)-isomer, a (Z)-isomer, or a mixture of the (E)-isomer and the (Z)-isomer.

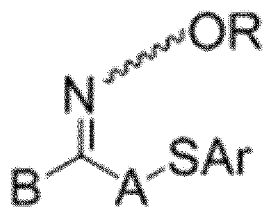

(OX-1)

In Formula (OX-1), R and B each independently represent a monovalent substituent, A represents a divalent organic group, and Ar represents an aryl group.

As the monovalent substituent represented by R in Formula (OX-1), a group of monovalent nonmetallic atoms is preferable.

Examples of the group of monovalent nonmetallic atoms include an alkyl group, an aryl group, an acyl group, an alkoxycarbonyl group, an aryloxycarbonyl group, a heterocyclic group, an alkylthiocarbonyl group, and an arylthiocarbonyl group. Moreover, these groups may have one or more substituents. Furthermore, each of the above-described substituents may be further substituted with another substituent.

Examples of the substituent include a halogen atom, an aryloxy group, an alkoxycarbonyl group, an aryloxycarbonyl group, an acyloxy group, an acyl group, an alkyl group, and an aryl group.

As the monovalent substituent represented by B in Formula (OX-1), an aryl group, a heterocyclic group, an arylcarbonyl group, or a heterocyclic carbonyl group is preferable, and an aryl group or a heterocyclic group is more preferable. These groups may have one or more substituents. As the substituents, the above-described substituents can be exemplified.

As the divalent organic group represented by A in Formula (OX-1), an alkylene group having 1 to 12 carbon atoms, a cycloalkylene group, or an alkynylene group is preferable. These groups may have one or more substituents. As the substituents, the above-described substituents can be exemplified.

As the photopolymerization initiator, a fluorine atom-containing oxime compound can also be used. Specific examples of the fluorine atom-containing oxime compound include the compound described in JP2010-262028A; the compounds 24 and 36 to 40 described in JP2014-500852A; and the compound (C-3) described in JP2013-164471A. The contents of the above documents are incorporated into the present specification.

As the photopolymerization initiator, compounds represented by Formulae (1) to (4) can also be used.

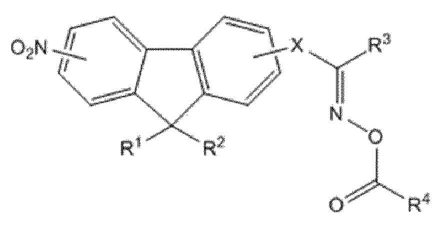

(1)

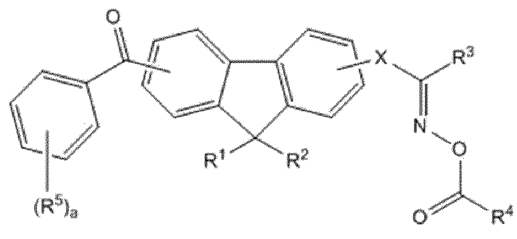

(2)

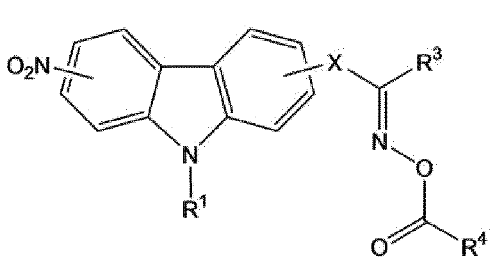

(3)

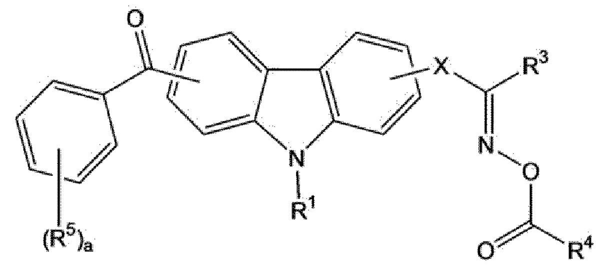

(4)

In Formula (1), $R^1$ and $R^2$ each independently represent an alkyl group having 1 to 20 carbon atoms, an alicyclic hydrocarbon group having 4 to 20 carbon atoms, an aryl group having 6 to 30 carbon atoms, or an aryl alkyl group having 7 to 30 carbon atoms, in a case where $R^1$ and $R^2$ each represent a phenyl group, the phenyl groups may be bonded to each other to form a fluorene group, $R^3$ and $R^4$ each independently represent a hydrogen atom, an alkyl group having 1 to 20 carbon atoms, an aryl group having 6 to 30 carbon atoms, an aryl alkyl group having 7 to 30 carbon atoms, or a heterocyclic group having 4 to 20 carbon atoms, and X represents a direct bond or a carbonyl group.

In Formula (2), $R^1$, $R^2$, $R^3$, and $R^4$ have the same definition as $R^1$, $R^2$, $R^3$, and $R^4$ in Formula (1), $R^5$ represents $-R^6$, $-OR^6$, $-SR^6$, $-COR^6$, $-CONR^6R^6$, $-NR^6COR^6$, $-OCOR^6$, $-COOR^6$, $-SCOR^6$, $-OCSR^6$, $-COSR^6$, $-CSOR^6$, -CN, a halogen atom, or a hydroxyl group, $R^6$ represents an alkyl group having 1 to 20 carbon atoms, an aryl group having 6 to 30 carbon atoms, an aryl alkyl group having 7 to 30 carbon atoms, or a heterocyclic group having 4 to 20 carbon atoms, X represents a direct bond or a carbonyl group, and a represents an integer of 0 to 4.

In Formula (3), $R^1$ represents an alkyl group having 1 to 20 carbon atoms, an alicyclic hydrocarbon group having 4 to 20 carbon atoms, an aryl group having 6 to 30 carbon atoms, or an aryl alkyl group having 7 to 30 carbon atoms, $R^3$ and $R^4$ each independently represent a hydrogen atom, an alkyl group having 1 to 20 carbon atoms, an aryl group having 6 to 30 carbon atoms, an aryl alkyl group having 7 to 30 carbon atoms, or a heterocyclic group having 4 to 20 carbon atoms, and X represents a direct bond or a carbonyl group.

In Formula (4), $R^1$, $R^3$, and $R^4$ have the same definition as $R^1$, $R^3$, and $R^4$ in Formula (3), $R^5$ represents $-R^6$, $-OR^6$, $-SR^6$, $-COR^6$, $-CONR^6R^6$, $-NR^6COR^6$, $-OCOR^6$, $-COOR^6$, $-SCOR^6$, $-OCSR^6$, $-COSR^6$, $-CSOR^6$, -CN, a halogen atom, or a hydroxyl group, $R^6$ represents an alkyl group having 1 to 20 carbon atoms, an aryl group having 6 to 30 carbon atoms, an aryl alkyl group having 7 to 30 carbon atoms, or a heterocyclic group having 4 to 20 carbon atoms, X represents a direct bond or a carbonyl group, and a represents an integer of 0 to 4.

In Formulae (1) and (2), $R^1$ and $R^2$ are preferably each independently a methyl group, an ethyl group, an n-propyl group, an i-propyl group, a cyclohexyl group, or a phenyl group. $R^3$ is preferably a methyl group, an ethyl group, a phenyl group, a tolyl group, or a xylyl group. $R^4$ is preferably an alkyl group having 1 to 6 carbon atoms or a phenyl group. $R^5$ is preferably a methyl group, an ethyl group, a phenyl group, a tolyl group, or a naphthyl group. X is preferably a direct bond.

Furthermore, in Formula (3) and Formula (4), $R^1$'s are preferably each independently a methyl group, an ethyl group, an n-propyl group, an i-propyl group, a cyclohexyl group, or a phenyl group. $R^3$ is preferably a methyl group, an ethyl group, a phenyl group, a tolyl group, or a xylyl group. $R^4$ is preferably an alkyl group having 1 to 6 carbon atoms or a phenyl group. $R^5$ is preferably a methyl group, an ethyl group, a phenyl group, a tolyl group, or a naphthyl group. X is preferably a direct bond.

Specific examples of the compounds represented by Formula (1) and Formula (2) include the compound described in paragraphs 0076 to 0079 in JP2014-137466A. The contents of the above document are incorporated into the present specification.

Specific examples of oxime compounds preferably used in the curable composition are shown below. Moreover, as the oxime compounds, the compounds described in Table 1 in WO2015/036910A can also be used, and the contents thereof are incorporated into the present specification.

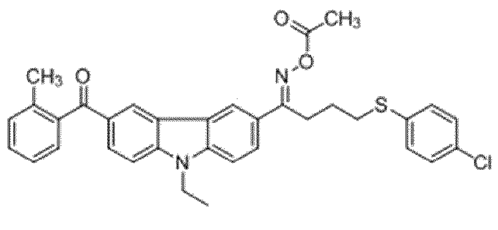

(C-1)

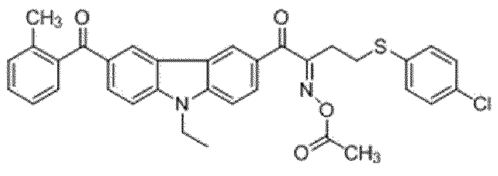

(C-2)

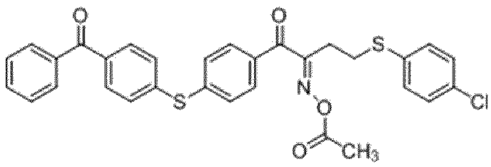

(C-3)

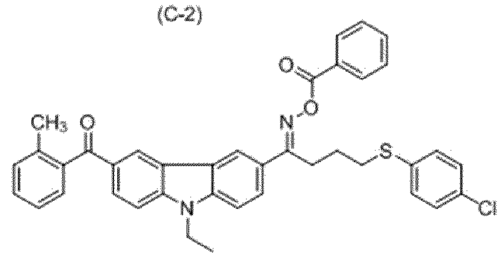

(C-4)

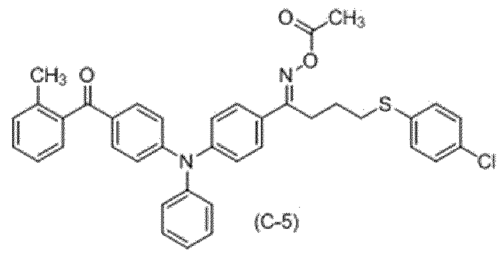

(C-5)

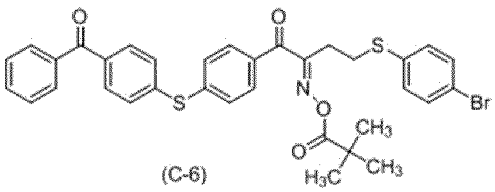

(C-6)

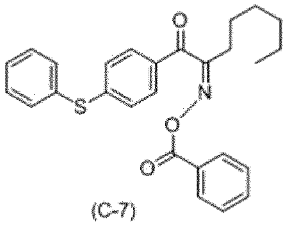

(C-7)

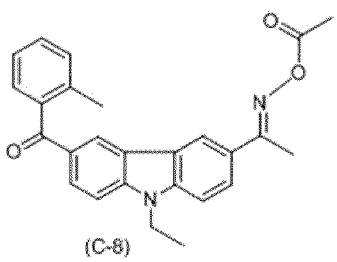

(C-8)

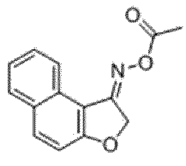

(C-9)

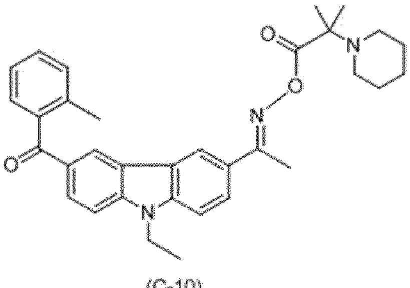

(C-10)

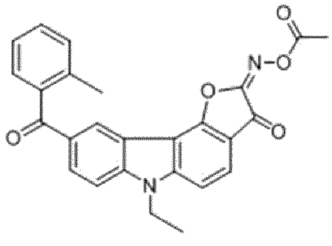

(C-11)

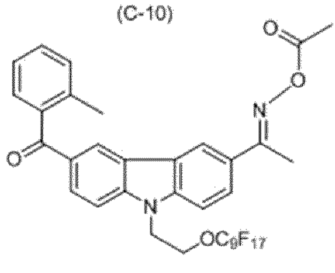

(C-12)

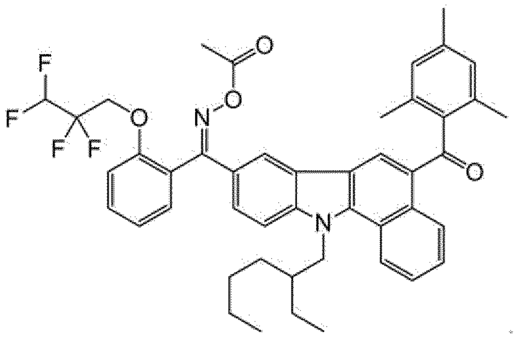

(C-13)

In addition, as the photopolymerization initiator, the compounds described in paragraph 0052 in JP2008-260927A, paragraphs 0033 to 0037 in JP2010-097210A, and paragraph 0044 in JP2015-068893A can also be used, and the contents thereof are incorporated into the present specification.

If necessary, two or more kinds of photopolymerization initiators may be used in combination.

In a case where the method B is used, it is also preferable that a photopolymerization initiator (hereinafter, referred to as a "specific initiator" as well) which does not exhibit photosensitivity at a wavelength of 365 nm is used.

The expression of "not exhibit photosensitivity at a wavelength of 365 nm" means that a light absorption coefficient at a wavelength of 365 nm is $1.0 \times 10^2$ mL/(g·cm) or less.

The specific initiator is preferably a photopolymerization initiator in which a maximum value of the light absorption coefficient at a wavelength of 330 to 500 nm is $1.0 \times 10^2$ mL/(g·cm) or less and a maximum value of the light absorption coefficient at a wavelength of 200 to 315 nm is $1.0 \times 10^3$ mL/(g·cm) or greater.

For example, in a case where a curable composition contains both a photopolymerization initiator other than the specific initiator and the specific initiator, even after a curable composition layer formed of such a curable composition is exposed to a light (for example, i-line) having a wavelength of 330 to 500 nm, the specific initiator in the curable composition layer is likely to remain without being decomposed. Therefore, thereafter, in a case where the developed curable composition layer is irradiated with ultraviolet rays (preferably, light different from the light used during exposure, and for example, light having a wavelength of 200 to 315 nm is preferably included), post-curing progresses more effectively, and a cured film having superior sustenance-defect suppressibility can be obtained.

Examples of the specific initiator include CIBA IRGACURE 2959 (trade name). In a case where irradiation with specific ultraviolet rays is performed, the curable composition layer is preferably a material which is cured at a wavelength of 315 nm or less. The lower limit value of the wavelength is not particularly limited, but is generally 200 nm or greater.

The content of the photopolymerization initiator in the curable composition is not particularly limited, but is preferably 0.5% to 20% by mass with respect to the total solid content of the curable composition. One kind of photopolymerization initiator may be used singly, or two or more kinds thereof may be used. In a case where two or more kinds of photopolymerization initiators are used, the total content thereof is preferably within the above range.

Furthermore, in a case where both a photopolymerization initiator other than the specific initiator and the specific initiator are included as the photopolymerization initiator, a content of the photopolymerization initiator other than the specific initiator is preferably 0.5% to 15% by mass with respect to the total solid content of the curable composition, and a content of the specific initiator is preferably 0.5% to 15% by mass with respect to the total solid content of the curable composition.

In a case where a plurality of kinds of the photopolymerization initiators other than the specific initiator and/or a plurality of kinds of the specific initiators are used, the total contents thereof are preferably within the preferred content ranges of the photopolymerization initiator other than the specific initiator and the specific initiator, respectively.

In addition, the curable composition may further contain a thermal polymerization initiator in addition to the photopolymerization initiator.

<Resin>

It is preferable that the curable composition contains a resin. Examples of the resin include a dispersant and an alkali-soluble resin.

A content of the resin in the curable composition is not particularly limited, but is preferably 3% to 60% by mass and more preferably 5% to 40% by mass with respect to the total solid content of the curable composition. One kind of resin may be used singly, or two or more kinds thereof may be used in combination. In a case where two or more kinds of resins are used in combination, the total content thereof is preferably within the above range.

A molecular weight of the resin is preferably greater than 2,000. Moreover, in a case where the molecular weight of the resin is polydisperse, a weight-average molecular weight is preferably greater than 2,000.

(Dispersant)

It is preferable that the curable composition contains a dispersant. Furthermore, in the present specification, the dispersant is a compound which is mainly used for dispersing a pigment in a curable composition, and means a compound which is different from an alkali-soluble resin described later.
A content of the dispersant in the curable composition is not particularly limited, but is preferably 2% to 40% by mass and more preferably 5% to 30% by mass with respect to the total solid content of the curable composition.
One kind of dispersant may be used singly, or two or more kinds thereof may be used in combination. In a case where two or more kinds of dispersants are used in combination, the total content thereof is preferably within the above range.
As the dispersant, for example, known dispersants can be appropriately selected and used. Among them, a polymer compound is preferable.
Examples of the dispersant include a polymer dispersant [for example, polyamide amine and a salt thereof, polycarboxylic acid and a salt thereof, a high-molecular-weight unsaturated acid ester, modified polyurethane, modified polyester, modified poly(meth)acrylate, a (meth)acrylic copolymer, and a naphthalenesulfonic acid formalin condensate], polyoxyethylene alkyl phosphoric acid ester, polyoxyethylene alkyl amine, and a pigment derivative.
The polymer compound can be further classified into a linear polymer, a terminal-modified polymer, a graft polymer, and a block polymer based on the structure.

Polymer compound

The polymer compound functions to prevent the reaggregation of the substance to be dispersed by being adsorbed onto the surface of the substance to be dispersed, such as the pigment, as described above. Therefore, a terminal-modified polymer, a graft polymer (containing a polymer chain), or a block polymer is preferable which contains a moiety anchored to the surface of the pigment.
The polymer compound may contain a curable group.
Examples of the curable group include an ethylenically unsaturated group (for example, a (meth)acryloyl group, a vinyl group, a styryl group, and the like), and a cyclic ether group (for example, an epoxy group, an oxetanyl group, and the like).
Among them, from the viewpoint that polymerization can be controlled by a radical reaction, an ethylenically unsaturated group is preferable as the curable group. As the ethylenically unsaturated group, a (meth)acryloyl group is more preferable.
There is no limitation on an aspect in which the polymer compound has the curable group, but it is preferable that a side chain of a repeating unit constituting the polymer compound contains a curable group. Moreover, in a case where the repeating unit has a graft chain described later, the graft chain may contain a curable group. For example, the curable group may be present at a terminal of the graft chain, or the curable group may be present at a place (for example, in a chain of the graft chain, a substituent included in the graft chain, and the like) other than the terminal of the graft chain.
In a case where the polymer compound contains the ethylenically unsaturated group, a content of the ethylenically unsaturated group is not particularly limited, but is preferably 0.001 to 8.00 mmol/g, more preferably 0.10 to 3.00 mmol/g, and even more preferably 0.20 to 2.50 mmol/g.
In a case where the ethylenically unsaturated group is a (meth)acryloyl group, the content of the ethylenically unsaturated group in the polymer compound contained in the curable composition can be measured, for example, by the following method.
First, solid components (black pigment or the like) in a curable composition are precipitated by a centrifugal separation method, and remaining liquid components are collected. Moreover, a component having a weight-average molecular weight of greater than 2,000 is collected from the obtained liquid components by the GPC method, and the component is used as a resin (polymer compound) to be measured.
Furthermore, the obtained resin is analyzed using a nuclear magnetic resonance (NMR) method and a GPC method to specify a structure and a content of the ethylenically unsaturated group.
It is preferable that the resin containing a curable group has at least one kind of structure selected from the group consisting of a polyester structure and a polyether structure. In this case, the polyester structure and/or the polyether structure may be included in a main chain, and in a case where the resin contains a structural unit containing a graft chain as described later, the polymer chain may have the polyester structure and/or the polyether structure.
For the resin, it is more preferable that the polymer chain has the polyester structure.

It is preferable that the polymer compound contains a structural unit containing a graft chain. Moreover, in the present specification, a "structural unit" has the same definition as a "repeating unit".

Since the polymer compound which contains such a structural unit containing a graft chain exhibits affinity with a solvent due to the graft chain, the dispersibility of the pigment or the like and the dispersion stability (temporal stability) after the lapse of time are excellent. Moreover, due to the presence of the graft chain, the polymer compound which contains the structural unit containing the graft chain exhibits affinity with the polymerizable compound or other resins which can be used in combination. As a result, a residue is less likely to be generated in alkali development.

In a case where the graft chain is long, a steric repulsion effect is enhanced and the dispersibility of the pigment or the like is improved. On the other hand, in a case where the graft chain is too long, the adsorptivity to the pigment or the like is reduced, and the dispersibility of the pigment or the like tends to be reduced. Therefore, the number of atoms excluding hydrogen atoms in the graft chain is preferably 40 to 10,000, more preferably 50 to 2,000, and even more preferably 60 to 500.

Here, the graft chain refers to a portion from the base of a main chain of a copolymer (an atom bonded to the main chain in a group which is branched off from the main chain) to the terminal of a group branched off from the main chain.

The graft chain preferably has a polymer structure, and examples of such a polymer structure include a poly(meth)acrylate structure (for example, a poly(meth)acryl structure), a polyester structure, a polyurethane structure, a polyurea structure, a polyamide structure, and a polyether structure.

In order to improve interaction properties between the graft chain and the solvent and thereby enhance the dispersibility of the pigment or the like, the graft chain is preferably a graft chain having at least one kind of structure selected from the group consisting of a polyester structure, a polyether structure, and a poly(meth)acrylate structure, and more preferably a graft chain having at least one of a polyester structure or a polyether structure.

A macromonomer (a monomer which has a polymer structure and is bonded to a main chain of a copolymer to form a graft chain) containing such a graft chain is not particularly limited, but a macromonomer containing a reactive double-bond group can be suitably used.

As a commercially available macromonomer which corresponds to the structural unit containing the graft chain contained in the polymer compound and is suitably used for synthesizing the polymer compound, AA-6 (trade name, manufactured by TOAGOSEI CO., LTD.), AA-10 (trade name, manufactured by TOAGOSEI CO., LTD.), AB-6 (trade name, manufactured by TOAGOSEI CO., LTD.), AS-6 (trade name, manufactured by TOAGOSEI CO., LTD.), AN-6 (trade name, manufactured by TOAGOSEI CO., LTD.), AW-6 (trade name, manufactured by TOAGOSEI CO., LTD.), AA-714 (trade name, manufactured by TOAGOSEI CO., LTD.), AY-707 (trade name, manufactured by TOAGOSEI CO., LTD.), AY-714 (trade name, manufactured by TOAGOSEI CO., LTD.), AK-5 (trade name, manufactured by TOAGOSEI CO., LTD.), AK-30 (trade name, manufactured by TOAGOSEI CO., LTD.), AK-32 (trade name, manufactured by TOAGOSEI CO., LTD.), BLEMMER PP-100 (trade name, manufactured by NOF CORPORATION), BLEMMER PP-500 (trade name, manufactured by NOF CORPORATION), BLEMMER PP-800 (trade name, manufactured by NOF CORPORATION), BLEMMER PP-1000 (trade name, manufactured by NOF CORPORATION), BLEMMER 55-PET-800 (trade name, manufactured by NOF CORPORATION), BLEMMER PME-4000 (trade name, manufactured by NOF CORPORATION), BLEMMER PSE-400 (trade name, manufactured by NOF CORPORATION), BLEMMER PSE-1300 (trade name, manufactured by NOF CORPORATION), BLEMMER 43PAPE-600B, or the like is used. Among them, AA-6 (trade name, manufactured by TOAGOSEI CO., LTD.), AA-10 (trade name, manufactured by TOAGOSEI CO., LTD.), AB-6 (trade name, manufactured by TOAGOSEI CO., LTD.), AS-6 (trade name, manufactured by TOAGOSEI CO., LTD.), AN-6 (trade name, manufactured by TOAGOSEI CO., LTD.), or BLEMMER PME-4000 (trade name, manufactured by NOF CORPORATION) is preferable.

The dispersant preferably contains at least one kind of structure selected from the group consisting of polymethyl acrylate, polymethyl methacrylate, and cyclic or chain-like polyester, more preferably contains at least one kind of structure selected from the group consisting of polymethyl acrylate, polymethyl methacrylate, and chain-like polyester, and even more preferably contains at least one kind of structure selected from the group consisting of a polymethyl acrylate structure, a polymethyl methacrylate structure, a polycaprolactone structure, and a polyvalerolactone structure. The dispersant may be a dispersant containing the above structure alone in one dispersant, or may be a dispersant containing a plurality of these structures in one dispersant.

Here, the polycaprolactone structure refers to a structure having a structure, which is obtained by ring opening of ε-caprolactone, as a repeating unit. The polyvalerolactone structure refers to a structure having a structure, which is obtained by ring opening of δ-valerolactone, as a repeating unit.

Specific examples of the dispersant having a polycaprolactone structure include a dispersant in which j and k in Formulae (1) and (2) are each 5. Moreover, specific examples of the dispersant having a polyvalerolactone structure include a dispersant in which j and k in Formulae (1) and (2) are each 4.

Specific examples of the dispersant having a polymethyl acrylate structure include a dispersant in which in Formula (4), $X^5$ is a hydrogen atom and $R^4$ is a methyl group. Moreover, specific examples of the dispersant having a polymethyl methacrylate structure include a dispersant in which in Formula (4), $X^5$ is a methyl group and $R^4$ is a methyl

group.

•Structural unit containing graft chain

The polymer compound preferably contains a structural unit represented by any one of Formula (1), ..., or (4) and more preferably contains a structural unit represented by any one of Formula (1A), Formula (2A), Formula (3A), Formula (3B), or Formula (4), as a structural unit containing a graft chain.

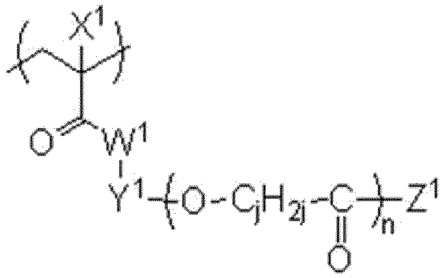
(1)

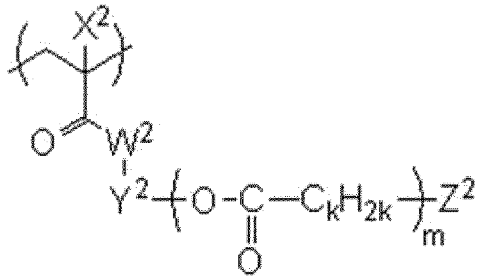
(2)

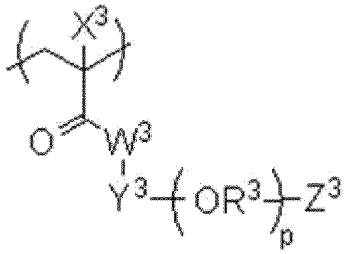
(3)

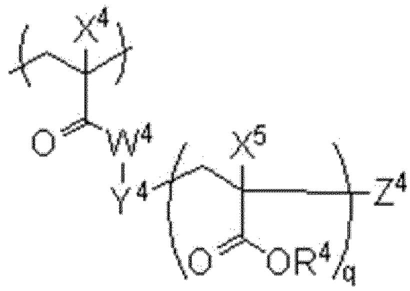
(4)

In Formulae (1) to (4), $W^1$, $W^2$, $W^3$, and $W^4$ each independently represent an oxygen atom or NH. $W^1$, $W^2$, $W^3$, and $W^4$ are preferably oxygen atoms.

In Formulae (1) to (4), $X^1$, $X^2$, $X^3$, $X^4$, and $X^5$ each independently represent a hydrogen atom or a monovalent organic group. From the viewpoint of constraint on synthesis, $X^1$, $X^2$, $X^3$, $X^4$, and $X^5$ are preferably each independently a hydrogen atom or an alkyl group having 1 to 12 carbon atoms (the number of carbon atoms), more preferably each independently a hydrogen atom or a methyl group, and even more preferably methyl groups.

In Formulae (1) to (4), $Y^1$, $Y^2$, $Y^3$, and $Y^4$ each independently represent a divalent linking group, and the linking group is not particularly limited in structure. Specific examples of the divalent linking group represented by $Y^1$, $Y^2$, $Y^3$, and $Y^4$ include linking groups represented by (Y-1) to (Y-21). In the structures shown below, A and B each mean a bonding site in Formulae (1) to (4). Among the structures shown below, from the viewpoint of ease of synthesis, (Y-2) or (Y-13) is more preferable.

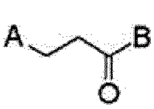
(Y-1)

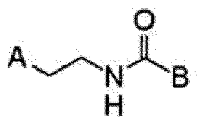
(Y-2)

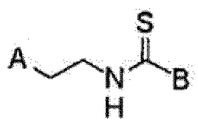
(Y-3)

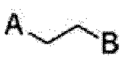
(Y-4)

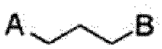
(Y-5)

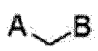
(Y-6)

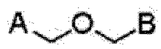
(Y-7)

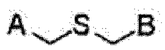
(Y-8)

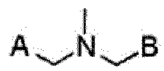
(Y-9)

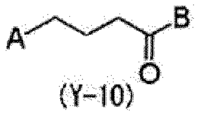
(Y-10)

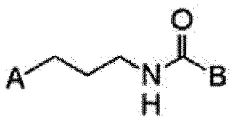
(Y-11)

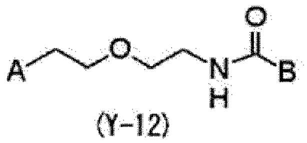
(Y-12)

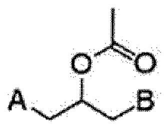
(Y-13)

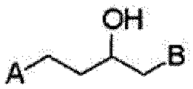
(Y-14)

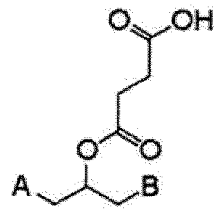
(Y-15)

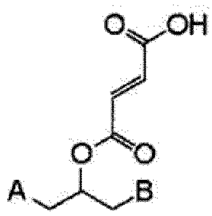
(Y-16)

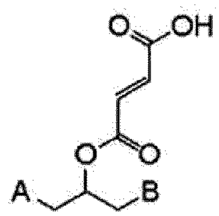
(Y-17)

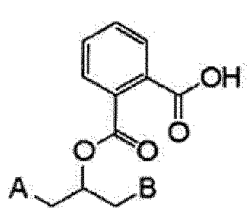
(Y-18)

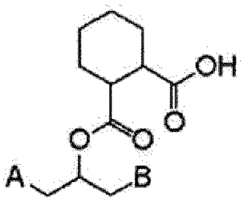
(Y-19)

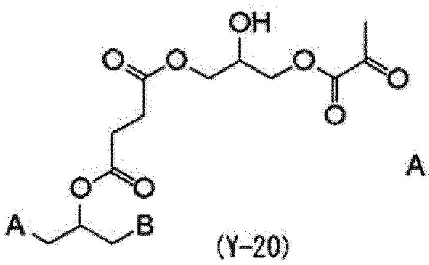
(Y-20)

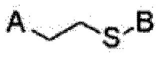
(Y-21)

In Formulae (1) to (4), $Z^1$, $Z^2$, $Z^3$, and $Z^4$ each independently represent a monovalent organic group. A structure of the organic group is not particularly limited, but specific examples thereof include an alkyl group, a hydroxyl group, an alkoxy group, an aryloxy group, a heteroaryloxy group, an alkylthioether group, an arylthioether group, a heteroarylthioether group, an amino group, and a group having a curable group. Among them, in particular, from the viewpoint of improvement in the dispersibility, the organic groups represented by $Z^1$, $Z^2$, $Z^3$, and $Z^4$ are preferably groups exhibiting a steric repulsion effect, more preferably each independently an alkyl group having 5 to 24 carbon atoms or an alkoxy group, and among them, in particular, and even more preferably each independently a branched alkyl group having 5 to 24 carbon atoms, a cyclic alkyl group having 5 to 24 carbon atoms, or an alkoxy group having 5 to 24 carbon atoms. Furthermore, the alkyl group included in the alkoxy group may be any one of linear, branched, or cyclic.

In Formulae (1) to (4), n, m, p, and q are each independently an integer of 1 to 500.

Moreover, in Formulae (1) and (2), j and k each independently represent an integer of 2 to 8. From the viewpoint of the temporal stability and the developability of the composition, j and k in Formulae (1) and (2) are each preferably an integer of 4 to 6 and more preferably 5.

Furthermore, in Formulae (1) and (2), n and m are each preferably an integer of 10 or greater and more preferably an integer of 20 or greater. In addition, in a case where the dispersant has a polycaprolactone structure and a polyvalerolactone structure, the sum of the number of repetitions of the polycaprolactone structure and the number of repetitions of the polyvalerolactone structure is preferably an integer of 10 or greater and more preferably an integer of 20 or greater.

In Formula (3), $R^3$ represents a branched or linear alkylene group, and is preferably an alkylene group having 1 to 10 carbon atoms and more preferably an alkylene group having 2 or 3 carbon atoms. In a case where p is 2 to 500, a plurality of $R^3$'s may be the same as or different from each other.

In Formula (4), $R^4$ represents a hydrogen atom or a monovalent organic group, and the monovalent organic group is not particularly limited in structure. As $R^4$, a hydrogen atom, an alkyl group, an aryl group, or a heteroaryl group is preferable, and a hydrogen atom or an alkyl group is more preferable. In a case where $R^4$ is an alkyl group, the alkyl group is preferably a linear alkyl group having 1 to 20 carbon atoms, a branched alkyl group having 3 to 20 carbon atoms, or a cyclic alkyl group having 5 to 20 carbon atoms, more preferably a linear alkyl group having 1 to 20 carbon atoms, and even more preferably a linear alkyl group having 1 to 6 carbon atoms. In Formula (4), in a case where q is 2 to 500, a plurality of $X^5$'s and a plurality of $R^4$'s in a graft copolymer may be the same as or different from each other.

In addition, the polymer compound may contain two or more kinds of structural units having different structures and containing a graft chain. That is, structural units represented by Formulae (1) to (4), which have different structures, may be contained in a molecule of the polymer compound, and in a case where, in Formulae (1) to (4), n, m, p, and q each represent an integer of 2 or greater, in Formulae (1) and (2), a structure in which j's and k's are different from each other may be included in the side chain, and in Formulae (3) and (4), a plurality of $R^3$'s, a plurality of $R^4$'s, and a plurality of $X^5$'s in the molecule may be the same as or different from each other.

From the viewpoint of the temporal stability and the developability of the composition, the structural unit represented by Formula (1) is more preferably a structural unit represented by Formula (1A).

Furthermore, from the viewpoint of the temporal stability and the developability of the composition, the structural unit represented by Formula (2) is more preferably a structural unit represented by Formula (2A).

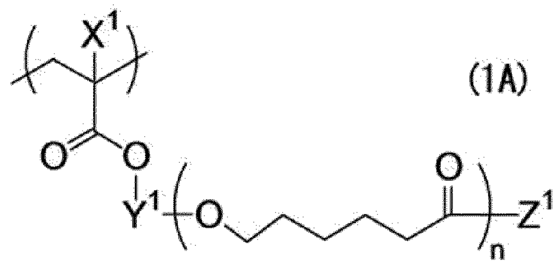

(1A)

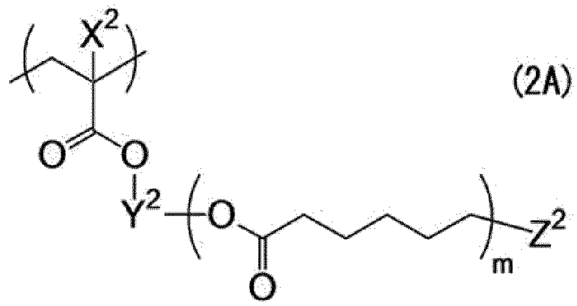

(2A)

$X^1$, $Y^1$, $Z^1$, and n in Formula (1A) have the same definition as $X^1$, $Y^1$, $Z^1$, and n in Formula (1), and preferred ranges thereof are also the same. $X^2$, $Y^2$, $Z^2$, and m in Formula (2A) have the same definition as $X^2$, $Y^2$, $Z^2$, and m in Formula (2), and preferred ranges thereof are also the same.

In addition, from the viewpoint of the temporal stability and the developability of the composition, the structural unit represented by Formula (3) is more preferably a structural unit represented by Formula (3A) or (3B).

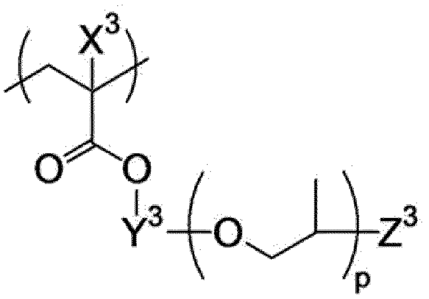

(3A)

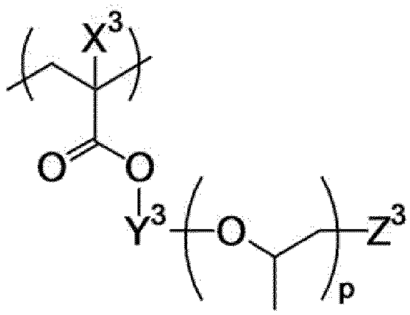

(3B)

$X^3$, $Y^3$, $Z^3$, and p in Formula (3A) or (3B) have the same definition as $X^3$, $Y^3$, $Z^3$, and p in Formula (3), and preferred ranges thereof are also the same.

It is more preferable that the polymer compound contains a structural unit represented by Formula (1A) as the structural unit containing a graft chain.

In the polymer compound, the structural unit (for example, structural units represented by Formulae (1) to (4)) containing a graft chain is contained preferably in a range of 2% to 90% by mass and more preferably in a range of 5% to 30% by mass, in terms of mass, with respect to the total mass of the polymer compound. In a case where the structural unit containing a graft chain is contained within the above range, the dispersibility of the pigment is enhanced and developability in formation of the cured film is favorable.

It is preferable that the polymer compound contains both a repeating unit having a graft chain and a repeating unit having a curable group (the curable group is preferably included on the side chain, and the curable group is preferably an ethylenically unsaturated group).

•Hydrophobic structural unit

In addition, it is preferable t^#^hat the polymer compound contains a hydrophobic structural unit different from the structural unit containing a graft chain (that is, a hydrophobic structural unit which does not correspond to the structural unit containing a graft chain). However, in the present specification, the hydrophobic structural unit is a structural unit which does not have an acid group (for example, a carboxylic acid group, a sulfonic acid group, a phosphoric acid group, a phenolic hydroxyl group, or the like).

As the hydrophobic structural unit, a structural unit derived from (corresponding to) a compound (monomer) having a ClogP value of 1.2 or greater is preferable, and a structural unit derived from a compound having a ClogP value of 1.2 to 8 is more preferable. In this way, the effects of the present invention can be exhibited more reliably.

The ClogP value is a value calculated by a program "CLOGP" available from Daylight Chemical Information System, Inc. This program provides a value of "calculated logP" calculated by the fragment approach (see the following documents) of Hansch and Leo. The fragment approach is based on the chemical structure of a compound, and in this method, the chemical structure is divided into partial structures (fragments), and degrees of contribution to logP that are assigned to the fragments are summed up, thereby estimating the logP value of the compound. Details of the method are described in the following documents. In the present specification, a ClogP value calculated by a program CLOGP v 4.82 is used.

A. J. Leo, Comprehensive Medicinal Chemistry, Vol. 4, C. Hansch, P. G. Sammnens, J. B. Taylor and C. A. Ramsden, Eds., p. 295, Pergamon press, 1990 C. Hansch & A. J. Leo. Substituent Constants For Correlation Analysis in Chemistry and Biology. John Wiley & Sons. A. J. Leo. Calculating logPoct from structure. Chem. Rev., 93, 1281 to 1306, 1993.

logP means a common logarithm of a partition coefficient P, is a value of physical properties that shows how a certain organic compound is partitioned in an equilibrium of two-phase system consisting of oil (generally, 1-octanol) and water by using a quantitative numerical value, and is represented by the following expression.

$$\log P = \log(Coil/Cwater)$$

In the expression, Coil represents a molar concentration of a compound in an oil phase, and Cwater represents a molar concentration of the compound in a water phase.

The greater the positive logP value based on 0, the higher the oil solubility, and the greater the absolute value of negative logP, the higher the water solubility. The value of logP is negatively correlated with the water solubility of an organic compound, and widely used as a parameter for estimating the hydrophilicity and hydrophobicity of an organic compound.

It is preferable that the polymer compound contains one or more kinds of structural units selected from structural units derived from monomers represented by Formulae (i) to (iii) as the hydrophobic structural unit.

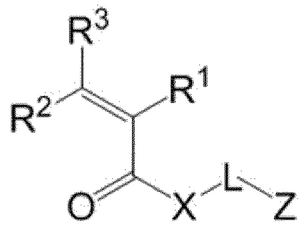

(i)

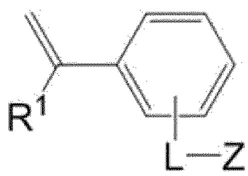

(ii)

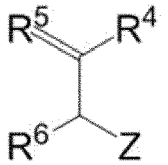

(iii)

In Formulae (i) to (iii), $R^1$, $R^2$, and $R^3$ each independently represent a hydrogen atom, a halogen atom (for example, a fluorine atom, a chlorine atom, a bromine atom, and the like), or an alkyl group (for example, a methyl group, an ethyl group, a propyl group, and the like) having 1 to 6 carbon atoms.

$R^1$, $R^2$, and $R^3$ are each preferably a hydrogen atom or an alkyl group having 1 to 3 carbon atoms and more preferably a hydrogen atom or a methyl group. $R^2$ and $R^3$ are even more preferably hydrogen atoms.

X represents an oxygen atom (-O-) or an imino group (-NH-), and is preferably an oxygen atom.

L is a single bond or a divalent linking group. Examples of the divalent linking group include a divalent aliphatic group (for example, an alkylene group, a substituted alkylene group, an alkenylene group, a substituted alkenylene group, an alkynylene group, and a substituted alkynylene group), a divalent aromatic group (for example, an arylene group and a substituted arylene group), a divalent heterocyclic group, an oxygen atom (-O-), a sulfur atom (-S-), an imino group (-NH-), a substituted imino group (-$NR^{31}$-, where $R^{31}$ is an aliphatic group, an aromatic group, or a heterocyclic group), a carbonyl group (-CO-), and a combination thereof.

The divalent aliphatic group may have a cyclic structure or a branched structure. The number of carbon atoms in the aliphatic group is preferably 1 to 20, more preferably 1 to 15, and even more preferably 1 to 10. The aliphatic group may be an unsaturated aliphatic group or a saturated aliphatic group, but a saturated aliphatic group is preferable. Moreover, the aliphatic group may have a substituent. Examples of the substituent include a halogen atom, an aromatic group, and a heterocyclic group.

The number of carbon atoms in the divalent aromatic group is preferably 6 to 20, more preferably 6 to 15, and even more preferably 6 to 10. Moreover, the aromatic group may have a substituent. Examples of the substituent include a halogen atom, an aliphatic group, an aromatic group, and a heterocyclic group.

It is preferable that the divalent heterocyclic group contains a 5-membered ring or a 6-membered ring as a heterocycle. Another heterocycle, an aliphatic ring, or an aromatic ring may be fused with the heterocycle. Moreover, the heterocyclic group may have a substituent. Examples of the substituent include a halogen atom, a hydroxyl group, an oxo group (=O), a thioxo group (=S), an imino group (=NH), a substituted imino group (=N-$R^{32}$, where $R^{32}$ is an aliphatic group, an aromatic group, or a heterocyclic group), an aliphatic group, an aromatic group, and a heterocyclic group.

L is preferably a single bond, an alkylene group, or a divalent linking group having an oxyalkylene structure. The oxyalkylene structure is more preferably an oxyethylene structure or an oxypropylene structure. Moreover, L may

have a polyoxyalkylene structure including two or more oxyalkylene structures repeatedly. The polyoxyalkylene structure is preferably a polyoxyethylene structure or a polyoxypropylene structure. The polyoxyethylene structure is represented by $-(OCH_2CH_2)_n-$, and n is preferably an integer of 2 or greater and more preferably an integer of 2 to 10.

Examples of Z include an aliphatic group (for example, an alkyl group, a substituted alkyl group, an unsaturated alkyl group, and a substituted unsaturated alkyl group), an aromatic group (for example, an aryl group, a substituted aryl group, an arylene group, and a substituted arylene group), a heterocyclic group, and a combination thereof. An oxygen atom (-O-), a sulfur atom (-S-), an imino group (-NH-), a substituted imino group ($-NR^{31}-$, where $R^{31}$ is an aliphatic group, an aromatic group, or a heterocyclic group), or a carbonyl group (-CO-) may be contained in these groups.

The aliphatic group may have a cyclic structure or a branched structure. The number of carbon atoms in the aliphatic group is preferably 1 to 20, more preferably 1 to 15, and even more preferably 1 to 10. The aliphatic group further includes a ring-aggregated hydrocarbon group or a crosslinked cyclic hydrocarbon group, and examples of the ring-aggregated hydrocarbon group include a bicyclohexyl group, a perhydronaphthalenyl group, a biphenyl group, and a 4-cyclohexylphenyl group. Examples of a crosslinked cyclic hydrocarbon ring include a bicyclic hydrocarbon ring such as pinane, bornane, norpinane, norbornane, and a bicyclooctane ring (a bicyclo[2.2.2]octane ring, a bicyclo[3.2.1]octane ring, and the like), a tricyclic hydrocarbon ring such as homobredane, adamantane, tricyclo[$5.2.1.0^{2,6}$]decane, and a tricyclo[$4.3.1.1^{2,5}$]undecane ring, and a tetracyclic hydrocarbon ring such as tetracyclo[$4.4.0.1^{2,5}.1^{7,10}$]dodecane and a perhydro-1,4-methano-5,8-methanonaphthalene ring. Moreover, as the crosslinked cyclic hydrocarbon ring, a fused cyclic hydrocarbon ring, for example, a fused ring obtained by fusing a plurality of 5- to 8-membered cycloalkane rings such as perhydronaphthalene (decalin), perhydroanthracene, perhydrophenanthrene, perhydroacenaphthene, perhydrofluorene, perhydroindene, and perhydrophenalene rings is also included.

As the aliphatic group, a saturated aliphatic group is preferred to an unsaturated aliphatic group. Moreover, the aliphatic group may have a substituent. Examples of the substituent include a halogen atom, an aromatic group, and a heterocyclic group. Here, the aliphatic group does not have an acid group as a substituent.

The number of carbon atoms in the aromatic group is preferably 6 to 20, more preferably 6 to 15, and even more preferably 6 to 10. Moreover, the aromatic group may have a substituent. Examples of the substituent include a halogen atom, an aliphatic group, an aromatic group, and a heterocyclic group. Here, the aromatic group does not have an acid group as a substituent.

It is preferable that the heterocyclic group contains a 5-membered ring or a 6-membered ring as a heterocycle. Another heterocycle, an aliphatic ring, or an aromatic ring may be fused with the heterocycle. Moreover, the heterocyclic group may have a substituent. Examples of the substituent include a halogen atom, a hydroxyl group, an oxo group (=O), a thioxo group (=S), an imino group (=NH), a substituted imino group ($=N-R^{32}$, where $R^{32}$ is an aliphatic group, an aromatic group, or a heterocyclic group), an aliphatic group, an aromatic group, and a heterocyclic group. Here, the heterocyclic group does not have an acid group as a substituent.

In Formula (iii), $R^4$, $R^5$, and $R^6$ each independently represent a hydrogen atom, a halogen atom (for example, a fluorine atom, a chlorine atom, a bromine atom, and the like), an alkyl group (for example, a methyl group, an ethyl group, a propyl group, and the like) having 1 to 6 carbon atoms, Z, or L-Z. Here, L and Z have the same definition as those described above. $R^4$, $R^5$, and $R^6$ are each preferably a hydrogen atom or an alkyl group having 1 to 3 carbon atoms and more preferably hydrogen atoms.

The monomer represented by Formula (i) is preferably a compound in which $R^1$, $R^2$, and $R^3$ are each a hydrogen atom or a methyl group, L is a single bond, an alkylene group, or a divalent linking group having an oxyalkylene structure, X is an oxygen atom or an imino group, and Z is an aliphatic group, a heterocyclic group, or an aromatic group.

Furthermore, the monomer represented by Formula (ii) is preferably a compound in which $R^1$ is a hydrogen atom or a methyl group, L is an alkylene group, and Z is an aliphatic group, a heterocyclic group, or an aromatic group. Moreover, the monomer represented by Formula (iii) is preferably a compound in which $R^4$, $R^5$, and $R^6$ are each a hydrogen atom or a methyl group, and Z is an aliphatic group, a heterocyclic group, or an aromatic group.

Examples of typical compounds represented by Formulae (i) to (iii) include a radically polymerizable compound selected from acrylic acid esters, methacrylic acid esters, and styrenes.

Furthermore, regarding examples of the typical compounds represented by Formulae (i) to (iii), reference can be made to the compounds described in paragraphs 0089 to 0093 in JP2013-249417A, the contents of which are incorporated into the present specification.

In the polymer compound, the hydrophobic structural unit is contained preferably in a range of 10% to 90% by mass and more preferably in a range of 20% to 80% by mass, in terms of mass, with respect to the total mass of the polymer compound. In a case where the content is in the above range, sufficient pattern formation is possible.

•Functional groups capable of interacting with pigment or the like

The polymer compound can introduce a functional group capable of interacting with a pigment or the like. Here, it is preferable that the polymer compound further contains a structural unit which contains a functional group capable

of interacting with a pigment or the like.

Examples of the functional group capable of interacting with a pigment or the like include an acid group, a basic group, a coordinating group, and a reactive functional group.

In a case where the polymer compound contains an acid group, a basic group, a coordinating group, or a reactive functional group, it is preferable that the polymer compound contains each of a structural unit containing an acid group, a structural unit containing a basic group, a structural unit containing a coordinating group, or a reactive structural unit.

In particular, in a case where the polymer compound further contains an alkali-soluble group such as a carboxylic acid group as an acid group, developability for pattern formation by alkali development can be imparted to the polymer compound.

That is, by introducing an alkali-soluble group into the polymer compound, in the above composition, the polymer compound as a dispersant which contributes to the dispersion of the pigment or the like has alkali-solubility. The composition containing such a polymer compound exhibits excellent light blocking properties in an exposed portion and improved alkali developability in an unexposed portion.

In addition, in a case where the polymer compound contains a structural unit containing an acid group, the polymer compound is likely to be compatible with a solvent, and coating properties also tends to be improved.

It is presumed that this is because the acid group in the structural unit containing an acid group is likely to interact with a pigment or the like, the polymer compound stably disperses the pigment or the like, the viscosity of the polymer compound dispersing the pigment or the like is reduced, and thus the polymer compound is also likely to be dispersed in a stable manner.

However, the structural unit containing an alkali-soluble group as an acid group and the above-described structural unit containing a graft chain may be the same structural unit or different structural units, but the structural unit containing an alkali-soluble group as an acid group is a structural unit different from the above-described hydrophobic structural unit (that is, the structural unit does not correspond to the above-described hydrophobic structural unit).

Examples of the acid group which is the functional group capable of interacting with a pigment or the like include a carboxylic acid group, a sulfonic acid group, a phosphoric acid group, and a phenolic hydroxyl group, at least one kind of acid group among a carboxylic acid group, a sulfonic acid group, and a phosphoric acid group is preferable, and a carboxylic acid group is more preferable. The carboxylic acid group has favorable adsorptivity to the pigment or the like, and high dispersibility.

That is, it is preferable that the polymer compound further contains a structural unit which contains at least one kind of acid group among a carboxylic acid group, a sulfonic acid group, and a phosphoric acid group.

The polymer compound may have one or more kinds of structural units containing an acid group.

The polymer compound may or may not contain the structural unit containing an acid group, but in a case where the polymer compound contains the structural unit containing an acid group, the content thereof is preferably 5% to 80% by mass, in terms of mass, with respect to the total mass of the polymer compound, and more preferably 10% to 60% by mass from the viewpoint that damage to image intensity by alkali development is suppressed.

Examples of the basic group which is the functional group capable of interacting with a pigment or the like include a primary amino group, a secondary amino group, a tertiary amino group, a hetero ring containing a N atom, and an amide group, and a preferred basic group is a tertiary amino group from the viewpoint that the adsorptivity to the pigment or the like is favorable and the dispersibility is high. The polymer compound may contain one or more kinds of these basic groups.

The polymer compound may or may not contain the structural unit containing a basic group, but in a case where the polymer compound contains the structural unit containing a basic group, the content thereof is preferably 0.01% to 50% by mass, in terms of mass, with respect to the total mass of the polymer compound, and more preferably 0.01% to 30% by mass from the viewpoint of suppression of developability inhibition.

Examples of the coordinating group and the reactive functional group, which are the functional groups capable of interacting with a pigment or the like, include an acetyl acetoxy group, a trialkoxysilyl group, an isocyanate group, an acid anhydride, and an acid chloride. From the viewpoint that the adsorptivity to the pigment or the like is favorable and the dispersibility of the pigment or the like is high, a preferred functional group is an acetyl acetoxy group. The polymer compound may have one or more kinds of these groups.

The polymer compound may or may not contain the structural unit containing a coordinating group or the structural unit containing a reactive functional group, but in a case where the polymer compound contains these structural units, the content thereof is preferably 10% to 80% by mass, in terms of mass, with respect to the total mass of the polymer compound, and more preferably 20% to 60% by mass from the viewpoint of suppression of developability inhibition.

In a case where the polymer compound contains the functional group capable of interacting with a pigment or the like in addition to the graft chain, the polymer compound may contain a functional group capable of interacting with the various pigments or the like, and although an introduction method for these functional group is not particularly limited,

the polymer compound preferably contains one or more kinds of structural units selected from structural units derived from monomers represented by Formulae (iv) to (vi).

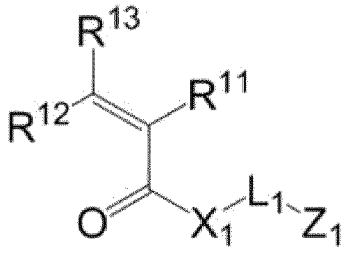

(iv)

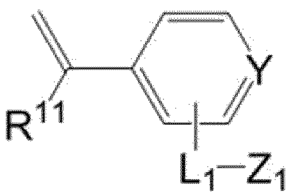

(v)

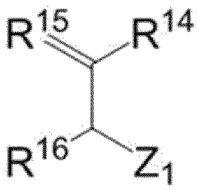

(vi)

In Formulae (iv) to (vi), $R^{11}$, $R^{12}$, and $R^{13}$ each independently represent a hydrogen atom, a halogen atom (for example, a fluorine atom, a chlorine atom, a bromine atom, and the like), or an alkyl group (for example, a methyl group, an ethyl group, a propyl group, and the like) having 1 to 6 carbon atoms.

In Formulae (iv) to (vi), $R^{11}$, $R^{12}$, and $R^{13}$ are preferably each independently a hydrogen atom or an alkyl group having 1 to 3 carbon atoms, and more preferably each independently a hydrogen atom or a methyl group. In Formula (iv), $R^{12}$ and $R^{13}$ are each more preferably a hydrogen atom.

$X_1$ in Formula (iv) represents an oxygen atom (-O-) or an imino group (-NH-), and is preferably an oxygen atom.

Furthermore, Y in Formula (v) represents a methine group or a nitrogen atom.

In addition, $L_1$ in Formulae (iv) and (v) represents a single bond or a divalent linking group. The definition of the divalent linking group is the same as the definition of the divalent linking group represented by L in Formula (i).

$L_1$ is preferably a single bond, an alkylene group, or a divalent linking group having an oxyalkylene structure. The oxyalkylene structure is more preferably an oxyethylene structure or an oxypropylene structure. Moreover, $L_1$ may have a polyoxyalkylene structure including two or more oxyalkylene structures repeatedly. The polyoxyalkylene structure is preferably a polyoxyethylene structure or a polyoxypropylene structure. The polyoxyethylene structure is represented by $-(OCH_2CH_2)_n-$, and n is preferably an integer of 2 or greater and more preferably an integer of 2 to 10.

In Formulae (iv) to (vi), $Z_1$ represents a functional group capable of interacting with a pigment or the like in addition to the graft chain, and is preferably a carboxylic acid group or a tertiary amino group and more preferably a carboxylic acid group.

In Formula (vi), $R^{14}$, $R^{15}$, and $R^{16}$ each independently represent a hydrogen atom, a halogen atom (for example, a fluorine atom, a chlorine atom, a bromine atom, and the like), an alkyl group (for example, a methyl group, an ethyl group, a propyl group, and the like) having 1 to 6 carbon atoms, $-Z_1$, or $L_1-Z_1$. Here, $L_1$ and $Z_1$ have the same definition as $L_1$ and $Z_1$ described above, and preferred examples thereof are also the same. $R^{14}$, $R^{15}$, and $R^{16}$ are preferably each independently a hydrogen atom or an alkyl group having 1 to 3 carbon atoms and more preferably hydrogen atoms.

The monomer represented by Formula (iv) is preferably a compound in which $R^{11}$, $R^{12}$, and $R^{13}$ are each independently a hydrogen atom or a methyl group, $L_1$ is an alkylene group or a divalent linking group having an oxyalkylene structure, $X_1$ is an oxygen atom or an imino group, and $Z_1$ is a carboxylic acid group.

Moreover, the monomer represented by Formula (v) is preferably a compound in which $R^{11}$ is a hydrogen atom or a methyl group, $L_1$ is an alkylene group, $Z_1$ is a carboxylic acid group, and Y is a methine group.

Furthermore, the monomer represented by Formula (vi) is preferably a compound in which $R^{14}$, $R^{15}$, and $R^{16}$

are each independently a hydrogen atom or a methyl group, $L_1$ is a single bond or an alkylene group, and $Z_1$ is a carboxylic acid group.

Typical examples of the monomers (compounds) represented by Formulae (iv) to (vi) are shown below.

Examples of the monomer include methacrylic acid, crotonic acid, isocrotonic acid, a product of a reaction of a compound (for example, 2-hydroxyethyl methacrylate) containing an addition-polymerizable double bond and a hydroxyl group in a molecule with a succinic acid anhydride, a product of a reaction of a compound containing an addition-polymerizable double bond and a hydroxyl group in a molecule with a phthalic acid anhydride, a product of a reaction of a compound containing an addition-polymerizable double bond and a hydroxyl group in a molecule with a tetrahydroxyphthalic acid anhydride, a product of a reaction of a compound containing an addition-polymerizable double bond and a hydroxyl group in a molecule with trimellitic acid anhydride, a product of a reaction of a compound containing an addition-polymerizable double bond and a hydroxyl group in a molecule with a pyromellitic acid anhydride, acrylic acid, an acrylic acid dimer, an acrylic acid oligomer, maleic acid, itaconic acid, fumaric acid, 4-vinylbenzoic acid, vinylphenol, and 4-hydroxyphenyl methacrylamide.

From the viewpoint of the interaction with a pigment or the like, the temporal stability, and the permeability with respect to a developer, the content of the structural unit containing a functional group capable of interacting with a pigment or the like is preferably 0.05% to 90% by mass, more preferably 1.0% to 80% by mass, and even more preferably 10% to 70% by mass with respect to the total mass of the polymer compound.

•Other structural units

In addition, for the purpose of improving various performances such as image intensity, as long as the effects of the present invention are not impaired, the polymer compound may further contain other structural units (for example, a structural unit containing a functional group or the like having affinity with the solvent described later) which have various functions and are different from the structural unit containing a graft chain, the hydrophobic structural unit, and the structural unit containing a functional group capable of interacting with a pigment or the like.

Examples of such other structural units include structural units derived from radically polymerizable compounds selected from acrylonitriles, methacrylonitriles, and the like.

The polymer compound may use one or more kinds of these other structural units, and the content thereof is preferably 0% to 80% by mass and more preferably 10% to 60% by mass, in terms of mass, with respect to the total mass of the polymer compound. In a case where the content is in the above range, sufficient pattern formability is maintained.

•Physical properties of polymer compound

The acid value of the polymer compound is preferably in a range of 0 mg to 250 mg KOH/g, more preferably in a range of 10 to 200 mg KOH/g, and even more preferably in a range of 20 to 120 mg KOH/g.

In a case where the acid value of the polymer compound is 250 mg KOH/g or less, pattern peeling during development in the formation of the cured film is more effectively suppressed. Moreover, in a case where the acid value of the polymer compound is 10 mg KOH/g or greater, alkali developability is further improved. Furthermore, in a case where the acid value of the polymer compound is 20 mg KOH/g or greater, precipitation of the pigment or the like can be further suppressed, the number of coarse particles can be further reduced, and thus temporal stability of the composition can be further improved.

In the present specification, the acid value can be calculated, for example, from the average content of acid groups in the compound. Furthermore, by changing the content of the structural unit containing an acid group, which is a constituent component of the resin, a resin having a desired acid value can be obtained.

A weight-average molecular weight of the polymer compound is preferably 4,000 to 300,000, more preferably 5,000 to 200,000, even more preferably 6,000 to 100,000, and particularly preferably 10,000 to 50,000.

The polymer compound can be synthesized based on known methods.

Specific examples of the structure of the polymer compound include the following compounds.

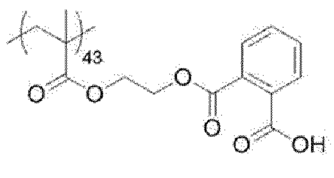
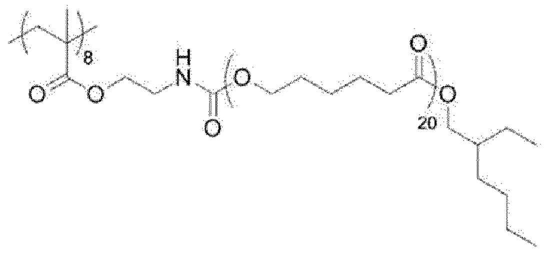
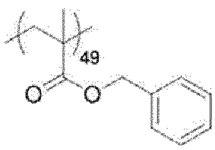

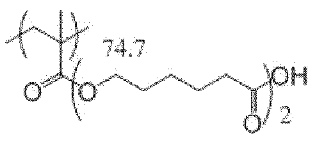 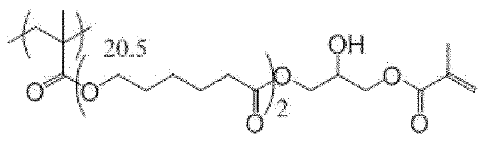

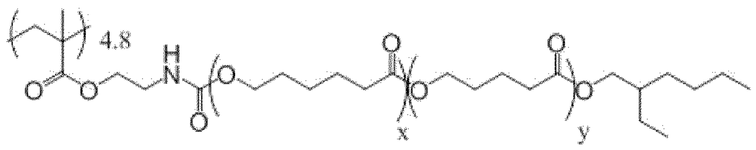

x:y=83.2:16.8

Other specific examples of the polymer compound include "DA-7301" manufactured by Kusumoto Chemicals, Ltd., "DISPERBYK-101 (polyamidoamine phosphate), 107 (carboxylic acid ester), 110 (copolymer containing an acid group), 111 (phosphoric acid-based dispersant), 130 (polyamide), 161, 162, 163, 164, 165, 166, 167, 170, and 190 (polymeric copolymer)" and "BYK-P104 and P105 (high-molecular-weight unsaturated polycarboxylic acid)" manufactured by BYK-Chemie GmbH, "EFKA 4047, 4050 to 4010 to 4165 (based on polyurethane), EFKA 4330 to 4340 (block copolymer), 4400 to 4402 (modified polyacrylate), 5010 (polyester amide), 5765 (high-molecular-weight polycarboxylate), 6220 (aliphatic polyester), 6745 (phthalocyanine derivative), and 6750 (azo pigment derivative)" manufactured by EFKA, "AJISPER PB821, PB822, PB880, and PB881" manufactured by Ajinomoto Fine-Techno Co., Inc., "FLOWLEN TG-710 (urethane oligomer)" and "POLYFLOW No. 50E, No. 300 (acrylic copolymer)" manufactured by KYOEISHA CHEMICAL Co., LTD., "DISPARLON KS-860, 873SN, 874, #2150 (aliphatic polyvalent carboxylic acid), #7004 (polyether ester), DA-703-50, DA-705, and DA-725" manufactured by Kusumoto Chemicals, Ltd., "DEMOL RN, N (naphthalenesulfonic acid formalin polycondensate), MS, C, and SN-B (aromatic sulfonic acid formalin polycondensate)", "HOMOGENOL L-18 (polymeric polycarboxylic acid)", "EMULGEN 920, 930, 935, and 985 (polyoxyethylene nonylphenyl ether)", and "ACETAMIN 86 (stearylamine acetate)" manufactured by Kao Corporation, "SOLSPERSE 5000 (phthalocyanine derivative), 22000 (azo pigment derivative), 13240 (polyester amine), 3000, 12000, 17000, 20000, 27000 (polymer containing a functional portion on a terminal portion), 24000, 28000, 32000, and 38500 (graft copolymer)" manufactured by Lubrizol Japan Limited, "NIKKOL T106 (polyoxyethylene sorbitan monooleate), and MYS-IEX (polyoxyethylene monostearate)" manufactured by Nikko Chemicals Co., Ltd., HINOACT T-8000E and the like manufactured by Kawaken Fine Chemicals Co., Ltd., an organosiloxane polymer KP-341 manufactured by Shin-Etsu Chemical Co., Ltd., "W001: cationic surfactant" manufactured by Yusho Co., Ltd., nonionic surfactants such as polyoxyethylene lauryl ether, polyoxyethylene stearyl ether, polyoxyethylene oleyl ether, polyoxyethylene octyl phenyl ether, polyoxyethylene nonylphenyl ether, polyethylene glycol dilaurate, polyethylene glycol distearate, and a sorbitan fatty acid ester, anionic surfactants such as "W004, W005, and W017", polymer dispersants such as "EFKA-46, EFKA-47, EFKA-47EA, EFKA polymer 100, EFKA polymer 400, EFKA polymer 401, and EFKA polymer 450" manufactured by MORISHITA & CO., LTD., and "DISPERSE AID 6, DISPERSE AID 8, DISPERSE AID 15, and DISPERSE AID 9100" manufactured by SAN NOPCO LIMITED, "ADEKA PLURONIC L31, F38, L42, L44, L61, L64, F68, L72, P95, F77, P84, F87, P94, L101, P103, F108, L121, and P-123" manufactured by ADEKA CORPORATION, and "IONET (trade name) S-20" manufactured by Sanyo Chemical Industries, Ltd. Moreover, ACRYBASE FFS-6752 and ACRYBASE FFS-187 can also be used.

In addition, it is also preferable that an amphoteric resin containing an acid group and a basic group is used. The amphoteric resin is preferably a resin having an acid value of 5 mg KOH/g or greater and an amine value of 5 mg KOH/g or greater.

Examples of a commercial product of the amphoteric resin include DISPERBYK-130, DISPERBYK-140, DISPERBYK-142, DISPERBYK-145, DISPERBYK-180, DISPERBYK-187, DISPERBYK-191, DISPERBYK-2001, DISPERBYK-2010, DISPERBYK-2012, DISPERBYK-2025, and BYK-9076 manufactured by BYK-Chemie GmbH, and AJISPER PB821, AJISPER PB822, and AJISPER PB881 manufactured by Ajinomoto Fine-Techno Co., Inc.

One kind of these polymer compounds may be used singly, or two or more kinds thereof may be used in combination.

Moreover, regarding specific examples of the polymer compound, reference can be made to the polymer compounds described in paragraphs 0127 to 0129 in JP2013-249417A, the contents of which are incorporated into the present specification.

Furthermore, as a dispersant, in addition to the above-described polymer compound, the graft copolymers described in paragraphs 0037 to 0115 in JP2010-106268A (paragraphs 0075 to 0133 in US2011/0124824A corresponding to JP2010-106268A) can be used, and the contents thereof are incorporated by reference into the present specification.

Moreover, in addition to the above dispersants, the polymer compounds described in paragraphs 0028 to 0084 in JP2011-153283A (paragraphs 0075 to 0133 in US2011/0279759A corresponding to JP2011-153283A), which contain a constituent component containing a side chain structure formed by bonding of acidic groups through a linking group, can be used, and the contents thereof are incorporated by reference into the present specification.
Moreover, as a dispersant, the resin described in paragraphs 0033 to 0049 in JP2016-109763A can also be used, and the contents thereof are incorporated into the present specification.

(Alkali-soluble resin)

It is preferable that the curable composition contains an alkali-soluble resin. In the present specification, the alkali-soluble resin means a resin containing a group (alkali-soluble group) which promotes alkali-solubility, and a resin different from the dispersants described above.
A content of the alkali-soluble resin in the curable composition is not particularly limited, but is preferably 1% to 30% by mass and more preferably 1% to 15% by mass with respect to the total solid content of the curable composition.
One kind of alkali-soluble resin may be used singly, or two or more kinds thereof may be used in combination. In a case where two or more kinds of alkali-soluble resins are used in combination, the total content thereof is preferably within the above range.
Examples of the alkali-soluble resin include a resin containing at least one alkali-soluble group in a molecule, and examples thereof include a polyhydroxystyrene resin, a polysiloxane resin, a (meth)acrylic resin, a (meth)acrylamide resin, a (meth)acryl/(meth)acrylamide copolymer resin, an epoxy-based resin, and a polyimide resin.
Specific examples of the alkali-soluble resin include a copolymer of an unsaturated carboxylic acid and an ethylenically unsaturated compound.
The unsaturated carboxylic acid is not particularly limited, and examples thereof include monocarboxylic acids such as (meth)acrylic acid, crotonic acid, and vinyl acetate; dicarboxylic acid, such as itaconic acid, maleic acid, and fumaric acid, or an acid anhydride thereof; and polyvalent carboxylic acid monoesters such as mono(2-(meth)acryloyloxyethyl)phthalate.
Examples of a copolymerizable ethylenically unsaturated compound include methyl (meth)acrylate. Furthermore, the compounds described in paragraph 0027 in JP2010-097210A and paragraphs 0036 and 0037 in JP2015-068893A can also be used, and the contents thereof are incorporated into the present specification.
Furthermore, copolymerizable ethylenically unsaturated compounds containing an ethylenically unsaturated group on a side chain may also be used in combination. As the ethylenically unsaturated group, a (meth)acrylic acid group is preferable. An acrylic resin containing an ethylenically unsaturated group on a side chain can be obtained, for example, by addition-reacting a carboxylic acid group of an acrylic resin containing a carboxylic acid group with an ethylenically unsaturated compound containing a glycidyl group or an alicyclic epoxy group.
As the alkali-soluble resin, an alkali-soluble resin containing a curable group is also preferable.
As the curable group, curable groups that the above-described polymer compound may contain are similarly mentioned, and preferred ranges thereof are also the same.
The alkali-soluble resin containing a curable group is preferably an alkali-soluble resin having a curable group on the side chain. Examples of the alkali-soluble resin containing a curable group include DIANAL NR series (manufactured by Mitsubishi Rayon Co., Ltd.), Photomer6173 (COOH-containing polyurethane acrylic oligomer, manufactured by Diamond Shamrock Co., Ltd.), VISCOAT R-264 and KS RESIST 106 (both are manufactured by OSAKA ORGANIC CHEMICAL INDUSTRY LTD.), CYCLOMER P series (for example, ACA230AA) and PLACCEL CF200 series (both are manufactured by DAICEL CORPORATION), Ebecryl3800 (manufactured by DAICEL-ALLNEX LTD.), and ACRYCURE RD-F8 (manufactured by NIPPON SHOKUBAI CO., LTD.).
As the alkali-soluble resin, for example, it is possible to use the radical polymers containing a carboxylic acid group on a side chain, which are described in JP1984-044615A (JP-S59-044615A), JP1979-034327B (JP-S54-034327B), JP1983-012577B (JP-S58-012577B), JP1979-025957B (JP-S54-025957B), JP1979-092723A (JP-S54-092723A), JP1984-053836A (JP-S59-053836A), and JP1984-071048A (JP-S59-071048A); the acetal-modified polyvinyl alcohol-based binder resins containing an alkali-soluble group, which are described in EP993966B, EP1204000B, and JP2001-318463A; polyvinyl pyrrolidone; polyethylene oxide; polyether as a product of a reaction between alcohol-soluble nylon, 2,2-bis-(4-hydroxyphenyl)-propane, and epichlorohydrin; the polyimide resin described in WO2008/123097A; and the like.
As the alkali-soluble resin, for example, the compound described in paragraphs 0225 to 0245 in JP2016-075845A can also be used, and the contents thereof are incorporated into the present specification.
As the alkali-soluble resin, a polyimide precursor can also be used. The polyimide precursor means a resin obtained by causing an addition polymerization reaction between a compound containing an acid anhydride group and a diamine compound at a temperature of 40°C to 100°C.
Examples of the polyimide precursor include a resin containing a repeating unit represented by Formula (1).

Examples of a structure of the polyimide precursor include a polyimide precursor having an amic acid structure represented by Formula (2), and an imide structure represented by Formula (3) in which the amic acid structure is partially imide ring-closed and Formula (4) in which all the amic acid structures are imide ring-closed.

Furthermore, in the present specification, the polyimide precursor having an amic acid structure is referred to as polyamic acid in some cases.

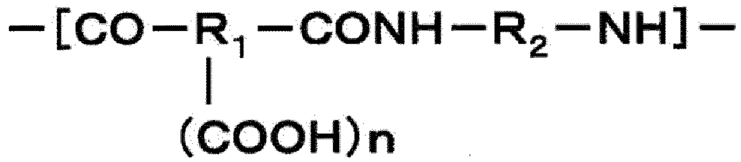

(1)

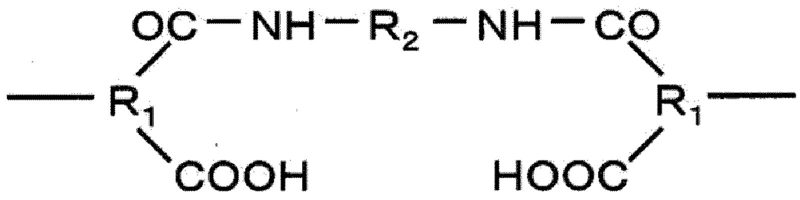

(2)

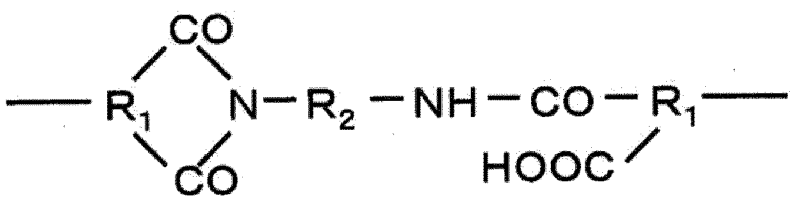

(3)

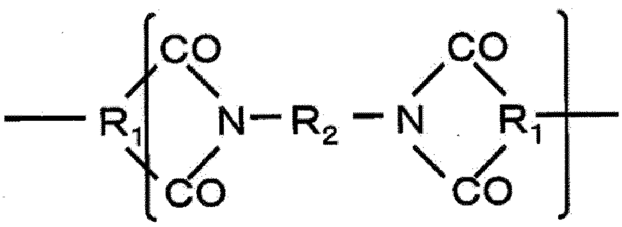

(4)

In Formulae (1) to (4), $R_1$ represents a tetravalent organic group having 2 to 22 carbon atoms, $R_2$ represents a divalent organic group having 1 to 22 carbon atoms, and n represents 1 or 2.

Specific examples of the polyimide precursor include the compound described in paragraphs 0011 to 0031 in JP2008-106250A, the compound described in paragraphs 0022 to 0039 in JP2016-122101A, and the compound described in paragraphs 0061 to 0092 in JP2016-068401A, and the contents thereof are incorporated into the present specification.

From the viewpoint that a pattern shape of a pattern-like cured film obtained by using a curable composition is superior, it is also preferable that the alkali-soluble resin contains at least one kind selected from the group consisting of a polyimide resin and a polyimide precursor.

A polyimide resin containing an alkali-soluble group is not particularly limited, and known polyimide resins containing an alkali-soluble group can be used. Examples of the polyimide resin include the resin described in paragraph 0050 in JP2014-137523A, the resin described in paragraph 0058 in JP2015-187676A, and the resin described in paragraphs 0012 and 0013 in JP2014-106326A, and the contents thereof are incorporated into the present specification.

<Polymerization inhibitor>

The curable composition may contain a polymerization inhibitor.

The polymerization inhibitor is not particularly limited, and known polymerization inhibitors can be used. Examples of the polymerization inhibitor include a phenol-based polymerization inhibitor (for example, p-methoxyphenol, 2,5-di-tert-butyl-4-methylphenol, 2,6-di-tert-butyl-4-methylphenol, 4,4'-thiobis(3-methyl-6-t-butylphenol), 2,2'-methylenebis(4-methyl-6-t-butylphenol), 4-methoxynaphthol, or the like), a hydroquinone-based polymerization inhibitor (for example, hydroquinone, 2,6-di-tert-butylhydroquinone, or the like); a quinone-based polymerization inhibitor (for example, benzoquinone or the like), a free radical-based polymerization inhibitor (for example, a 2,2,6,6-tetramethylpiperidin-1-oxyl free radical, a 4-hydroxy-2,2,6,6-tetramethylpiperidin-1-oxyl free radical, or the like); a nitrobenzene-based polymerization inhibitor (for example, nitrobenzene, 4-nitrotoluene, or the like); and a phenothiazine-based polymerization inhibitor (for example, phenothiazine, 2-methoxyphenothiazine, or the like).

Among them, from the viewpoint that the curable composition has superior effects, a phenol-based polymerization inhibitor or a free radical-based polymerization inhibitor is preferable.

In a case where the polymerization inhibitor is used together with a resin containing a curable group, the effects thereof are remarkable.

A content of the polymerization inhibitor in the curable composition is not particularly limited, but is preferably 0.0001% to 0.5% by mass and more preferably 0.001% to 0.2% by mass with respect to the total solid content of the curable composition. One kind of polymerization inhibitor may be used singly, or two or more kinds thereof may be used in combination. In a case where two or more kinds of polymerization inhibitors are used in combination, the total content thereof is preferably within the above range.

<Surfactant>

The curable composition may contain a surfactant. The surfactant contributes to improvement in the coating properties of the curable composition.

In a case where the curable composition contains a surfactant, a content of the surfactant is preferably 0.001% to 2.0% by mass with respect to the total solid content of the curable composition.

One kind of surfactant may be used singly, or two or more kinds thereof may be used in combination. In a case where two or more kinds of surfactants are used in combination, the total amount thereof is preferably within the above range.

Examples of the surfactant include a fluorine-based surfactant, a nonionic surfactant, a cationic surfactant, an anionic surfactant, and a silicone-based surfactant.

For example, in a case where the curable composition contains a fluorine-based surfactant, the liquid characteristics (particularly, fluidity) of the curable composition are further improved. That is, in a case where a film is formed of the curable composition containing the fluorine-based surfactant, the interfacial tension between a surface to be coated and a coating liquid is reduced, and thus the wettability with respect to the surface to be coated is improved and the coating properties with respect to the surface to be coated are improved. For the reason, the fluorine-based surfactant is effective in that a film having a uniform thickness and small thickness unevenness is more suitably formed even in a case where a thin film having a thickness of about several micrometers is formed of a small amount of the liquid.

A content percentage of fluorine in the fluorine-based surfactant is preferably 3% to 40% by mass, more preferably 5% to 30% by mass, and even more preferably 7% to 25% by mass. A fluorine-based surfactant having a content percentage of fluorine within the above range is effective in terms of uniformity in the thickness of the coating film and/or liquid saving properties and also has favorable solubility in the curable composition.

Examples of the fluorine-based surfactant include MEGAFACE F171, MEGAFACE F172, MEGAFACE F173, MEGAFACE F176, MEGAFACE F177, MEGAFACE F141, MEGAFACE F142, MEGAFACE F143, MEGAFACE F144, MEGAFACE R30, MEGAFACE F437, MEGAFACE F475, MEGAFACE F479, MEGAFACE F482, MEGAFACE F554, MEGAFACE F780, and MEGAFACE F781 (the above products are manufactured by DIC Corporation); FLUORAD FC430, FLUORAD FC431, and FLUORAD FC171 (the above products are manufactured by Sumitomo 3M Limited); SURFLON S-382, SURFLON SC-101, SURFLON SC-103, SURFLON SC-104, SURFLON SC-105, SURFLON SC-1068, SURFLON SC-381, SURFLON SC-383, SURFLON S-393, and SURFLON KH-40 (the above products are manufactured by ASAHI GLASS CO., LTD.); and PF636, PF656, PF6320, PF6520, and PF7002 (manufactured by OMNOVA Solutions Inc.).

A block polymer can also be used as the fluorine-based surfactant, and specific examples thereof include the compound described in JP2011-089090A.

<Ultraviolet absorber>

The curable composition may contain an ultraviolet absorber. In this way, a shape of a pattern of the cured film can be made into a superior (fine) shape.

As the ultraviolet absorber, ultraviolet absorbers based on salicylate, benzophenone, benzotriazole, substituted acrylonitrile, triazine, and the like can be used. As specific examples thereof, the compounds of paragraphs 0137 to 0142 in of JP2012-068418A (paragraphs 0251 to 0254 in US2012/0068292A corresponding to JP2012-068418A can be used, and the contents thereof are incorporated by reference into the present specification.

In addition to the ultraviolet absorbers, a diethylamino-phenylsulfonyl-based ultraviolet absorber (manufactured by DAITO CHEMICAL CO., LTD., trade name: UV-503) and the like are also suitably used.
Examples of the ultraviolet absorber include compounds exemplified in paragraphs 0134 to 0148 of JP2012-032556A.
A content of the ultraviolet absorber is preferably 0.001% to 15% by mass, more preferably 0.01% to 10% by mass, and even more preferably 0.1% to 5% by mass with respect to the total solid content of the curable composition.

<Silane coupling agent>

The curable composition may contain a silane coupling agent.
The silane coupling agent is a compound containing a hydrolyzable group and other functional groups in a molecule. Moreover, the hydrolyzable group such as an alkoxy group is bonded to a silicon atom.
The hydrolyzable group refers to a substituent which is directly bonded to a silicon atom and can form a siloxane bond by a hydrolysis reaction and/or a condensation reaction. Examples of the hydrolyzable group include a halogen atom, an alkoxy group, an acyloxy group, and an alkenyloxy group. In a case where the hydrolyzable group contains carbon atoms, the number of carbon atoms is preferably 6 or less and more preferably 4 or less. Particularly, an alkoxy group having 4 or less carbon atoms or an alkenyloxy group having 4 or less carbon atoms is preferable.
Furthermore, in a case where a cured film is formed on a substrate, in order to improve adhesiveness between the substrate and the cured film, a silane coupling agent preferably does not contain a fluorine atom and a silicon atom (here, a silicon atom to which a hydrolyzable group is bonded is excluded), and desirably does not contain a fluorine atom, a silicon atom (here, a silicon atom to which a hydrolyzable group is bonded is excluded), an alkylene group substituted with a silicon atom, a linear alkyl group having 8 or more carbon atoms, and a branched alkyl group having 3 or more carbon atoms.
A content of the silane coupling agent in the curable composition is preferably 0.1% to 10% by mass, more preferably 0.5% to 8% by mass, and even more preferably 1.0% to 6% by mass with respect to the total solid content in the curable composition.
The curable composition may contain one type of silane coupling agent alone or may contain two or more kinds thereof. In a case where the curable composition contains two or more kinds of silane coupling agents, the total thereof may be within the above range.
Examples of the silane coupling agent include 3-glycidoxypropyltrimethoxysilane, 3-glycidoxypropyltriethoxysilane, 3-glycidoxypropylmethyldimethoxysilane, 3-glycidoxypropylmethyldiethoxysilane, vinyltrimethoxysilane, and vinyltriethoxysilane.

<Solvent>

It is preferable that the curable composition contains a solvent.
The solvent is not particularly limited, and known solvents can be used.
A content of the solvent in the curable composition is not particularly limited, but is preferably adjusted such that the solid content of the curable composition is 10% to 90% by mass, and more preferably adjusted such that the solid content of the curable composition is 15% to 90% by mass. Moreover, the solid content means components other than a solvent.
One kind of solvent may be used singly, or two or more kinds thereof may be used in combination. In a case where two or more kinds of solvents are used in combination, it is preferable that the content thereof is adjusted such that the total solid content of the curable composition falls within the above range.

Examples of the solvent include water and an organic solvent.

Examples of the organic solvent include acetone, methyl ethyl ketone, cyclohexane, ethyl acetate, ethylene dichloride, tetrahydrofuran, toluene, ethylene glycol monomethyl ether, ethylene glycol monoethyl ether, ethylene glycol dimethyl ether, propylene glycol monomethyl ether, propylene glycol monoethyl ether, acetyl acetone, cyclohexanone, cyclopentanone, diacetone alcohol, ethylene glycol monomethyl ether acetate, ethylene glycol ethyl ether acetate, ethylene glycol monoisopropyl ether, ethylene glycol monobutyl ether acetate, 3-methoxypropanol, methoxymethoxy ethanol, diethylene glycol monomethyl ether, diethylene glycol monoethyl ether, diethylene glycol dimethyl ether, diethylene glycol diethyl ether, propylene glycol monomethyl ether acetate, propylene glycol monoethyl ether acetate, 3-methoxypropyl acetate, N,N-dimethylformamide, dimethyl sulfoxide, $\gamma$-butyrolactone, butyl acetate, methyl lactate, N-methyl-2-pyrrolidone, and ethyl lactate.

[Manufacturing method of curable composition]

Regarding the curable composition, it is preferable that a dispersion composition in which a black coloring material is dispersed is first manufactured, and the obtained dispersion composition is further mixed with other components to obtain a curable composition.
The dispersion composition is preferably prepared by mixing a black coloring material, a resin (preferably, a dispersant), and a solvent. Moreover, it is also preferable that a polymerization inhibitor is contained in the dispersion composition.
The dispersion composition can be prepared by mixing together the above-described components by known mixing methods (for example, mixing methods using a stirrer, a homogenizer, a high-pressure emulsification device, a wet-type pulverizer, a wet-type disperser, or the like).
In a case where the curable composition is prepared, the respective components may be formulated together at once, or each of the components may be dissolved or dispersed in a solvent and then sequentially formulated together. Moreover, the order of addition and the operation conditions during the formulation are not particularly limited.
For the purpose of removing foreign substances, reducing defects, and the like, it is preferable that the curable composition is filtered through a filter. The filter can be used without particular limitation as long as the filter is a filter which has been used for a filtration application or the like. Examples thereof include filters formed of a fluororesin such as polytetrafluoroethylene (PTFE), a polyamide-based resin such as nylon, and a polyolefin-based resin (including a high-density polyolefin-based resin and an ultra-high-molecular-weight polyolefin-based resin) such as polyethylene or polypropylene (PP). Among these materials, polypropylene (including high-density polypropylene) and nylon are preferable.
A pore size of the filter is preferably 0.1 to 7.0 μm, more preferably 0.2 to 2.5 μm, even more preferably 0.2 to 1.5 μm, and particularly preferably 0.3 to 0.7 μm. By setting the pore size with the above range, it is possible to reliably remove fine foreign substances such as impurities and aggregated substances contained in the pigment while suppressing filter clogging of the pigment.
In a case where filters are used, different filters may be used in combination. At this time, filtering performed using a first filter may be carried out only once or twice or more. In a case where filtering is performed twice or more by using a combination of different filters, the pore sizes in the second and subsequent filtering are preferably the same as or larger than the pore size in the first filtering. Moreover, a first filter having a different pore size within the above range may be combined. Regarding the pore size here, the nominal values of the filter manufacturer can be referred to. A commercially available filter can be selected from various filters provided by, for example, Nihon Pall Ltd., Advantec Toyo Kaisha, Ltd., Nihon Entegris G.K. (former Nihon Microlith Co., Ltd.), KITZ MICRO FILTER CORPORATION, and the like.
As a second filter, a filter formed of the same material as the first filter described above and the like can be used. A pore size of the second filter is preferably 0.2 to 10.0 μm, more preferably 0.2 to 7.0 μm, and even more preferably 0.3 to 6.0 μm.
It is preferable that the curable composition does not contain impurities such as a metal, a metal salt containing halogen, acid, and alkali. A content of the impurities contained in these materials is preferably 1 ppm or less, more preferably 1 ppb or less, even more preferably 100 ppt or less, and particularly preferably 10 ppt or less, and it is most preferable that the impurities are not substantially contained (equal to or lower than detection limit of a measurement device).
Furthermore, the impurities can be measured using an inductively coupled plasma mass spectrometer (manufactured by Yokogawa Analytical Systems, Inc., Agilent 7500cs model).

[Procedure for manufacturing cured film]

A pattern-like cured film can be obtained by curing a curable composition layer (composition layer) formed of the curable composition.
Hereinafter, the procedure for forming a cured film using the curable composition as described above will be described separately for a method A and a method B.

«Method A»

<Curable composition layer forming step>

The method A includes a step (curable composition layer forming step) of applying a curable composition onto a support or the like to form a layer (curable composition layer) of the curable composition prior to exposure.
As the support, for example, a substrate for a solid-state imaging element in which an imaging element (light-receiving element) such as a charge coupled device (CCD) and complementary metal-oxide semiconductor (CMOS) is provided on a substrate (for example, a silicon substrate) can be used. Moreover, if necessary, an undercoat layer may be provided on the support, in order to improve adhesion with an upper layer, prevent diffusion of substances, and planarize a surface of the substrate.

As a method for applying the curable composition onto the support, various coating methods such as a slit coating method, an ink jet method, a spin coating method, a cast coating method, a roll coating method, and a screen printing method can be applied.

Furthermore, it is preferable that the curable composition applied onto the support is subjected to a drying treatment (prebaking) to form a curable composition layer.

The drying treatment for the curable composition applied onto the support is preferably performed using a hot plate or an oven at a temperature of 50°C to 140°C for 10 to 300 seconds.

A film thickness of the curable composition layer is preferably 0.1 to 10 μm, more preferably 0.2 to 5 μm, and even more preferably 0.2 to 3 μm.

<Exposure step>

In the method A, the curable composition layer formed in the curable composition layer forming step is exposed by irradiation with actinic rays or radiation to cure (photo-cure) the curable composition layer (exposure step).

A method of light irradiation is not particularly limited, but the light irradiation is preferably performed through a photo mask having a pattern-like opening portion.

The exposure is preferably performed by irradiation with radiation, as the radiation that can be used for the exposure, ultraviolet rays such as g-line, h-line, and i-line are particularly preferable, and as a light source, a high-pressure mercury lamp is preferable. The irradiation intensity is preferably 5 to 1,500 $mJ/cm^2$ and more preferably 10 to 1,000 $mJ/cm^2$.

<Development step>

In the method A, the exposed curable composition layer is subjected to a development treatment (development step), and thus a portion which is not subjected to light irradiation in the exposure step is eluted into a developer. In this way, only a photo-cured portion remains.

As the developer, an alkaline developer may be used. In this case, it is preferable to use an organic alkaline developer. A development temperature is usually 20°C to 30°C, and a development time is 20 to 90 seconds.

Examples of an aqueous alkaline solution (alkaline developer) include an inorganic alkaline developer and an organic alkaline developer.

Examples of the inorganic alkaline developer include an aqueous alkaline solution in which an alkaline compound such as sodium hydroxide, potassium hydroxide, sodium carbonate, sodium hydrogen carbonate, sodium silicate, and sodium metasilicate is dissolved such that the concentration is 0.001% to 10% by mass (preferably, 0.005% to 0.5% by mass).

Examples of the organic alkaline developer include an aqueous alkaline solution in which an alkaline compound such as ammonia water, ethylamine, diethylamine, dimethylethanolamine, tetramethylammonium hydroxide, tetraethylammonium hydroxide, tetrapropylammonium hydroxide, tetrabutylammonium hydroxide, benzyltrimethylammonium hydroxide, choline, pyrrole, piperidine, and 1,8-diazabicyclo-[5,4,0]-7-undecen is dissolved such that the concentration is 0.001% to 10% by mass (preferably, 0.005% to 0.5% by mass).

For example, an appropriate amount of a water-soluble organic solvent such as methanol or ethanol and/or a surfactant can be added to the aqueous alkaline solution.

Furthermore, in a case where a developer consisting of such an aqueous alkaline solution is used, the cured film is generally washed (rinsed) with pure water after development.

<Post-curing step (post-baking step)>

This step is a step of performing a post-curing treatment.

In the method A, the developed curable composition layer is further heated at a temperature of lower than 170°C, in an environment where an oxygen concentration is lower than 1,000 ppm by volume, to form a cured film (post-curing step (post-baking step)).

The oxygen concentration in the post-curing step is less than 1,000 ppm by volume, preferably 850 ppm by volume or lower, more preferably 500 ppm by volume or lower, and even more preferably 100 ppm by volume or lower. The lower limit of the oxygen concentration is not particularly limited, but is, for example, 1 ppb by volume or greater and preferably 1 ppm by volume or greater.

Furthermore, as a method for achieving the oxygen concentration with the above range, a method in which the air in the system for performing the post-curing step is replaced with an inert gas (preferably a nitrogen gas or an argon gas) is preferable. Moreover, atmospheric pressure in the system for performing the post-curing step is preferably normal pressure. Here, the normal pressure is pressure near a standard state of the atmosphere, and means an atmospheric pressure condition near 101 kPa in absolute pressure.
In other words, the post-curing step is preferably performed under an absolute oxygen concentration such that the oxygen concentration under the normal pressure (101 kPa) falls within the above range.
A heating temperature in the post-curing step is lower than 170°C, and the lower limit thereof is not particularly limited but is 100°C or higher, for example. The heating temperature is preferably 135°C to 160°C, for example.
A heating time is preferably 30 to 300 seconds. The upper limit thereof is more preferably 240 seconds or less and even more preferably 180 seconds or less. The lower limit thereof is more preferably 60 seconds or more.
A heating method in the post-curing step is not particularly limited, and examples thereof include a method using an oven or a hot plate. Above them, it is preferable that heating is performed using an oven.
In addition, the method for manufacturing a cured film may further include other steps.
The other steps are not particularly limited, and can be appropriately selected according to the purpose.
Examples of the other steps include a substrate surface treatment step.

«Method B»

<Curable composition layer forming step>

The method B includes a curable composition layer forming step. In the method B, the curable composition layer forming step is performed as in the method A.

<Exposure step>

In the method B, an exposure step is performed according to the same procedure as in the method A.
In particular, in the method B, it is preferable that the exposure is performed using light (for example, i-line) having a wavelength of 330 to 500 nm. The light used for exposure may contain light having a wavelength other than a wavelength of 330 to 500 nm, but in a case where the light used for exposure contains such light and the intensity of the maximum wavelength in the wavelength range of 330 to 500 nm is 100%, the intensity of the maximum wavelength in a wavelength range of 200 to 315 nm is preferably 10% or less.

<Development step>

The method B includes a development step. In the method B, the development step is performed as in the method A.

<Post-curing step (ultraviolet irradiation step)>

This step is a step of performing a post-curing treatment.
In the method B, the developed curable composition layer is further irradiated with ultraviolet rays to form a cured film (post-curing step (ultraviolet irradiation step)).
The light radiated in this step is ultraviolet rays, and more preferably has a wavelength of 300 nm or less. The light radiated in this step is not particularly limited as long as the light contains ultraviolet rays (preferably, light having a wavelength of 300 nm or less), and may contain light other than ultraviolet rays.
In the light radiated in this step, in a case where the intensity of the maximum wavelength in the wavelength range of 330 to 500 nm is 100%, the intensity of the maximum wavelength in a wavelength range of 200 to 315 nm (preferably, a wavelength of 200 to 300 nm) is preferably 50% or greater.
Furthermore, an irradiation dose of the light in the ultraviolet irradiation step is preferably 0.1 to 20 $J/cm^2$ and more preferably 1 to 10 $J/cm^2$.

[Physical properties of cured film and application of cured film]

[Physical properties of cured film]

In the cured film obtained by the manufacturing method according to the embodiment of the present invention, from the viewpoint that the cured film has excellent light blocking properties, an optical density (OD) per film thickness

of 1.0 μm in a wavelength range of 400 to 1,200 nm is preferably 2.0 or higher and more preferably 3.0 or higher. Moreover, the upper limit value thereof is not particularly limited, but is generally preferably 10 or lower. The cured film can be preferably used as a light blocking film.

In the present specification, the expression of "the optical density per film thickness of 1.0 μm in a wavelength range of 400 to 1,200 nm is 3.0 or higher" means that the optical density per film thickness of 1.0 μm is 3.0 or higher in the entire wavelength range of 400 to 1,200 nm.

Furthermore, in the present specification, as a method for measuring the optical density of a cured film, first, a cured film is formed on a glass substrate and measured using a transmission densitometer (X-rite 361T (visual) densitometer), a film thickness at a measurement point is also measured, and an optical density per predetermined film thickness is calculated.

In addition, it is also preferable that the cured film has a surface uneven structure. By doing so, in a case where the cured film is used as a light blocking film, reflectivity of the cured film can be reduced. The surface of the cured film may have an uneven structure, or an uneven structure may be provided by providing another layer on the cured film. A shape of the surface uneven structure is not particularly limited, but surface roughness is preferably in a range of 0.55 μm to 1.5 μm.

The reflectivity of the cured film is preferably 5% or less, more preferably 3% or less, and even more preferably 2% or less.

The method for producing the surface uneven structure is not particularly limited, but may be a method in which an organic filler and/or an inorganic filler is incorporated in the cured film or the other layer, a lithography method using exposure and development, or a method in which a surface of the cured film or the other layer is roughened by an etching method, a sputtering method, or a nanoimprint method.

Furthermore, examples of a method for reducing the reflectivity of the cured film include, in addition to the above methods, a method of providing a layer of low refractive index on the cured film, a method of further providing a plurality of layers (for example, a layer of high refractive index) having different refractive indices, and a method of forming a layer having a low optical density and a layer having a high optical density, which is described in JP2015-001654A.

In addition, the cured film is suitable for a light blocking member, a light blocking film, an antireflection member, and an antireflection film of optical filters and modules used in portable instruments such as a personal computer, a tablet, a mobile phone, a smartphone, and a digital camera; office automation (OA) instruments such as a printer composite machine and a scanner; industrial instruments such as monitoring camera, a barcode reader, an automated teller machine (ATM), a high-speed camera, an instrument having a personal authentication function exploiting face image authentication; in-vehicle camera instruments; medical camera instruments such as an endoscope, a capsule endoscope, and a catheter; a biosensor, a military reconnaissance camera, a camera for a three-dimensional map, a camera for observing weather and sea, a camera for a land resource exploration, space instruments such as an exploration camera for the astronomy of the universe and a deep space target; and the like.

The cured film can also be used for an application such as a micro light emitting diode (LED) and a micro organic light emitting diode (OLED). The cured film is suitable for an optical filter and an optical film used in the micro LED and the micro OLED and for a member to which a light blocking function or an antireflection function is to be imparted.

Examples of the micro LED and the micro OLED include those described in JP2015-500562A and JP2014-533890A.

The cured film is also suitable as an optical filter and an optical film used in a quantum dot sensor and a quantum dot solid-state imaging element. Furthermore, the cured film is suitable as a member to which a light blocking function or an antireflection function is to be imparted. Examples of the quantum dot sensor and the quantum dot solid-state imaging element include those described in US2012/0037789A and WO2008/131313A.

The cured film is also preferably used in a light blocking member and/or a light blocking film of a headlight unit used in headlights for vehicles such as automobiles. Furthermore, the cured film is also preferably used in an antireflection member, an antireflection film, and the like.

[Light blocking film, solid-state imaging element, and solid-state imaging device]

The cured film obtained by the manufacturing method according to the embodiment of the present invention is also preferably used as a so-called light blocking film. Such a light blocking film is also preferably used in a solid-state imaging element.

Furthermore, the light blocking film is one of the preferred applications of the cured film obtained by the manufacturing method according to the embodiment of the present invention. That is, a cured film manufactured by the method for manufacturing a cured film according to the embodiment of the present invention is also preferably a light blocking film.

A method for manufacturing the cured film which is a light blocking film can be performed similarly to the method

described as the above-described method for manufacturing a cured film. Specifically, by applying a curable composition to a substrate so as to form a curable composition layer and performing exposure and development, a light blocking film can be manufactured.

In addition, a method for manufacturing a solid-state imaging element according to the embodiment of the present invention is a method for manufacturing a solid-state imaging element having a cured film (light blocking film), which includes a step of manufacturing the cured film (light blocking film) through the above-described manufacturing method according to the embodiment of the present invention.

As described above, the solid-state imaging element related to the manufacturing method according to the embodiment of the present invention includes the cured film (light blocking film). The aspect in which the solid-state imaging element includes the cured film (light blocking film) is not particularly limited, and examples thereof include an aspect in which a plurality of photodiodes and light-receiving elements formed of polysilicon or the like constituting a light-receiving area of a solid-state imaging element (a CCD image sensor, a CMOS image sensor, or the like) are provided on a substrate, and the cured film is provided on a surface side of a support on which the light-receiving elements are formed (for example, a portion other than light-receiving portions and/or a pixel for adjusting a tone) or on a side opposite to the surface on which the light-receiving elements are formed.

A solid-state imaging device includes the solid-state imaging element.

It is also preferable that such a solid-state imaging device is applied to a camera, a fingerprint authentication device, a face authentication device, and the like.

Examples of the constitutions of the solid-state imaging device and the solid-state imaging element will be described with reference to Fig. 1 and Fig. 2. Moreover, in Fig. 1 and Fig. 2, in order that each portion is clearly seen, some portions are magnified in disregard of a thickness ratio and/or a width ratio between the portions.

As shown in Fig. 1, a solid-state imaging device 100 comprises a rectangular solid-state imaging element 101 and a transparent cover glass 103 which is held above the solid-state imaging element 101 and seals the solid-state imaging element 101. Furthermore, on the cover glass 103, a lens layer 111 is provided so as to be superposed through a spacer 104. The lens layer 111 is constituted with a support 113 and a lens material 112. The lens layer 111 may be constituted with the support 113 and the lens material 112 that are integrally formed. In a case where stray light comes into the peripheral region of the lens layer 111, due to the diffusion of light, a light condensing effect of the lens material 112 is weakened, and thus the light reaching an imaging portion 102 is reduced. Moreover, noise occurs due to the stray light. Therefore, a light blocking film 114 is provided in the peripheral region of the lens layer 111 such that light is blocked. The cured film obtained by the manufacturing method according to the embodiment of the present invention can also be used as the light blocking film 114.

The solid-state imaging element 101 performs photoelectric conversion on an optical image formed by the imaging portion 102, which serves as a light-receiving surface of the solid-state imaging element 101, and outputs the converted optical image as an image signal. The solid-state imaging element 101 comprises a laminated substrate 105 obtained by laminating two sheets of substrates. The laminated substrate 105 consists of a chip substrate 106 and a circuit substrate 107 that are rectangular substrates having the same size, and the circuit substrate 107 is laminated on the rear surface of the chip substrate 106.

A material of the substrate used as the chip substrate 106 is not particularly limited, and known materials can be used.

The imaging portion 102 is provided in the central portion of the surface of the chip substrate 106. Moreover, in a case where stray light comes into the peripheral region of the imaging portion 102, a dark current (noise) occurs from the circuit in the peripheral region, and thus a light blocking film 115 is provided in the peripheral region such that light is blocked. The cured film obtained by the manufacturing method according to the embodiment of the present invention is preferably used as the light blocking film 115.

A plurality of electrode pads 108 are provided at the edge of the surface of the chip substrate 106. The electrode pads 108 are electrically connected to the imaging portion 102 through a signal line (a bonding wire can also be used) not shown in the drawing that is provided on the surface of the chip substrate 106.

On the rear surface of the circuit substrate 107, external connection terminals 109 are provided approximately at positions below the electrode pads 108. The external connection terminals 109 are connected to the electrode pads 108 through a penetration electrode 110 vertically penetrating the laminated substrate 105. Furthermore, the external connection terminals 109 are connected to a control circuit controlling the driving of the solid-state imaging element 101, an image processing circuit performing image processing on an imaging signal output from the solid-state imaging element 101, and the like through wiring not shown in the drawing.

As shown in Fig. 2, the imaging portion 102 is constituted with the portions provided on a substrate 204, such as a light-receiving element 201, a color filter 202, and a microlens 203. The color filter 202 has a blue pixel 205b, a red pixel 205r, a green pixel 205g, and a black matrix 205bm. The cured film obtained by the manufacturing method according to the embodiment of the present invention can also be used as the black matrix 205bm.

As the material of the substrate 204, the same material as that of the chip substrate 106 can be used. On the

surface layer of the substrate 204, a p-well layer 206 is formed. In the p-well layer 206, the light-receiving elements 201, which consist of an n-type layer and generate and accumulate signal charges by photoelectric conversion, are arranged in the form of square grids.

On one lateral side of each light-receiving element 201, through a reading gate portion 207 on the surface layer of the p-well layer 206, a vertical electric charge transfer path 208 consisting of an n-type layer is formed. Furthermore, on the other lateral side of each light-receiving element 201, through an element separation region 209 consisting of a p-type layer, a vertical electric charge transfer path 208 belonging to the adjacent pixel is formed. The reading gate portion 207 is a channel region for the signal charges accumulated in the light-receiving element 201 to be read toward the vertical electric charge transfer path 208.

On the surface of the substrate 204, a gate insulating film 210 consisting of an oxide-nitride-oxide (ONO) film is formed. On the gate insulating film 210, vertical electric charge transfer electrodes 211 consisting of polysilicon or amorphous silicon are formed to cover the portions which are approximately immediately above the vertical electric charge transfer path 208, the reading gate portion 207, and the element separation region 209. The vertical electric charge transfer electrodes 211 function as driving electrodes for driving the vertical electric charge transfer path 208 and performing charge transfer and as reading electrodes for driving the reading gate portion 207 and reading out signal charges. The signal charges are transferred to a horizontal electric charge transfer path and an output portion (floating diffusion amplifier), which are not shown in the drawing, in this order from the vertical electric charge transfer path 208 and then output as voltage signals.

On each of the vertical electric charge transfer electrodes 211, a light blocking film 212 is formed to cover the surface of the electrode. The light blocking film 212 has an opening portion at a position immediately above the light-receiving element 201 and shields a region other than the opening portion from light. The cured film obtained by the manufacturing method according to the embodiment of the present invention can also be used as the light blocking film 212.

On the light blocking film 212, a transparent interlayer is provided which consists of an insulating film 213 consisting of borophosphosilicate glass (BPSG), an insulating film (passivation film) 214 consisting of P-SiN, and a planarization film 215 consisting of a transparent resin or the like. The color filter 202 is formed on the interlayer.

In addition, the application of the cured film (light blocking film) obtained by the manufacturing method according to the embodiment of the present invention is not limited, and for example, the cured film may be used in a black matrix (or a color filter including the black matrix) in an image display device, or may be used in an infrared sensor.

## Examples

Hereinafter, the present invention will be more specifically described based on Examples. The materials, the amount of the materials used, the proportion of the materials, the treatment content, the treatment procedure, and the like shown in the following Examples can be appropriately modified as long as the gist of the present invention is maintained. Accordingly, the scope of the present invention is not limited to the following Examples.

### [Preparation of curable composition]

A curable composition was prepared using components shown below.

### <Dispersion composition>

The following dispersion compositions were produced and used for the preparation of the curable composition.

### (Titanium black dispersion liquid A)

The following raw materials were subjected to a dispersion treatment by using NPM Pilot manufactured by Shinmaru Enterprises Corporation to obtain a titanium black dispersion liquid A.

- Titanium black (T-1) (details will be described later): 25 parts by mass
- Solution (pigment dispersant) of 30 mass% resin (X-1) in PGMEA: 25 parts by mass
- PGMEA: 23 parts by mass
- Butyl acetate: 27 parts by mass

The structure of the resin (X-1) is as follows. A weight-average molecular weight was 30,000. Moreover, the number attached to each repeating unit indicates a molar ratio of each unit.

X-1

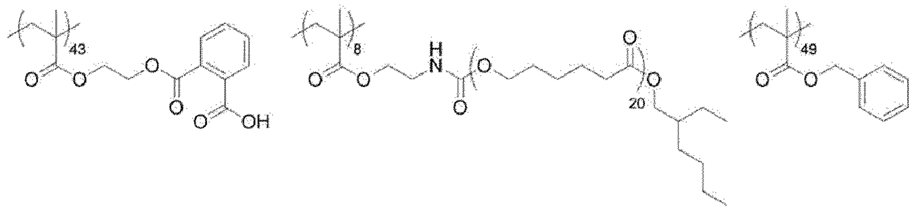

Furthermore, PGMEA means propylene glycol monomethyl ether acetate.

In addition, the solution of a 30 mass% resin (X-1) in PGMEA means a solution obtained by dissolving the resin (X-1) in PGMEA such that a content of the resin (X-1) is 30% by mass with respect to the total mass of the solution. Hereinafter, the description of a "solution of (number) mass% (substance name) in (solvent name)" is based on the same intention.

Production of titanium black (T-1)

Titanium oxide MT-150A (trade name, manufactured by TAYCA) (100 g) having an average particle diameter of 15 nm, silica particles AEROSIL (registered trademark) 300/30 (manufactured by Evonik Industries AG) (25 g) having a BET surface area of 300 $m^2$/g, and a dispersant DISPERBYK-190 (trade name, manufactured by BYK-Chemie GmbH) (100 g) were weighed, electrically deionized water (71 g) was added thereto, and the resultant was treated for 20 minutes at a revolution speed of 1,360 rpm and a rotation speed of 1,047 rpm by using MAZERUSTAR KK-400W manufactured by KURABO INDUSTRIES LTD. to obtain a homogeneous aqueous solution of a mixture. A quartz container was filled with the aqueous solution and heated to 920°C in an oxygen atmosphere by using a small rotary kiln (manufactured by MOTOYAMA Co., Ltd.), and then by purging the atmosphere with nitrogen and allowing an ammonia gas to flow for 5 hours at 100 mL/min at the same temperature, a nitriding reduction treatment was performed. After completion of the nitriding reduction treatment, the collected powder was pulverized using a mortar, thereby obtaining powder-like titanium black (T-1) containing Si atoms and having a specific surface area of 73 $m^2$/g.

(Titanium black dispersion liquid B)

A titanium black dispersion liquid B was produced in the same manner as the titanium black dispersion liquid A, except that the solution (pigment dispersant) of a 30 mass% resin (X-1) in PGMEA was changed to a solution (pigment dispersant) of a 30 mass% resin (X-2) in PGMEA.

The structure of the resin (X-2) is as follows. A weight-average molecular weight was 18,000. Moreover, the number attached to each repeating unit indicates a molar ratio of each unit. Furthermore, in the following structure, x and y represent the number of repetitions, x/y = 83.2/16.8 is satisfied, and x + y = 20 is satisfied.

The resin (X-2) corresponds to a resin containing a repeating unit having a graft chain and a repeating unit having an ethylenically unsaturated group.

A content of the ethylenically unsaturated group in the resin (X-2) is 0.45 mmol/g.

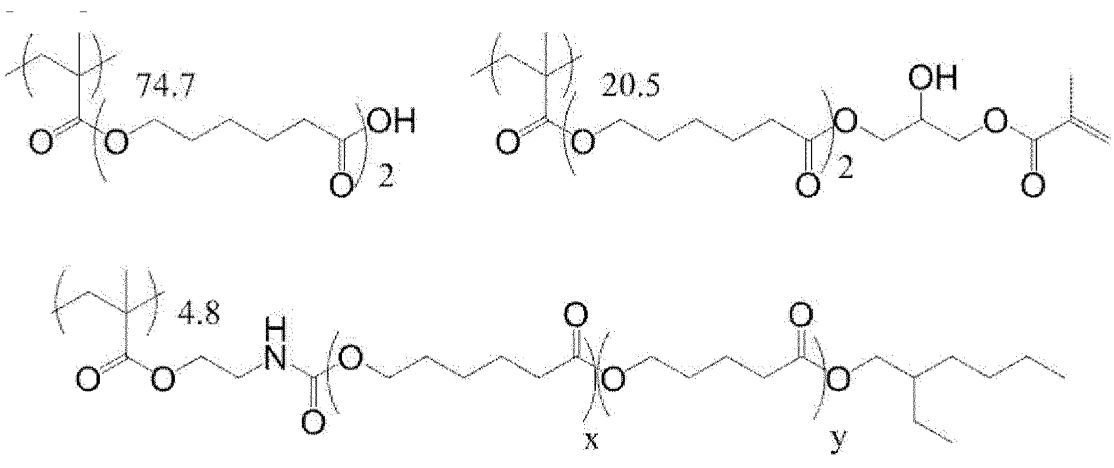

x:y=83.2:16.8

(Red pigment dispersion liquid R1)

The following raw materials were subjected to a dispersion treatment by using NPM Pilot manufactured by Shinmaru Enterprises Corporation to obtain a Red pigment dispersion liquid R1.

Pigment Red 254: 8.3 parts by mass
Pigment Yellow 139: 3.7 parts by mass
DISPERBYK-161 (dispersant, manufactured by BYK-Chemie GmbH, solid content of 30% by mass): 16.0 parts by mass
PGMEA: 72.0 parts by mass

(Blue pigment dispersion liquid B1)

The following raw materials were subjected to a dispersion treatment by using NPM Pilot manufactured by Shinmaru Enterprises Corporation to obtain a Blue pigment dispersion liquid B1.

Pigment Blue 15:6: 9.5 parts by mass

Pigment Violet 23: 2.4 parts by mass
DISPERBYK-161 (dispersant, manufactured by BYK-Chemie GmbH, solid content of 30% by mass): 18.7 parts by mass
PGMEA: 69.4 parts by mass

(Carbon black (CB) dispersion liquid C1)

A dispersion obtained by mixing the following raw materials was further premixed by being thoroughly stirred using a stirrer. In addition, by using ultra apex mill UAM015 manufactured by KOTOBUKI KOGYOU.CO., LTD., a dispersion treatment was performed on the dispersion under the following dispersion conditions, thereby obtaining a dispersion liquid. After completion of the dispersion, beads were separated from the dispersion liquid by a filter, thereby obtaining a CB dispersion liquid C1.

Coated carbon black (details will be described later): 20 parts by mass

DISPERBYK-167 (pigment dispersant, manufactured by BYK-Chemie GmbH, solid content of 52% by mass): 8.7 parts by mass
SOLSPERSE 12000 (pigment derivative, manufactured by The Lubrizol Corporation): 1 part by mass
PGMEA: amount such that solid content of CB dispersion liquid C1 is 35% by mass

Dispersion conditions

Bead size: $\phi$ 0.05 mm
Bead filling rate: 65% by volume
Circumferential speed of mill: 10 m/sec
Circumferential speed of separator: 11 m/s
Amount of mixed solution subjected to dispersion treatment: 15.0 g
Circulation flow rate (pump feeding amount): 60 kg/hour
Treatment liquid temperature: 20°C to 25°C
Coolant: tap water at 5°C
Inner volume of circular path of beads mill: 2.2 L
Number of times of pass: 84 passes

Production of coated carbon black

By a general oil furnace method, carbon black was manufactured. Here, as raw material oil, ethylene bottom oil containing small amounts of Na, Ca, and S was combusted using a gas fuel. Furthermore, as water for stopping the reaction, pure water treated with an ion exchange resin was used.

By using a homomixer, the obtained carbon black (540 g) and pure water (14,500 g) were stirred together at 5,000 to 6,000 rpm for 30 minutes, thereby obtaining a slurry. The slurry was moved to a container with a screw-type stirrer, and while the slurry was being mixed at about 1,000 rpm, toluene (600 g), in which an epoxy resin "EPIKOTE 828" (manufactured by Japan Epoxy Resins Co., Ltd.) (60 g) was dissolved, was added to the slurry little by little. After about 15 minutes, the entirety of carbon black dispersed in water was moved to the side of toluene, thereby obtaining

particles having a size of about 1 mm.

Next, the particles were drained using a 60-mesh wire net, and then the separated grains were put into a vacuum drier and dried for 7 hours at 70°C such that toluene and water were removed. The amount of resin coating the obtained coated carbon black was 10% by mass with respect to the total amount of the carbon black and the resin.

<Black dye>

The following black dye was used for the preparation of the curable composition.

RDW-K01 (polymerizable dye, manufactured by Wako Pure Chemical Industries, Ltd.)

<Polymerizable compound>

The following polymerizable compounds were used for the preparation of the curable composition.

DPHA: KAYARAD DPHA (trade name, manufactured by Nippon Kayaku Co., Ltd., a mixture of a hexafunctional polymerizable compound (double bond equivalent: 10.4 mmol/g) and a pentafunctional polymerizable compound (double bond equivalent: 9.5 mmol/g); the double bond equivalent as a whole (weighted average value of the double bond equivalents of the hexafunctional polymerizable compound and the pentafunctional polymerizable compound) is 10.1 mmol/g)

RP-1040: KAYARAD RP-1040 (manufactured by Nippon Kayaku Co., Ltd., tetrafunctional polymerizable compound, double bond equivalent: 7.5 mmol/g)

A-TMMT: NK ESTER A-TMMT (trade name, manufactured by Shin-Nakamura Chemical Co., Ltd., tetrafunctional polymerizable compound, double bond equivalent: 11.35 mmol/g)

<Resin>

The following resins (solutions containing a resin) were used for the preparation of the curable composition.

RD-F8: ACRYCURE-RD-F8 (manufactured by NIPPON SHOKUBAI CO., LTD., solid content of 40% by mass, solvent: propylene glycol monomethyl ether)

FF-426: ACRYBASE FF-426 (manufactured by FUJIKURA KASEI CO., LTD., solid content of 39% by mass, solvent: propylene glycol monomethyl ether)

ACA230AA: CYCLOMER P (ACA) Z230AA (manufactured by Daicel Chemical Industries, Ltd., solid content of 54% by mass (a solid content of ACA230AA is an actually measured value, and solid content values of other commercially available raw materials are catalog values.))

<Photopolymerization initiator>

The following photopolymerization initiators were used for the preparation of the curable composition.

OXE01: IRGACURE OXE-01 (manufactured by BASF SE)

OXE02: IRGACURE OXE-02 (manufactured by BASF SE)

2959: IRGACURE 2959 (manufactured by BASF SE)

Furthermore, IRGACURE 2959 was a specific initiator.

<Surfactant>

The following surfactants were used for the preparation of the curable composition.

F-780: MEGAFACE F-780 (manufactured by DIC Corporation)

F-781 solution: solution of 0.2 mass% MEGAFACE F-781 (manufactured by DIC Corporation) in cyclohexanone

D-6112-W: PIONIN D-6112-W (manufactured by TAKEMOTO OIL & FAT Co., Ltd.)

Mixture X: mixture shown below (weight-average molecular weight: 14,000)

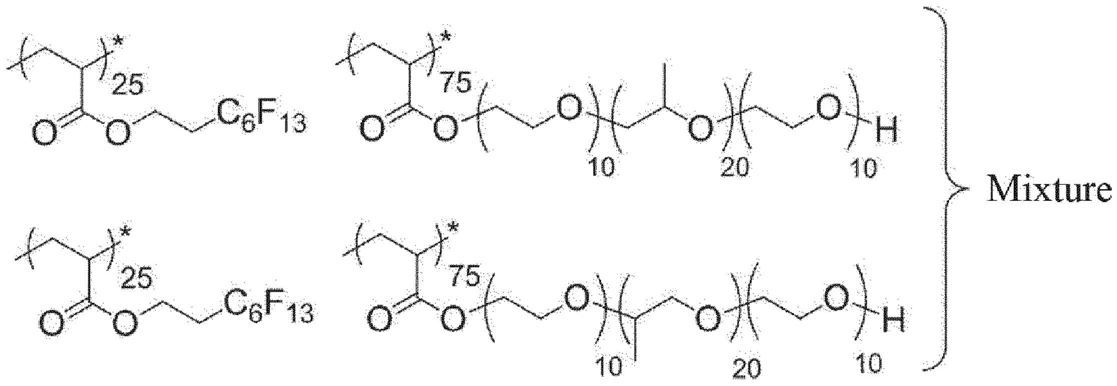

<Silane coupling agent>

The following silane coupling agent was used for the preparation of the curable composition.
KBM-602 solution: solution of 0.9 mass% KBM-602 (manufactured by Shin-Etsu Chemical Co., Ltd.) in cyclohexanone

<Ultraviolet absorber>

The following ultraviolet absorber was used for the preparation of the curable composition.
UV-503 (manufactured by DAITO CHEMICAL CO., LTD.)

<Polymerization inhibitor>

The following polymerization inhibitor was used for the preparation of the curable composition.
p-Methoxyphenol

<Solvent>

The following solvents were used for the preparation of the curable composition.
PGMEA: propylene glycol monomethyl ether acetate
XAN: Cyclohexanone
The above components were mixed to prepare a curable composition shown in the table below.
The table shows a content (parts by mass) of each component in each curable composition.
For example, it is shown that a curable composition 1 contains 73 parts by mass of the titanium black dispersion liquid A.
In addition, the column of "Content of coloring material" in the table indicates a content (% by mass) of the coloring material (pigment) with respect to the total mass of the dispersion composition in each dispersion composition. Moreover, it is shown that in RDW-K01, the black dye itself is used, and the content of the coloring material is 100% by mass.
The column of "Content of coloring material with respect to total solid content" indicates the content (% by mass) of the black coloring material with respect to the total mass of the solid content in each curable composition.
Furthermore, a curable composition 5 is in a state where a plurality of coloring materials are mixed by mixing the Red pigment dispersion liquid R1 with the Blue pigment dispersion liquid B1, and it can be said that the curable composition 5 contains a mixed coloring material. The mixed coloring material (a mixture of Pigment Red 254, Pigment Yellow 139, Pigment Blue 15:6, and Pigment Violet 23) is a black coloring material (black pigment) which is adjusted to be black as a whole, and satisfies the evaluation standards Z.

[Table 1]

| Component | | | Curable composition | | | | | | | | | | | | | |
|---|---|---|---|---|---|---|---|---|---|---|---|---|---|---|---|---|
| Classification | Type | Content of coloring material (% by mass) | 1 | 2 | 3 | 4 | 5 | 6 | 7 | 8 | 9 | 10 | 11 | 12 | 13 | 14 |
| Dispersion composition | Titanium black dispersion liquid A | 25 | 73 | 73 | 45.48 | 51.2 | | | 76.1 | 74.8 | | | 73 | 73 | 36.5 | |
| | Red pigment dispersion liquid R1 | 12 | | | | | 44.87 | | | | | | | | | |
| | Blue pigment dispersion liquid B1 | 12 | | | | | 38.46 | | | | | | | | | |
| | CB dispersion liquid C1 | 27 | | | | | | 35.63 | | | | | | | 34 | |
| | Titanium black dispersion liquid B | 25 | | | | | | | | | 45.48 | 73 | | | | |
| Black dye | RDW-K01 | 100 | | | | | | | | | | | | | | 12.5 |
| Polymerizable compound | DPHA | | 6.82 | 6.82 | 2.66 | | 1.93 | 5.52 | 3.72 | 5.02 | 2.66 | 6.82 | | 3.41 | 6.82 | 6.82 |
| | RP-1040 | | | | | 4.7 | | | | | | | | | | |
| | A-TMMT | | | | | | | | | | | | 6.82 | 3.41 | | |
| Resin | RD-F8 | | 8.32 | 8.32 | | | 8.51 | | 8.32 | 8.32 | | 8.32 | 8.32 | 8.32 | 8.32 | 8.32 |
| | FF-426 | | | | 1.3 | | | 20.85 | | | 1.3 | | | | | |
| | ACA230AA | | | | | 7.4 | | | | | | | | | | |
| Photopolymerization initiator | OXE01 | | | | | 0.87 | | 1.06 | | | | | | | | |
| | OXE02 | | 1.96 | 1.96 | 0.75 | | 0.926 | | 1.96 | 1.96 | 0.75 | 1.96 | 1.96 | 1.96 | 1.96 | 1.96 |
| | 2959 | | | 0.88 | | | | | | | | | | | | |

(continued)

| Component | | | Curable composition | | | | | | | | | | | | | |
|---|---|---|---|---|---|---|---|---|---|---|---|---|---|---|---|---|
| Classification | Type | Content of coloring material (% by mass) | 1 | 2 | 3 | 4 | 5 | 6 | 7 | 8 | 9 | 10 | 11 | 12 | 13 | 14 |
| Surfactant | Mixture X | | 0.02 | 0.02 | | | 0.04 | 0.01 | 0.02 | 0.02 | | 0.02 | 0.02 | 0.02 | 0.02 | 0.02 |
| | F-780 | | | | 0.04 | | | | | | 0.04 | | | | | |
| | F-781 solution | | | | | 0.2 | | | | | | | | | | |
| | D-6112-W | | | | | 0.19 | | | | | | | | | | |
| Silane coupling agent | KBM-602 solution | | | | | 10.8 | | | | | | | | | | |
| Ultraviolet absorber | UV-503 | | | | 0.19 | | | | | | 0.19 | | | | | |
| Polymerization inhibitor | p-Methoxyphenol | | 0.002 | 0.002 | | 0.002 | 0.002 | 0.001 | 0.002 | 0.002 | | 0.002 | 0.002 | 0.002 | 0.002 | 0.002 |
| Solvent | PGMEA | | 3.91 | 3.91 | 39.76 | 14.3 | 5.27 | 33.83 | 3.91 | 3.91 | 39.76 | 3.91 | 3.91 | 3.91 | 3.91 | 3.91 |
| | XAN | | 3.91 | 3.91 | 5.71 | 6.4 | | 3.1 | 3.91 | 3.91 | 5.71 | 3.91 | 3.91 | 3.91 | 3.91 | 3.91 |
| Content of coloring material with respect to total solid content (% by mass) | | | 51 | 50 | 60 | 48 | 48 | 36 | 56 | 54 | 60 | 51 | 51 | 51 | 51 | 51 |

[Test]

The following tests were performed using each curable composition described above.

<Light blocking properties>

Each curable composition was applied onto a glass substrate by a spin coating method, and then heated at 100°C for 2 minutes on a hot plate to obtain a curable composition layer. Next, by using an i-line stepper exposure device FPA-3000i5+ (manufactured by Canon Inc.), the obtained curable composition layer was exposed at 200 mJ/$cm^2$ through a mask having a pattern of 2 cm square. The exposed curable composition layer was puddle-developed for 60 seconds with a developer "CD-2060" (manufactured by FUJIFILM Electronic Materials Co., Ltd.), and further spin-dried. Then, the developed and dried curable composition layer was subjected to a post-curing treatment using any of devices A to D described later to obtain a cured film.

Thereafter, light blocking properties of the cured film were evaluated by using UV-3600 (manufactured by Hitachi High-Tech Corporation: spectrophotometer) according to the following evaluation standards.

A: The maximum value of the transmittance was less than 10% at a wavelength of 400 to 700 nm
B: The maximum value of the transmittance was 10% or greater at a wavelength of 400 to 700 nm

<Evaluation of pattern-defect suppressibility>

A cured film was obtained in the same manner as in the above-described test in <Light blocking properties>, except that an 8-inch silicon substrate on which 100 nm-thick $SiO_2$ was vapor-deposited was used as a substrate and exposure was performed using a mask having a pattern of 5 μm square as a mask.

Thereafter, by using a foreign substance evaluation device COMPLUS III (manufactured by Applied Materials, Inc.), the number of defects in the obtained cured film was evaluated.

A: The number of defects was less than 100 defects/Wafer, and the cured film was at the unproblematic level
B: The number of defects was 100 defects/Wafer or more and less than 300 defects/Wafer, and the cured film was at the unproblematic level
C: The number of defects was 300 defects/Wafer or more, and the cured film was at the problematic level

<Evaluation of sustenance-defect suppressibility>

The substrate produced in the above-described test in <Evaluation of pattern-defect suppressibility> was left for 30 days under a condition of 23°C. Thereafter, the obtained pattern was checked by a cross-sectional scanning electron microscope (SEM) image, and a sustenance defect was evaluated from the following viewpoints.

A: The pattern was formed normally, and the substrate was at the unproblematic level
B: The pattern was slightly deformed, but the substrate was at the unproblematic level
C: The pattern was deformed, but the substrate was at the manageable level
D: The pattern is greatly deformed, and the substrate was at the level problematic for practical use

<Evaluation of film-shrinkage suppressibility>

Each curable composition was applied onto a glass substrate by a spin coating method, and then heated at 100°C for 2 minutes on a hot plate to obtain a curable composition layer. Next, by using an i-line stepper exposure device FPA-3000i5+ (manufactured by Canon Inc.), the obtained curable composition layer was exposed at 200 mJ/$cm^2$ through a mask having a pattern of 2 cm square. The exposed curable composition layer was puddle-developed for 60 seconds with a developer "CD-2060" (manufactured by FUJIFILM Electronic Materials Co., Ltd.), and further spin-dried. Then, the developed and dried curable composition layer was subjected to a post-curing treatment using any of devices A to D described later to obtain a cured film.

At this time, a film thickness of a curable composition layer before the post-curing treatment and a film thickness of a cured film obtained by the post-curing treatment were measured by using a stylus surface profiler (DEKTAK 150 manufactured by ULVAC, Inc.). From the results, a film shrinkage rate of "1 - (film thickness of cured film obtained by post-curing treatment/film thickness of curable composition layer immediately before post-curing treatment)" was calculated, and film-shrinkage suppressibility was evaluated according to the following evaluation standards. A and B were set to be within the allowable range.

A: The film shrinkage rate was 0.03 or less, and the sample was at the unproblematic level
B: The film shrinkage rate was greater than 0.03 and 0.05 or less, and the sample was at the unproblematic level
C: The film shrinkage rate was greater than 0.05, and the sample was at the problematic level

<Devices A to D>

Device A: an oven in which a heating tank was sealed, and nitrogen was introduced while exhausting air in the heating tank
Device B: a hot plate-type heating device in which a heating tank was sealed, and nitrogen was introduced while exhausting air in the heating tank
Device C: UV curing device UNIHARD UMA-802 (manufactured by Ushio Inc.)
Device D: a hot plate-type heating device in which a heating tank was sealed, and air was introduced while exhausting air in the heating tank

Furthermore, the devices A and B can be used for the method A. The device C can be used for the method B.
Various conditions in a case where the devices A to D are used are summarized in the table described later.

[Result]

The test results are shown in the table below.
In the table, the column of "No." indicates a number of the curable composition used in the test.
The column of "Coloring material" indicates a type of the coloring material contained in the curable composition. "Ti" means titanium black, "CB" means carbon black, "Ti/CB" means a mixed system of titanium black and carbon black, "Pig" means another pigment, and "Black dye" means a black dye.
The column of "Content of coloring material" indicates a content (% by mass) of the coloring material with respect to the total mass of the solid content in the curable composition.
The column of "C=C value of polymerizable compound" indicates a double bond equivalent of the polymerizable compound used in the curable composition. Moreover, regarding a curable composition 12 in which a mixture of two polymerizable compounds was used, the column of "C=C value of polymerizable compound" indicates the double bond equivalent (weighted average value of the double bond equivalents of the respective polymerizable compounds) of the whole polymerizable compound contained in the curable composition.
The column of "Graft chain/C=C resin" indicates whether or not the curable composition contains a resin which contains a repeating unit having a graft chain and a repeating unit having an ethylenically unsaturated group. A case where the resin was contained was designated as "A", and a case where the resin was not contained was designated as "B".
The column of "Specific initiator" indicates whether or not the curable composition contains a photopolymerization initiator which is a specific initiator. A case where the specific initiator was contained was designated as "A", and a case where the specific initiator was not contained was designated as "B".
The column of "Film thickness after coating" indicates a thickness of the curable composition layer, which was formed in each test, before exposure.
The column of "Oxygen concentration" means an oxygen concentration in the heating tank after the post-curing treatment. "ppm" means "ppm by volume", and "%" means "% by volume".
The column of "Exposure amount" indicates a total amount of energy of light radiated using the device C.

[Table 2]

| | Curable composition | | | | | | | Treatment conditions | | | | | Evaluation | | | |
|---|---|---|---|---|---|---|---|---|---|---|---|---|---|---|---|---|
| | No. | Coloring material | Content of coloring material (% by mass) | C=C value of polymerizable compound (mmol/gl | Graft chain/C=C resin | Specific initiator | Film thickness after coating (μm) | Device | Oxygen concentration | Heating temperature (°C) | Heatingtime (h) | Exposure amount (J/cm$^2$) | Light blocking properties | Pattern-defect suppressibility | Sustenance-delect suppressibility | Film-shrinkag e suppressibility |
| Example 1 | 1 | Ti | 51 | 10.1 | B | B | 1.0 | A | 20 ppm | 150 | 1 | - | A | A | A | A |
| Example 2 | 1 | Ti | 51 | 10.1 | B | B | 1.0 | A | 50 ppm | 150 | 1 | - | A | A | A | A |
| Example 3 | 1 | Ti | 51 | 10.1 | B | B | 1.0 | A | 80 ppm | 150 | 1 | - | A | A | A | A |
| Example 4 | 1 | Ti | 51 | 10.1 | B | B | 1.0 | A | 110 ppm | 150 | 1 | - | A | A | B | A |
| Example 5 | 1 | Ti | 51 | 10.1 | B | B | 1.0 | A | 850 ppm | 150 | 1 | - | A | A | C | A |
| Example 6 | 5 | Pig | 48 | 10.1 | B | B | 1.0 | A | 50 ppm | 150 | 1 | - | A | A | B | A |
| Example 7 | 6 | CB | 36 | 10.1 | B | B | 1.0 | A | 50 ppm | 150 | 1 | - | A | A | B | A |
| Example 8 | 1 | Ti | 51 | 10.1 | B | B | 1.0 | B | 50 ppm | 150 | 1 | - | A | B | A | A |
| Example 9 | 1 | Ti | 51 | 10.1 | B | B | 2.0 | A | 50 ppm | 150 | 1 | - | A | A | A | A |
| Example 10 | 1 | Ti | 51 | 10.1 | B | B | 2.7 | A | 50 ppm | 150 | 1 | - | A | A | A | A |
| Example 11 | 4 | Ti | 48 | 7.5 | B | B | 1.0 | A | 20 ppm | 150 | 1 | - | A | A | B | A |
| Example 12 | 11 | Ti | 51 | 11.4 | B | B | 1.0 | A | 20 ppm | 150 | 1 | - | A | A | A | A |
| Example 13 | 12 | Ti | 51 | 10.7 | B | B | 1.0 | A | 20 ppm | 150 | 1 | - | A | A | A | A |
| Example 14 | 13 | Ti/CB | 51 | 10.1 | B | B | 1.0 | A | 20 ppm | 150 | 1 | - | A | A | B | A |
| Example 15 | 14 | Black dye | 51 | 10.1 | B | B | 1.0 | A | 20 ppm | 150 | 1 | - | A | A | A | B |

(continued)

| | Curable composition | | | | | | Film thickness after coating (μm) | Treatment conditions | | | | | Evaluation | | | |
|---|---|---|---|---|---|---|---|---|---|---|---|---|---|---|---|---|
| | No. | Coloring material | Content of coloring material (% by mass) | C=C value of polymerizable compound (mmol/gl | Graft chain/C=C resin | Specific initiator | | Device | Oxygen concentration | Heating temperature (°C) | Heatingtime (h) | Exposure amount (J/cm²) | Light blocking properties | Pattern-defect suppressibility | Sustenance-delect suppressibility | Film-shrinkag e suppressibility |
| Comparative Example 1 | 1 | Ti | 51 | 10.1 | B | B | 1.0 | A | 1,000 ppm | 150 | 1 | - | A | A | D | A |
| Comparative Example 2 | 1 | Ti | 51 | 10.1 | B | B | 1.0 | A | 50 ppm | 200 | 1 | - | A | B | D | C |
| Comparative Example 3 | 1 | Ti | 51 | 10.1 | B | B | 1.0 | D | 21% | 150 | 1 | - | A | A | D | B |
| Example 16 | 1 | Ti | 51 | 10.1 | B | B | 1.0 | C | - | - | - | 10 | A | A | B | A |
| Example 17 | 2 | Ti | 50 | 10.1 | B | A | 1.0 | C | - | - | - | 10 | A | A | A | A |
| Example 18 | 5 | Pig | 48 | 10.1 | B | B | 1.0 | C | - | - | - | 10 | A | A | A | B |
| Example 19 | 6 | CB | 36 | 10.1 | B | B | 1.0 | C | - | - | - | 10 | A | A | B | A |
| Example 20 | 8 | Ti | 54 | 10.1 | B | B | 1.0 | C | - | - | - | 10 | A | A | B | A |
| Example 21 | 7 | Ti | 56 | 10.1 | B | B | 1.0 | C | - | - | - | 10 | A | A | C | A |
| Example 22 | 3 | Ti | 60 | 10.1 | B | B | 0.4 | C | - | - | - | 10 | A | B | C | A |

(continued)

| | Curable composition | | | | | | Film thickness after coating (μm) | Treatment conditions | | | | | Evaluation | | | |
|---|---|---|---|---|---|---|---|---|---|---|---|---|---|---|---|---|
| | No. | Coloring material | Content of coloring material (% by mass) | C=C value of polymerizable compound (mmol/gl | Graft chain/C=C resin | Specific initiator | | Device | Oxygen concentration | Heating temperature (°C) | Heatingtime (h) | Exposure amount (J/cm$^2$) | Light blocking properties | Pattern-defect suppressibility | Sustenance-delect suppressibility | Film-shrinkag e suppressibility |
| Example 23 | 9 | Ti | 60 | 10.1 | A | B | 0.4 | C | - | - | - | 10 | A | B | B | A |
| Example 24 | 10 | Ti | 51 | 10.1 | A | B | 1.0 | C | - | - | - | 10 | A | A | A | A |
| Example 25 | 11 | Ti | 51 | 11.4 | B | B | 1.0 | C | - | - | - | 10 | A | A | B | A |
| Example 26 | 12 | Ti | 51 | 10.7 | B | B | 1.0 | C | - | - | - | 10 | A | A | B | A |
| Example 27 | 13 | Ti/CB | 51 | 10.1 | B | B | 1.0 | C | - | - | - | 10 | A | A | B | A |
| Example 28 | 14 | Black dye | 51 | 10.1 | B | B | 1.0 | C | - | - | - | 10 | A | A | B | B |

According to the method according to the embodiment of the present invention, it was confirmed that a cured film having excellent sustenance-defect suppressibility can be manufactured.

It was confirmed that in a case where the post-curing is performed by the method A, from the viewpoint of superior sustenance-defect suppressibility, the oxygen concentration is preferably 500 ppm by volume or lower and more preferably 100 ppm by volume or lower (comparison of Examples 1 to 5).

It was confirmed that in a case where the post-curing is performed by the method A and the coloring material in the curable composition is a black pigment, film shrinkage of the obtained cured film is further suppressed (comparison of Examples 1 to 14 and Example 15).

Moreover, it was confirmed that in a case where the post-curing is performed by the method A and the coloring material in the curable composition is titanium black (titanium nitride), the sustenance-defect suppressibility of the obtained cured film is superior (comparison of Examples 2, 6, and 7 and comparison Examples 1 and 14).

It was confirmed that in a case where a heating treatment is performed in an oven in order to carry out the method A, a pattern defect of the obtained cured film is further suppressed (comparison Examples 2 and 8).

Furthermore, it was confirmed that in a case where the post-curing is performed by the method A and a double bond equivalent of the polymerizable compound in the curable composition is 10.0 mmol/g or greater, the sustenance-defect suppressibility of the obtained cured film is superior (comparison Examples 1 and 11).

It was confirmed that in a case where the post-curing is performed by the method B and a content of the black pigment is less than 55% by mass with respect to the total solid content of the curable composition, the sustenance-defect suppressibility of the obtained cured film is superior (comparison Examples 20 and 21).

It was confirmed that in a case where the post-curing is performed by the method B and the curable composition contains the resin which contains a repeating unit having a graft chain and a repeating unit having an ethylenically unsaturated group on a side chain, the sustenance-defect suppressibility of the obtained cured film is superior (comparison Examples 16 and 24 and comparison Examples 22 and 23).

It was confirmed that in a case where the post-curing is performed by the method B and the curable composition contains the specific initiator, the sustenance-defect suppressibility of the obtained cured film is superior (comparison Examples 16 and 17).

Furthermore, it was confirmed that in a case where the post-curing is performed by the method B and the coloring material in the curable composition is a black pigment absorbing infrared rays, film shrinkage of the obtained cured film is further suppressed (comparison of Examples 16, 18, 19, and 28).

Explanation of References

100: Solid-state imaging device
101: Solid-state imaging element
102: Imaging portion
103: Cover glass
104: Spacer
105: Laminated substrate
106: Chip substrate
107: Circuit substrate
108: Electrode pad
109: External connection terminal
110: Penetration electrode
111: Lens layer
112: Lens material
113: Support
114, 115: Cured film
201: Light-receiving element
202: Color filter
201: Light-receiving element
202: Color filter
203: Microlens
204: Substrate
205b: Blue pixel
205r: Red pixel
205g: Green pixel

205bm: Black matrix
206: p-well layer
207: Reading gate portion
208: Vertical electric charge transfer path
209: Element separation region
210: Gate insulating film
211: Vertical electric charge transfer electrode
212: Cured film
213, 214: Insulating film
215: Planarization film

## Claims

**1.** A method for manufacturing a cured film, the method comprising:

a step of forming a curable composition layer by using a curable composition which contains one or more kinds of black coloring materials selected from the group consisting of a black pigment and a black dye, a polymerizable compound, and a photopolymerization initiator;
a step of exposing the curable composition layer by irradiation with actinic rays or radiation;
a step of developing the exposed curable composition layer; and
a step of heating the developed curable composition layer at a temperature of lower than 170°C, in an environment where an oxygen concentration is lower than 1,000 ppm by volume, to form a cured film.

**2.** The method for manufacturing a cured film according to claim 1,
wherein the oxygen concentration is 100 ppm by volume or lower.

**3.** The method for manufacturing a cured film according to claim 1 or 2,
wherein the heating is performed using an oven.

**4.** The method for manufacturing a cured film according to any one of claims 1 to 3,
wherein the photopolymerization initiator includes an oxime ester-based polymerization initiator.

**5.** The method for manufacturing a cured film according to any one of claims 1 to 4,
wherein a double bond equivalent of the polymerizable compound is 10.0 mmol/g or greater.

**6.** The method for manufacturing a cured film according to any one of claims 1 to 5,
wherein the black coloring material is the black pigment.

**7.** The method for manufacturing a cured film according to claim 6,
wherein the black pigment absorbs infrared rays.

**8.** The method for manufacturing a cured film according to claim 7,
wherein the black pigment is one or more kinds selected from the group consisting of a nitride of titanium, an oxynitride of titanium, a nitride of zirconium, an oxynitride of zirconium, a nitride of vanadium, an oxynitride of vanadium, a nitride of niobium, and an oxynitride of niobium.

**9.** The method for manufacturing a cured film according to any one of claims 1 to 8,
wherein the cured film is a light blocking film.

**10.** A method for manufacturing a solid-state imaging element including a cured film, the method comprising:
the method for manufacturing a cured film according to any one of claims 1 to 9.

**11.** A method for manufacturing a cured film, the method comprising:

a step of forming a curable composition layer by using a curable composition which contains one or more kinds of black coloring materials selected from the group consisting of a black pigment and a black dye, a polymerizable compound, and a photopolymerization initiator;

a step of exposing the curable composition layer by irradiation with actinic rays or radiation;
a step of developing the exposed curable composition layer; and
a step of irradiating the developed curable composition layer with ultraviolet rays to form a cured film.

**12.** The method for manufacturing a cured film according to claim 11,
wherein the curable composition further contains a resin which contains a repeating unit having a graft chain and a repeating unit having an ethylenically unsaturated group on a side chain.

**13.** The method for manufacturing a cured film according to claim 11 or 12,
wherein in the step of performing irradiation with ultraviolet rays to form a cured film, the irradiating light has a wavelength of 300 nm or less.

**14.** The method for manufacturing a cured film according to any one of claims 11 to 13,
wherein the photopolymerization initiator includes a photopolymerization initiator which does not exhibit photosensitivity at a wavelength of 365 nm.

**15.** The method for manufacturing a cured film according to any one of claims 11 to 14,
wherein the black coloring material is the black pigment.

**16.** The method for manufacturing a cured film according to claim 15,
wherein a content of the black pigment is less than 55% by mass with respect to a total solid content of the curable composition.

**17.** The method for manufacturing a cured film according to claim 15 or 16,
wherein the black pigment absorbs infrared rays.

**18.** The method for manufacturing a cured film according to claim 17,
wherein the black pigment is one or more kinds selected from the group consisting of a nitride of titanium, an oxynitride of titanium, a nitride of zirconium, an oxynitride of zirconium, a nitride of vanadium, an oxynitride of vanadium, a nitride of niobium, and an oxynitride of niobium.

**19.** The method for manufacturing a cured film according to any one of claims 11 to 18,
wherein the cured film is a light blocking film.

**20.** A method for manufacturing a solid-state imaging element including a cured film, the method comprising:
the method for manufacturing a cured film according to any one of claims 11 to 19.

FIG. 1

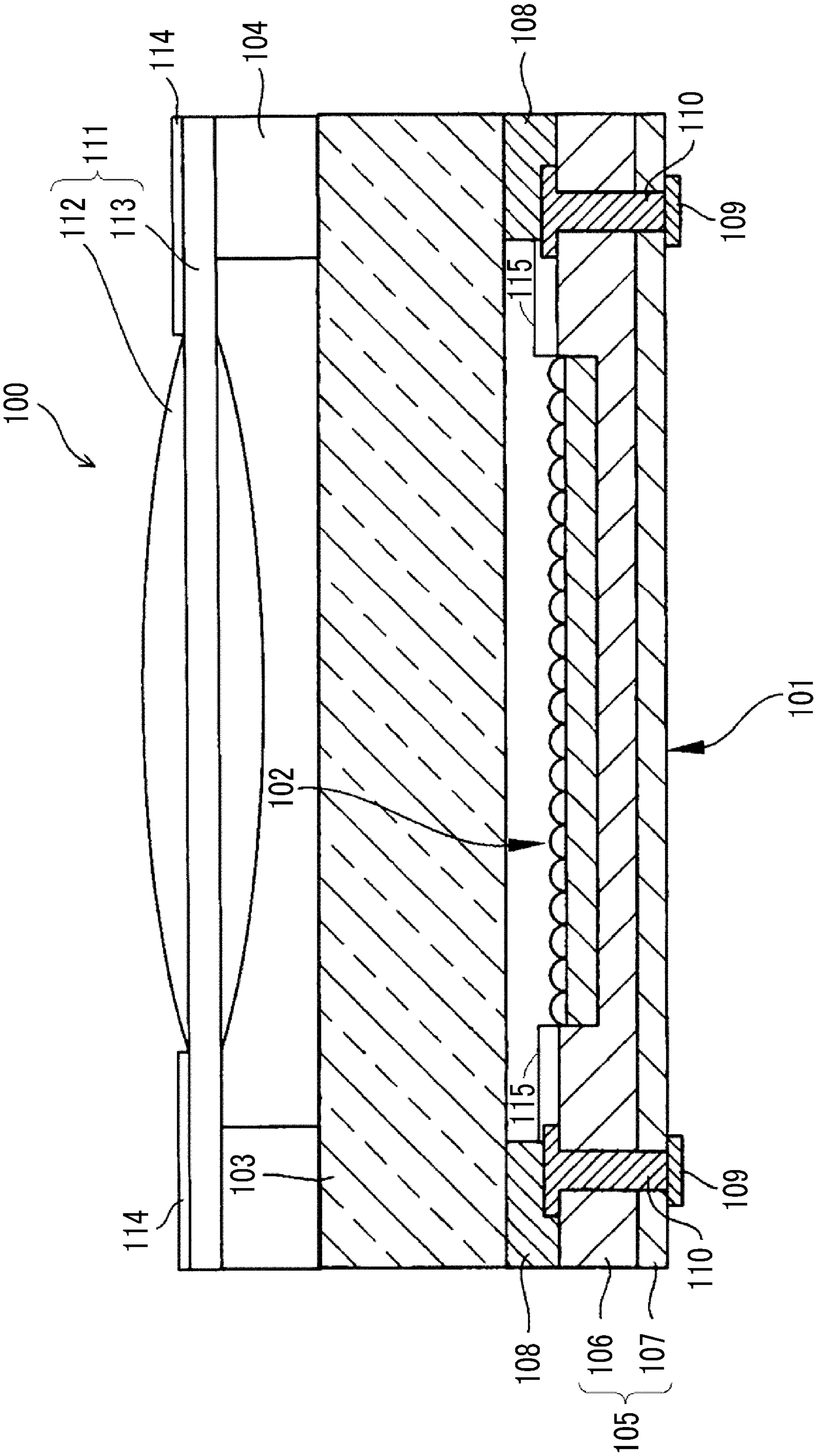

FIG. 2

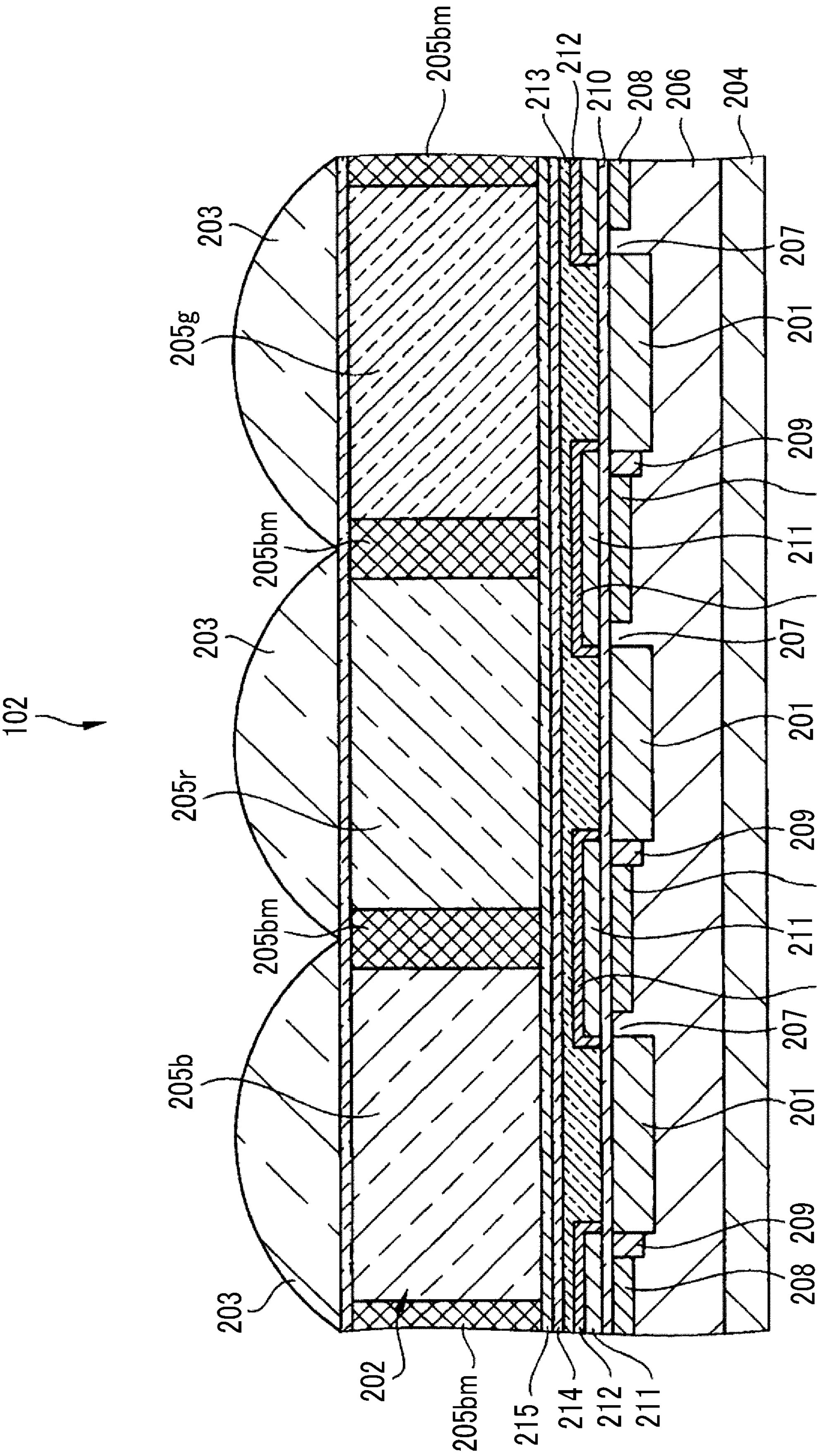
102
201
202
203
204
205b
205bm
205g
205r
206
207
208
209
210
211
212
213
214
215

## INTERNATIONAL SEARCH REPORT

International application No. PCT/JP2019/004835

A. CLASSIFICATION OF SUBJECT MATTER
Int.Cl. G03F7/40(2006.01)i, C08F2/44(2006.01)i, C08F2/50(2006.01)i, C08F290/08(2006.01)i, G02B5/00(2006.01)i, G03F7/004(2006.01)i, G03F7/031(2006.01)i

According to International Patent Classification (IPC) or to both national classification and IPC

B. FIELDS SEARCHED

Minimum documentation searched (classification system followed by classification symbols)
Int.Cl. G03F7/40, C08F2/44, C08F2/50, C08F290/08, G02B5/00, G03F7/004, G03F7/031

Documentation searched other than minimum documentation to the extent that such documents are included in the fields searched

| | |
|---|---|
| Published examined utility model applications of Japan | 1922–1996 |
| Published unexamined utility model applications of Japan | 1971–2019 |
| Registered utility model specifications of Japan | 1996–2019 |
| Published registered utility model applications of Japan | 1994–2019 |

Electronic data base consulted during the international search (name of data base and, where practicable, search terms used)

C. DOCUMENTS CONSIDERED TO BE RELEVANT

| Category* | Citation of document, with indication, where appropriate, of the relevant passages | Relevant to claim No. |
|---|---|---|
| X<br>A | JP 2013-228695 A (FUJIFILM CORP.) 07 November 2013, claim 9, paragraphs [0063]-[0064], examples & US 2015/0015813 A1, claim 9, paragraphs [0147]-[0151], examples & WO 2013/146372 A1 & TW 201344359 A & CN 104246611 A & KR 10-2014-0136996 A | 11, 13, 15-17, 19<br>1-10, 12, 14, 18, 20 |
| X<br>A | WO 2007/061115 A1 (ASAHI GLASS CO., LTD.) 31 May 2007, claims, examples & US 2008/0233493 A1, claim 1, examples & KR 10-2008-0073302 A & CN 101317132 A & TW 200735700 A | 11, 13, 15-17, 19-20<br>1-10, 12, 14, 18 |

☒ Further documents are listed in the continuation of Box C. ☐ See patent family annex.

* Special categories of cited documents:
"A" document defining the general state of the art which is not considered to be of particular relevance
"E" earlier application or patent but published on or after the international filing date
"L" document which may throw doubts on priority claim(s) or which is cited to establish the publication date of another citation or other special reason (as specified)
"O" document referring to an oral disclosure, use, exhibition or other means
"P" document published prior to the international filing date but later than the priority date claimed
"T" later document published after the international filing date or priority date and not in conflict with the application but cited to understand the principle or theory underlying the invention
"X" document of particular relevance; the claimed invention cannot be considered novel or cannot be considered to involve an inventive step when the document is taken alone
"Y" document of particular relevance; the claimed invention cannot be considered to involve an inventive step when the document is combined with one or more other such documents, such combination being obvious to a person skilled in the art
"&" document member of the same patent family

| Date of the actual completion of the international search | Date of mailing of the international search report |
|---|---|
| 26 March 2019 (26.03.2019) | 09 April 2019 (09.04.2019) |

| Name and mailing address of the ISA/ | Authorized officer |
|---|---|
| Japan Patent Office<br>3-4-3, Kasumigaseki, Chiyoda-ku,<br>Tokyo 100-8915, Japan | Telephone No. |

Form PCT/ISA/210 (second sheet) (January 2015)

INTERNATIONAL SEARCH REPORT

International application No.
PCT/JP2019/004825

C (Continuation). DOCUMENTS CONSIDERED TO BE RELEVANT

| Category* | Citation of document, with indication, where appropriate, of the relevant passages | Relevant to claim No. |
|---|---|---|
| X<br>A | JP 2001-208908 A (FUJI PHOTO FILM CO., LTD.) 03 August 2001, examples (Family: none) | 11, 13, 15-17, 19-20<br>1-10, 12, 14, 18 |
| A | JP 2001-305749 A (TORAY INDUSTRIES, INC.) 02 November 2001, claim 5 (Family: none) | 3 |
| A | WO 2017/038708 A1 (FUJIFILM CORP.) 09 March 2017, paragraphs [0018]-[0024] & US 2018/0164681 A1, paragraphs [0105]-[0122] & KR 10-2018-0034525 A & B 201715304 A | 8, 18 |
| A | JP 2013-054200 A (DAINIPPON PRINTING CO., LTD.) 21 March 2013, claim 1, paragraph [0055] (Family: none) | 12 |
| A | JP 2015-041058 A (FUJIFILM CORP.) 02 March 2015, claim 1 & US 2016/0139505 A1, claim 1 & WO 2015/025689 A1 & TW 201508420 A & KR 10-2016-0025592 A | 14 |
| A | JP 2009-157006 A (NIPPON ZEON CO., LTD.) 16 July 2009 (Family: none) | 1-10 |
| A | US 2015/0024326 A1 (MICROCHEM CORP.) 22 January 2015 & WO 2013/134104 A2 & TW 201348861 A | 1-10 |
| A | US 2011/0147983 A1 (CHENG, J. et al.) 23 June 2011 & GB 2488250 A & WO 2011/073013 A1 & DE 112010004848 B & CN 102656111 A | 11-20 |

Form PCT/ISA/210 (continuation of second sheet) (January 2015)

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description

- JP 2013231878 A
- JP 2022110 A
- JP H02022110 A
- JP 61011140 A
- JP S61011140 A
- JP 63085007 A
- JP S63085007 A
- JP 53033228 A
- JP S53033228 A
- JP 2008069193 A
- JP 2016074870 A
- JP 2008266045 A
- JP 2013249417 A
- JP 2014042375 A
- JP 1090403 A
- JP S64090403 A
- JP 1091102 A
- JP 64091102 A
- JP 1094301 A
- JP H01094301 A
- JP 6011614 A
- JP H06011614 A
- JP 2592207 B
- US 4808501 A
- US 5667920 A
- US 505950 A
- JP 5333207 A
- JP H05333207 A
- JP 6035183 A
- JP H06035183 A
- JP 6051115 A
- JP H06051115 A
- JP 6194828 A
- JP H06194828 A
- JP 2011213925 A
- JP 2013041097 A
- JP 2010111750 A
- JP 7164729 A
- JP H07164729 A
- JP 2002146254 A
- JP 2011164583 A
- JP 2010222557 A
- WO 2014088063 A
- WO 2014030628 A
- JP 2014059550 A
- WO 2012169447 A
- JP 2015176046 A
- JP 2014063144 A
- JP 2014052431 A
- JP 2014044301 A
- JP 2012008532 A
- JP 2015172102 A
- JP 2015172004 A
- JP 2015040895 A
- JP 2014126642 A
- JP 2014148567 A
- JP 2015157893 A
- JP 2014095007 A
- JP 2014080487 A
- JP 2013227403 A
- JP 2008260927 A
- JP 2015068893 A
- JP 2013029760 A
- JP 2008292970 A
- JP 10291969 A
- JP H10291969 A
- JP 4225898 B
- JP 2009191179 A
- JP 2001233842 A
- JP 2000080068 A
- JP 2006342166 A
- JP 2000066385 A
- JP 2004534797 A
- JP 2009519904 A
- US 7626957 B
- JP 2010015025 A
- US 20090292039 A
- WO 2009131189 A
- US 7556910 B
- JP 2009221114 A
- JP 2010262028 A
- JP 2014500852 A
- JP 2013164471 A
- JP 2014137466 A
- WO 2015036910 A
- JP 2010097210 A
- JP 2010106268 A
- US 20110124824 A
- JP 2011153283 A
- US 20110279759 A
- JP 2016109763 A
- JP 59044615 A
- JP S59044615 A
- JP 54034327 B
- JP S54034327 B
- JP 58012577 B
- JP S58012577 B
- JP 54025957 B

- JP S54025957 B
- JP 54092723 A
- JP S54092723 A
- JP 59053836 A
- JP S59053836 A
- JP 59071048 A
- JP S59071048 A
- EP 993966 B
- EP 1204000 B
- JP 2001318463 A
- WO 2008123097 A
- JP 2016075845 A
- JP 2008106250 A
- JP 2016122101 A
- JP 2016068401 A
- JP 2014137523 A
- JP 2015187676 A
- JP 2014106326 A
- JP 2011089090 A
- JP 2012068418 A
- US 20120068292 A
- JP 2012032556 A
- JP 2015001654 A
- JP 2015500562 A
- JP 2014533890 A
- US 20120037789 A
- WO 2008131313 A


**Non-patent literature cited in the description**


- *J. C. S.,* 1979, vol. II, 1653-1660
- *J. C. S.,* 1979, vol. II, 156-162
- *Journal of Photopolymer Science and Technology,* 1995, 202-232
- **A. J. LEO.** Comprehensive Medicinal Chemistry. Pergamon press, 1990, vol. 4, 295
- **C. HANSCH ; A. J. LEO.** Substituent Constants For Correlation Analysis in Chemistry and Biology. John Wiley & Sons
- **A. J. LEO.** Calculating logPoct from structure. *Chem. Rev.,* 1993, vol. 93, 1281-1306